# EUROPEAN PATENT APPLICATION

(11) **EP 1 775 768 A1**
(43) Date of publication of application: **18.04.2007**
(21) Application number: 05751423.4
(22) Date of filing: 03.06.2005
(51) Int. Cl.: H01L 25/065, H01L 21/60, H01L 25/07, H01L 25/18

(54) **SEMICONDUCTOR DEVICE HAVING THREE-DIMENSIONAL STACK STRUCTURE AND METHOD FOR MANUFACTURING THE SAME**

(30) Priority: 04.06.2004 JP 2004166821
(71) Applicant: ZyCube Co., Ltd., Chuo-ku Tokyo 103-0027 (JP)
(72) Inventor: KOYANAGI, Mitsumasa, 9811245 (JP)
(74) Representative: Zimmermann, Gerd Heinrich
(86) International application number: PCT/JP2005/010270
(87) International publication number: WO 2005/119776

(57) **Abstract**

A three-dimensional stacked structured semiconductor device comprising semiconductor circuit layers stacked on a support substrate, and a method of fabricating the device are provided.

After fixing semiconductor chips 37 to a support substrate 31 with bump electrodes, gaps between the chips 37 are filled with an electrically insulative adhesive 38. Then, by polishing the reverses of the chips 37, the chips 37 are thinned to expose buried interconnections in the chips 37, thereby forming a first semiconductor circuit layer L1. Next, after fixing semiconductor chips 43 to the first semiconductor circuit layer L1 with bump electrodes 41 and 42 by way of an insulating layer 39, gaps between the chips 43 are filled with an electrically insulative adhesive 44. Then, by polishing the reverses of the chips 43, the chips 43 are thinned to expose buried interconnections in the chips 43, thereby forming a second semiconductor circuit layer L2. In a similar way, semiconductor chips 49 are fixed to the second semiconductor circuit layer L2 by way of an insulating layer 45, thereby forming a third semiconductor circuit layer L3. Dicing is performed as necessary. Thus, three-layer stacked structured semiconductor devices 30A, 30B, and 30C are obtained.

## Description

### TECHNICAL FIELD

The present invention relates to a semiconductor device and a method of fabricating the same and more particularly, to a semiconductor device having a three-dimensional stacked structure formed by stacking semiconductor circuit layers on a support substrate, and a method of fabricating the device.

### BACKGROUND ART

In recent years, semiconductor devices with a three-dimensional structure formed by stacking semiconductor chips were announced. For example, Kurino et al. announced an "Intelligent Image Sensor Chip with Three-Dimensional Structure" in 1999 IEDM Technical Digest published in 1999 (see Non-Patent Document 1).

This image sensor chip has a four-layer structure, where a processor array and an output circuit are located in the first layer, data latches and masking circuits are located in the second layer, amplifiers and analog-to-digital converters are located in the third layer, and an image sensor array is located in the fourth layer. The uppermost surface of the image sensor array is covered with a quartz glass layer containing the microlens array. The microlens array is formed on the surface of the quartz glass layer. A photodiode is formed as the semiconductor light-receiving element in each image sensor of the image sensor array.

The respective layers constituting the four-layer structure are mechanically connected to each other with an adhesive, and are electrically connected to each other with buried interconnections using conductive plugs and microbump electrodes contacted with the interconnections.

Moreover, Lee et al. announced an image-processing chip comprising an image sensor similar to the solid-state image sensor announced by Kurino et al. in Japan Journal of Applied Physics entitled "Development of Three-Dimensional Integration Technology for Highly Parallel Image-processing Chip" published in April 2000 (see Non-Patent Document 2).

The image sensor chip of Lee et al. has approximately the same configuration as the solid-stage imaging sensor announced by Kurino et al. in the above-described treatise.

With any one of the two above-described semiconductor devices having the three-dimensional stacked structure, a plurality of semiconductor wafers are stacked and adhered to each other and thereafter, they are divided into a plurality of chips by cutting (dicing), resulting in the semiconductor devices. In other words, semiconductor wafers in which integrated circuits have been respectively formed are stacked and fixed on the wafer level, realizing the three-dimensional stacked structure.

By the way, recently, a microelectro-mechanical system constituted by sequentially stacking a plurality of semiconductor device chips (semiconductor chips) and/or micro electronic components on a substrate has been attracting public attention. This is because there is a possibility that semiconductor chips having different functions and/or sizes can be combined and used for this system, and because if this is realized, there is an advantage that the degree of freedom in designing is expanded.

For example, Non-Patent Document 3 discloses a self-assembly technique of microdevices to be used for a microelectro-mechanical system (MEMS). This technique is a technique to mount a plurality of micro electronic components on a single substrate by utilizing hydrophobicity and capillary force. The substrate has hydrophobic alkanethiol-coated gold binding sites. To perform assembly, a hydrocarbon oil, which has been applied to the substrate, wets exclusively the hydrophobic binding sites in water. Next, micro electronic components are put into the water, and assembled respectively on the oil-wetted biding sites. Here, by using an electrochemical method to deactivate specific biding sites, the components are assembled at the biding sites as desired. By repeatedly conducting these steps, different batches of micro electronic components can be sequentially assembled to the single substrate. After the assembly operation is completed, electrical connection between the components and the substrate thus assembled is established by electroplating.
Non-Patent Document 1: H. Kurino et al., "Intelligent Image Sensor Chip with Three-Dimensional Structure", 1999 IEDM Technical Digest, pp. 36.4.1-36.4.4, 1999
Non-Patent Document 2: K. Lee et al., "Development of Three-Dimensional Integration Technology for Highly Parallel Image-processing Chip", Jpn. J. of Appl. Phys., Vol. 39, pp. 2474-2477, April 2000
Non-Patent Document 3: X. Xiong et al., "Controlled Multibatch Self-Assembly of Microdevices", Journal of Michroelectromechanical Systems, Vol. 12, No. 2, pp. 117-127, April 2003

### DISCLOSURE OF THE INVENTION

### PROBLEMS TO BE SOLVED BY THE INVENTION

The semiconductor devices having the three-dimensional structure formed by stacking semiconductor chips disclosed in above-described Non-Patent Documents 1 and 2 are each fabricated by stacking and fixing semiconductor wafers each including many integrated circuits to be unified together, and by dividing (dicing) the wafer stack thus formed. In this case, the many integrated circuits formed on each wafer are usually the same and therefore, there is a disadvantage that the semiconductor devices fabricated by dividing the wafer stack are limited to those having the same structure and the same function.

In recent years, "system LSIs" each formed by packing integrated circuits having different functions (e.g., CPU (Central Processing Unit) or DSP (Digital Signal Processor)) on a single substrate were developed. However, realization of such system LSIs is difficult. This is because preferred materials and/or preferred fabrication processes are very different according to the function of the integrated circuit. Moreover, mountable circuits on the substrate are limited. For this reason, there has been the strong demand that semiconductor circuits with various built-in integrated circuits are fabricated by using preferred materials and preferred fabrication processes to the built-in integrated circuits and then, the integrated circuits thus fabricated having various functions are appropriately combined and mounted on a single support substrate to constitute a three-dimensional stacked structure, thereby realizing semiconductor devices each having a similar function to the system LSI. This is because if this is realized, systemized semiconductor devices in a similar way to the system LSI can be easily obtained by combining semiconductor circuits having different functions and/or different sizes according to the necessity.

Moreover, when mounting the semiconductor circuits, it is necessary to electrically connect the predetermined electrodes of the said semiconductor circuits to the electrodes on the substrate or those on the corresponding semiconductor circuits, respectively. Therefore, the self-assembly technique of microdevices disclosed in above-described Non-Patent Document 3 may be applied to this point. However, with the assembly technique disclosed in Non-Patent Document 3, it is difficult to perform the electrical connection between the substrate and the micro electronic components assembled thereon.

The present invention was created based on consideration on these points. A chief object of the invention is to provide a semiconductor device having a three-dimensional stacked structure that makes it possible to realize a desired systemized function by combining a plurality of semiconductor circuits having different functions according to the necessity while eliminating or suppressing the difficulty in the electrical interconnection (wiring) between the internal circuits and in the packaging, and a method of fabricating the device.

Another object of the invention is to provide a semiconductor device having a three-dimensional stacked structure that makes it possible to mount semiconductor circuits to be combined on a single support substrate even if the said semiconductor circuits are different in size, shape, and/or thickness from each other, and a method of fabricating the device.

Still another object of the invention is to provide a semiconductor device having a three-dimensional stacked structure that makes it possible to realize diversified functions according to the necessity, and a method of fabricating the device.

The other objects not specifically mentioned here will become clear from the following description and attached drawings.

### MEANS FOR SOLVING THE PROBLEMS

(1) According to a first aspect of the present invention, a semiconductor device having a three-dimensional stacked structure is provided. This device comprises:
   a support substrate; and
   a stacked structure comprising first to n-th circuit layers (n is an integer equal to 2 or greater) stacked in sequence from a bottom of the structure to a top thereof in a predetermined stacking direction and unified with an electrically insulative adhesive, the structure being fixed to the substrate at the bottom;
wherein adjoining ones of the circuit layers in the stacked structure are mechanically and electrically interconnected with each other by way of connecting portions formed between the adjoining circuit layers, and are electrically insulated from each other by the adhesive in a region other than the connecting portions;
each of the first to n-th circuit layers is formed to include at least one semiconductor circuit; and
at least one of the first to n-th circuit layers is such that a physical size of the semiconductor circuit included in the said circuit layer in a plane perpendicular to the stacking direction is smaller than a physical size of the said circuit layer in the plane, and a side face of the said semiconductor circuit is covered with the adhesive.

(2) As explained above, the semiconductor device having a three-dimensional stacked structure a to the first aspect of the invention comprises the support substrate, and the stacked structure comprising the first to n-th circuit layers stacked in sequence from the bottom of the structure to the top thereof in the predetermined stacking direction and unified with the electrically insulative adhesive, the structure being fixed to the substrate at the bottom. Moreover, the adjoining ones of the circuit layers in the stacked structure are mechanically and electrically interconnected with each other by way of the connecting portions formed between the adjoining circuit layers, and are electrically insulated from each other by the adhesive in the region other than the connecting portions. Each of the first to n-th circuit layers is formed to include the at least one semiconductor circuit.

Therefore, by preparing a plurality of semiconductor circuits (e.g., semiconductor chips, i.e., chip-shaped semiconductor circuits, or semiconductor devices) having different functions and arranging these semiconductor circuits in the first to n-th circuit layers according to the necessity, and by combining the semiconductor circuits having different functions as necessary, a desired systemized function can be realized.
Regarding the electrical interconnection (wiring) between the internal circuits, i.e., the first to n-th circuit layers (and between the semiconductor circuits), it can be performed by way of the connecting portions within the stacked structure. Regarding the packaging, a package can be formed by the support substrate and the electrically insulative adhesive used for forming the stacked structure. Accordingly, the difficulty in the electrical interconnection (wiring) between the internal circuits and in the packaging can be eliminated or suppressed.

Moreover, the stacked structure is formed by stacking in sequence the first to n-th circuit layers each including at least one semiconductor circuit. Thus, if each of the circuit layers includes a single semiconductor circuit, the circuit layer may be formed by arranging the said semiconductor circuit, for example, in such a way as to form a gap in its periphery and to fill the gap with the adhesive. If each of the circuit layers includes a plurality of semiconductor circuits, the circuit layer may be formed by arranging the said semiconductor circuits, for example, in such a way as to be apart from each other and to fill the gap(s) formed in the periphery of the said semiconductor circuits with the adhesive. If the semiconductor circuits arranged in any one of the circuit layers are different in thickness from each other, the thickness difference may be eliminated by, for example, polishing the said semiconductor circuits at their sides where the circuits are not formed, thereby adjusting their thicknesses on stacking the circuit layers. As a result, even if the semiconductor circuits to be combined are different in size, shape, and/or thickness, the said semiconductor circuits can be mounted on the substrate.

Furthermore, the stacked structure is formed by stacking the first to n-th circuit layers in the predetermined stacking direction, where each of the circuit layers includes at least one of the semiconductor circuits. Therefore, diversified functions can be realized according to the necessity by suitably combining the types (functions) of the semiconductor circuits to be arranged in the circuit layers.

In addition, with the semiconductor device according to the first aspect of the invention, at least one of the first to n-th circuit layers is such that a physical size of the semiconductor circuit included in the said circuit layer in a plane perpendicular to the stacking direction is smaller than a physical size of the said circuit layer in the said plane, and the side face of the said semiconductor circuit is covered with the adhesive. Therefore, the semiconductor device according to the first aspect of the invention is evidently different from the known prior-art semiconductor device having a structure that a plurality of semiconductor chips (i.e., chip-shaped semiconductor circuits or semiconductor devices) are stacked and adhered on a support substrate, the said semiconductor chips are electrically connected to each other with wires, and the whole is covered with a synthetic resin package. Furthermore, the semiconductor device according to the first aspect of the invention is different from the above-described prior-art semiconductor devices as explained in BACKGROUND ART each of which is fabricated by stacking a plurality of semiconductor wafers having different integrated circuits and fixing them together to form a wafer stack and thereafter, dicing the wafer stack, also.

(3) With the semiconductor device according to the first aspect of the invention, the "support substrate" means a substrate that supports the "stacked structure". Any plate-shaped member may be used for the "support substrate" if it has a rigidity sufficient for supporting the "stacked structure". The material of the "support substrate" does not matter. Any one of semiconductor, insulator and conductor may be used. Circuits or wiring lines may be formed on the contact surface of the "support substrate" with the stacked structure. In this case, it is preferred that the said circuits or wiring lines are electrically connected to one of the circuit layers included in the "stacked structure".

Since the "stacked structure" is formed by stacking the first to n-th "circuit layers" in sequence in the predetermined direction, each of the "circuit layers" may have any structure if it includes at least one "semiconductor circuit" and the "stacked structure" can be formed by mechanically and electrically interconnecting them by way of the connecting portions. Therefore, the "circuit layer" may include one "semiconductor circuit" or two "semiconductor circuits" or more.

The "semiconductor circuit" means a solid-state circuit or circuits formed by any semiconductor. Typically, the "semiconductor circuit" is a discrete semiconductor chip (i.e., a chip-shaped semiconductor circuit or semiconductor device) obtained by forming an integrated circuit or circuits on one surface of a substrate made of a single-crystal semiconductor (e.g., silicon, or compound semiconductor such as gallium arsenide). However, the invention is not limited to this. The "semiconductor circuit" may be formed by a single semiconductor chip or a combination of semiconductor chips.

The "circuit layer" means a layer including at least one "semiconductor circuit", i.e., a solid-state circuit or circuits formed by any semiconductor. Therefore, the "circuit layer" may be formed by at least one "semiconductor circuit" alone, or a combination of at least one "semiconductor circuit" and any other material or materials (insulative layer, adhesive, and so on).

When the "circuit layer" includes a single "semiconductor circuit", the said "semiconductor circuit" may occupy the whole "circuit layer", or any other material or materials (for example, the above-described electrically insulative adhesive or other electrically insulative material or conductive material) may be located in the periphery of the said "semiconductor circuit". When the said "semiconductor circuit" occupies the whole "circuit layer", the said "circuit layer" is formed by the said semiconductor circuit alone. When the "circuit layer" includes not only the "semiconductor circuit" but also some other material, the said "circuit layer" is formed by the said semiconductor circuit and the other material located in its periphery.

When the "circuit layer" includes two or more "semiconductor circuits", the said "semiconductor circuits" may be arranged in the said "circuit layer" to be in contact with or to be apart from each other. The arrangement of the "semiconductor circuits" is optional. Some other material or materials (for example, the above-described electrically insulative adhesive or other electrically insulative material or conductive material) may be located among the said "semiconductor circuits" or in the periphery thereof. The said "semiconductor circuits" may be electrically interconnected in the said "circuit layer" or by way of wiring lines formed outside the said "circuit layer", as necessary. The said "semiconductor circuits" are typically arranged in the same orientation in the said "circuit layer" (for example, all the semiconductor circuits are arranged in such a way that their surfaces are placed upward); however, they may be arranged in different orientations from each other as necessary.

As the "electrically insulative adhesive", any electrically insulative adhesive may be used if it can unify the first to n-th circuit layers stacked in the predetermined stacking direction. Preferably, the gaps formed in the peripheries of the circuit layers in the stacked structure are filled with the said adhesive, thereby forming the sidewall of the stacked structure.

The "connecting portions" may have any structure if the connecting portions may be formed between the adjoining ones of the circuit layers in the stacked structure, and the said circuit layers may be mechanically and electrically interconnected by way of the connecting portions.

(4) In a preferred embodiment of the device according to the first aspect of the invention, a plurality of electrodes for external circuit connection, which are located at the top of the stacked structure and electrically connected to at least one of the first to n-th circuit layers, are provided. These electrodes may have any structure they satisfy the condition that they are located at the top of the stacked structure and are electrically connected to at least one of the first to n-th circuit layers. For example, the electrodes may be formed by bumps (electrodes) located at the top of the stacked structure or a combination of the bumps and solder balls fixed thereon.

In another preferred embodiment of the device according to the first aspect of the invention, in each of the connecting portions for mechanical and electrical interconnection between the adjoining ones of the circuit layers in the stacked structure, a conductive contact formed to protrude on the semiconductor circuit of one of the two adjoining circuit layers and a conductive contact formed to protrude on the semiconductor circuit of the other are mechanically connected. A gap between the adjoining ones of the circuit layers in the stacked structure is filled with the adhesive. In this case, there is an advantage that mechanical interconnection and electrical interconnection between the adjoining circuit layers are performed with high reliability. Here, microbump (electrodes) are preferably used for the contacts.

In still another preferred embodiment of the device according to the first aspect of the invention, in each of the connecting portions for mechanical and electrical interconnection between the adjoining ones of the circuit layers in the stacked structure, a conductive contact is formed between the said circuit layers, and both ends of the conductive contact are mechanically connected to the adjoining circuit layers, respectively. A gap between the adjoining ones of the circuit layers in the stacked structure is filled with the adhesive.

In still another preferred embodiment of the device according to the first aspect of the invention, at least one of the first to n-th circuit layers comprises a rigid member extending between a face of the said circuit layer and an opposing face of an adjoining one of the circuit layers or the substrate. The rigid member is used as a stopper for positioning the said circuit layer in the stacking direction, for example.

In still another preferred embodiment of the device according to the first aspect of the invention, at least one of the first to n-th circuit layers comprises a buried interconnection penetrating through the said circuit layer in the stacking direction. Electrical connection in the said circuit layer or to an adjoining one of the circuit layers is performed by using the buried interconnection.

In still another preferred embodiment of the device according to the first aspect of the invention, a whole sidewall of the stacked structure is covered with the adhesive. Typically, this corresponds to the case where semiconductor circuits each having a physical size in a plane perpendicular to the stacking direction smaller than the said circuit are used in all of the first to n-th circuit layers. This is because the semiconductor circuit usually occupies part of the said circuit layer alone and therefore, a gap is generated at the side of the said semiconductor circuit, the gap being filled with the adhesive.

In still another preferred embodiment of the device according to the first aspect of the invention, the circuit layer included in at least one of the first to n-th circuit layers is exposed from the adhesive covering a sidewall of the stacked structure. Typically, this corresponds to the case where a semiconductor circuit (a divided piece of a semiconductor wafer) having the same size as the said circuit layer is used in at least one of the circuit layers in the stacked structure. This is because, in this case, the said semiconductor circuit usually occupies the entirety of the said circuit layer and therefore, the adhesive does not exist at the side of the said semiconductor circuit.

In still another preferred embodiment of the device according to the first aspect of the invention, at least one of the first to n-th circuit layers comprises semiconductor circuits arranged at predetermined positions in a plane perpendicular to the stacking direction. In this case, the semiconductor circuits in the said circuit layers may be electrically interconnected by way of a wiring layer. The wiring layer is preferably located between the said circuit layer and its adjoining one of the circuit layers.

In still another preferred embodiment of the device according to the first aspect of the invention, the semiconductor circuit included in at least one of the first to n-th circuit layers comprises at least one dummy semiconductor circuit. Here, the "dummy semiconductor circuit" means a semiconductor circuit having no inner circuit, or having inner circuits unused (having inner circuits which are not electrically connected to another semiconductor circuit or circuits).

In still another preferred embodiment of the device according to the first aspect of the invention, the substrate comprises an inner circuit or a wiring line, the inner circuit or the wiring line being electrically connected to at least one of the first to n-th circuit layers.

In still another preferred embodiment of the device according to the first aspect of the invention, the adhesive comprises a filler. In this case, there is an advantage that the warp of the substrate or the circuit layers can be decreased by suitably setting a thermal expansion coefficient of the adhesive.

In still another preferred embodiment of the device according to the first aspect of the invention, the semiconductor circuit included in at least one of the first to n-th circuit layers comprises a redundant structure. Here, the "redundant structure" means that redundant components are added in such a way that the semiconductor circuit operates to conduct its all functions even if part of the components in the said semiconductor circuit has a malfunction. This embodiment is effective for improving the fabrication yield of the said semiconductor circuit.

(5) According to a second aspect of the present invention, a method of fabricating a semiconductor device having a three-dimensional stacked structure is provided, the device comprising:
   a support substrate; and
   a stacked structure comprising first to n-th circuit layers (n is an integer equal to 2 or greater) stacked in sequence from a bottom of the structure to a top thereof in a predetermined stacking direction and unified with an electrically insulative adhesive, the structure being fixed to the substrate at the bottom;
   wherein at least one of the first to n-th circuit layers is such that a physical size of the semiconductor circuit included in the said circuit layer in a plane perpendicular to the stacking direction is smaller than a physical size of the said circuit layer in the said plane, and a side face of the said semiconductor circuit is covered with the adhesive.
This method comprising the steps of:
mechanically connecting at least one first semiconductor circuit to a surface of the substrate at a predetermined position by way of first connecting portions;
filling a gap formed between the first semiconductor circuit and the substrate mechanically connected with a first electrically insulative adhesive, and curing the first adhesive;
polishing an opposite surface of the first semiconductor circuit to the substrate, where the gap is filled with the cured first adhesive, to adjust a thickness of the first semiconductor circuit to a predetermined value, thereby forming a first circuit layer constituting the stacked structure;
mechanically and electrically connecting at least one second semiconductor circuit to a surface of the first circuit layer at a predetermined position by way of second connecting portions;
filling a gap formed between the second semiconductor circuit and the first circuit layer with a second electrically insulative adhesive, and curing the second adhesive; and
polishing an opposite surface of the second semiconductor circuit to the substrate, where the gap is filled with the cured second adhesive, to adjust a thickness of the second semiconductor circuit to a predetermined value, thereby forming a second circuit layer constituting the stacked structure.

(6) With the method of fabricating a semiconductor device according to the second aspect of the invention, first, at least one first semiconductor circuit is mechanically connected to a surface of the support substrate at a predetermined position by way of first connecting portions. Next, a gap formed between the first semiconductor circuit and the substrate is filled with a first electrically insulative adhesive and then, the first adhesive is cured. Thereafter, an opposite surface of the first semiconductor circuit to the substrate is polished to adjust a thickness of the first semiconductor circuit to a predetermined value, thereby forming a first circuit layer constituting the stacked structure.

Subsequently, at least one second semiconductor circuit is mechanically and electrically connected to a surface of the first circuit layer at a predetermined position by way of second connecting portions. A gap formed between the second semiconductor circuit and the first circuit layer is filled with a second electrically insulative adhesive and then, the second adhesive is cured. Thereafter, an opposite surface of the second semiconductor circuit to the substrate is polished to adjust a thickness of the second semiconductor circuit to a predetermined value, thereby forming a second circuit layer constituting the stacked structure.

Following this, for example, the above-described three steps for forming the second circuit layer are repeated (n - 2) times. Thus, the first circuit layer comprising the at least one first semiconductor circuit, the second circuit layer comprising the at least one second semiconductor circuit ....., and an n-th circuit layer comprising at least one n-th semiconductor circuit are stacked on the support substrate in this order. As a result, the stacked structure is obtained.

Therefore, by preparing a plurality of semiconductor circuits (e.g., semiconductor chips) having different functions and arranging these semiconductor circuits in the first to n-th circuit layers according to the necessity, a desired systemized function can be realized by way of combination of the semiconductor circuits having different functions as necessary. Regarding the electrical interconnection (wiring) between the internal circuits, i.e., the first to n-th circuit layers (and between the semiconductor circuits), it can be performed by way of the connecting portions within the stacked structure. Regarding the packaging, a package can be formed by the support substrate and the electrically insulative adhesives used for forming the stacked structure. Accordingly, the difficulty in the electrical interconnection (wiring) between the internal circuits and in the packaging can be eliminated or suppressed.

Moreover, the stacked structure is formed by stacking the first to n-th circuit layers in sequence, where each of these circuit layers includes at least one semiconductor circuit. Thus, if each of the circuit layers includes a single semiconductor circuit, the circuit layer may be formed by locating the said semiconductor circuit, for example, in such a way as to form a gap in its periphery and to fill the gap with the first, second, ....., or n-th adhesive. If each of the circuit layers includes a plurality of semiconductor circuits, the circuit layer may be formed by arranging the said semiconductor circuits, for example, in such a way as to be apart from each other and to fill the gap(s) formed in the peripheries of the said semiconductor circuits with the first, second, ....., or n-th adhesive. If the semiconductor circuits arranged in any one of the circuit layers are different in thickness from each other, the thickness difference is eliminated by polishing the said semiconductor circuits at their sides where the circuits are not formed, thereby adjusting their thicknesses on stacking the circuit layers. As a result, even if the semiconductor circuits to be combined are different in size and/or thickness, these semiconductor circuits can be mounted on the substrate.

Furthermore, the stacked structure is formed by stacking the first to n-th circuit layers in the predetermined stacking direction, where each of the circuit layers includes at least one of the semiconductor circuits. Therefore, diversified functions can be realized according to the necessity by suitably combining the types (functions) of the semiconductor circuits to be arranged in the circuit layers.

(7) With the method of fabricating a semiconductor device according to the second aspect of the invention, the meanings of the "support substrate", the "semiconductor circuit", the "circuit layer", the "stacked structure", the "connecting portion", and the "electrically insulative adhesive" are the same as those explained for the semiconductor device according to the first aspect of the invention.

(8) In a preferred embodiment of the method of fabricating a semiconductor device according to the second aspect of the invention, by repeating the three steps for forming the second circuit layer (n - 2) times, the first circuit layer comprising the at least one first semiconductor circuit, the second circuit layer comprising the at least one second semiconductor circuit, ........, and an n-th circuit layer comprising at least one n-th semiconductor circuit are stacked on the substrate in this order, thereby forming the stacked structure.

In another preferred embodiment of the method of fabricating a semiconductor device according to the second aspect of the invention, a step of forming a plurality of electrodes for external circuit connection at predetermined positions on the n-th circuit layer is further included. The electrodes for external circuit connection are electrically connected to at least one of the first to n-th circuit layers.

In still another preferred embodiment of the method of fabricating a semiconductor device according to the second aspect of the invention, each of the second connecting portions used in the step of mechanically and electrically connecting the at least one second semiconductor circuit to the surface of the first circuit layer at the predetermined position comprises a conductive contact formed to protrude on the second semiconductor circuit and a conductive contact formed to protrude on the first semiconductor circuit. The first circuit layer and the at least one second semiconductor circuit are mechanically and electrically connected by mechanically connecting the contacts to each other directly or by way of a bonding metal. Here, microbump electrodes are preferably used for the contacts.

Specifically, if the contacts have a property that they are bonded to each other when contacted under heat and pressure (e.g., they have a two-layer structure of indium (In) and gold (Au)), the bonding metal is unnecessary and thus, the contacts may be bonded by directly contacting them. However, if the contacts have a property that they are not bonded to each other even when contacted under heat and pressure (e.g., they are made of tungsten (W)), they need to be bonded by way of an intervening bonding metal. As the bonding metal, for example, an In-Au alloy, a tin-gold (Sn-Ag) alloy, In, Sn, or the like is preferably used.

In still another preferred embodiment of the method of fabricating a semiconductor device according to the second aspect of the invention, each of the second connecting portions used in the step of mechanically and electrically connecting the at least one second semiconductor circuit to the surface of the first circuit layer at the predetermined position comprises a conductive contact formed to protrude on the second semiconductor circuit or the first semiconductor circuit. The first circuit layer and the at least one second semiconductor circuit are mechanically and electrically connected by mechanically connecting each end of the contact to the first circuit layer and the at least one second semiconductor circuit, respectively. Here, a microbump electrode is preferably used for the contact.

In still another preferred embodiment of the method of fabricating a semiconductor device according to the second aspect of the invention, at least one of the first semiconductor circuit and the second semiconductor circuit comprises a rigid member protruding toward an opposing face of the substrate or the first circuit layer adjoining thereto. The rigid member is used as a stopper for positioning the first semiconductor circuit and/or the second semiconductor circuit in the stacking direction.

In still another preferred embodiment of the method of fabricating a semiconductor device according to the second aspect of the invention, at least one of the first semiconductor circuit and the second semiconductor circuit comprises a buried interconnection that does not penetrate through the said semiconductor circuit. When the opposite surface of the said semiconductor circuit to the substrate is polished, the interconnection is turned to a penetrating state where the interconnection penetrates through the said semiconductor circuit.

In still another preferred embodiment of the method of fabricating a semiconductor device according to the second aspect of the invention, the first circuit layer includes a plurality of the first semiconductor circuits and the second circuit layer includes a plurality of the second semiconductor circuits.

In still another preferred embodiment of the method of fabricating a semiconductor device according to the second aspect of the invention, the first circuit layer has a physical size in a plane perpendicular to the stacking direction larger than a physical size of the at least one first semiconductor circuit in the plane. A side face of the first semiconductor circuit is covered with the first adhesive. The second circuit layer has a physical size in a plane perpendicular to the stacking direction larger than a physical size of the at least one second semiconductor circuit in the plane. A side face of the second semiconductor circuit is covered with the second adhesive.

In still another preferred embodiment of the method of fabricating a semiconductor device according to the second aspect of the invention, filling the gap with the first or second adhesive is performed by spraying the first or second adhesive. In this case, it is preferred that the filling of the first or second adhesive is performed in a vacuum.

In still another preferred embodiment of the method of fabricating a semiconductor device according to the second aspect of the invention, filling the gap with the first or second adhesive is performed by immersing in a liquid adhesive the first semiconductor circuit fixed to the substrate or the second semiconductor circuit fixed to the first semiconductor circuit. In this case, it is preferred that the filling of the first or second adhesive is performed in a vacuum.

In still another preferred embodiment of the method of fabricating a semiconductor device according to the second aspect of the invention, filling the gap with the first or second adhesive is performed by immersing into said liquid adhesive the first semiconductor chip layer sandwiched by a pair of pressing members or the first and second semiconductor circuits sandwiched by a pair of pressing members. In this case, it is preferred that the immersing into the adhesive is performed in a vacuum.

In still another preferred embodiment of the method of fabricating a semiconductor device according to the second aspect of the invention, filling the gap with the first or second adhesive is performed by placing the substrate and the first semiconductor chip layer or the first semiconductor chip layer and the second semiconductor chip layer in a member having a closed space, and injecting the liquid adhesive into the space under pressure.

In still another preferred embodiment of the method of fabricating a semiconductor device according to the second aspect of the invention, the first semiconductor circuits or the second semiconductor circuits are regularly placed on the substrate or the first semiconductor circuit layer and thereafter, gaps between the first semiconductor circuits or the second semiconductor circuits and their peripheries are coated with at least one of the first and second adhesives using a dispenser.

In still another preferred embodiment of the method of fabricating a semiconductor device according to the second aspect of the invention, when the first adhesive filled in the gaps are cured, a warp preventing layer is placed on an opposite surface of the substrate to the first circuit layer.

In still another preferred embodiment of the method of fabricating a semiconductor device according to the second aspect of the invention, when the gaps are filled with the first adhesive and the first adhesive is cured, a warp preventing layer for preventing warp of the substrate is placed on an opposite surface of the substrate to the first circuit layer.

In still another preferred embodiment of the method of fabricating a semiconductor device according to the second aspect of the invention, when the gaps are filled with the first adhesive or the first adhesive is cured, a first warp preventing layer for preventing warp of the substrate is placed on an opposite surface of the substrate to the first circuit layer; and when the gaps are filled with the second adhesive or the second adhesive is cured, a second warp preventing layer for preventing warp of the substrate is placed on the first warp preventing layer.

In still another preferred embodiment of the method of fabricating a semiconductor device according to the second aspect of the invention, after mechanically connecting the first semiconductor circuit to the substrate by way of the first connecting portions, a step of warping the substrate toward an opposite side to a warp of the substrate to be generated by curing of the first adhesive is included.

In still another preferred embodiment of the method of fabricating a semiconductor device according to the second aspect of the invention, at least one of the first and second adhesives contains a filler.

In still another preferred embodiment of the method of fabricating a semiconductor device according to the second aspect of the invention, a step of dicing the substrate and the stacked structure along a cutting plane or planes parallel to the stacking direction to form semiconductor devices is included.

In still another preferred embodiment of the method of fabricating a semiconductor device according to the second aspect of the invention, the semiconductor circuit included in at least one of the first to n-th circuit layers comprises a redundant structure. Here, the meaning of the "redundant structure" is the same as described for the semiconductor device according to the first aspect of the invention. There is an advantage that the fabrication yield of the semiconductor device having a three-dimensional stacked structure is improved.

### ADVANTAGEOUS EFFECTS OF THE INVENTION

With the semiconductor device having a three-dimensional stacked structure and its fabrication method according to the invention, a desired systemized function is realizable by combining a plurality of semiconductor circuits having different functions according to the necessity while eliminating or suppressing the difficulty in the electrical interconnection (wiring) between the internal circuits and in the packaging. Moreover, even if semiconductor circuits to be combined are different in size, shape, and/or thickness, the semiconductor circuits can be combined and mounted on a single support substrate. Furthermore, diversified functions are realizable according to the necessity.

### BRIEF DESCRIPTION OF THE DRAWINGS

Fig. 1 is a cross-sectional view showing the basic concept of a method of fabricating a semiconductor device having a three-dimensional stacked structure according to the invention.
Fig. 2 is a cross-sectional view showing the basic concept of the method of fabricating the semiconductor device having a three-dimensional stacked structure according to the invention, which is subsequent to Fig. 1.
Fig. 3 is a cross-sectional view showing the basic concept of the method of fabricating the semiconductor device having a three-dimensional stacked structure according to the invention, which is subsequent to Fig. 2.
Fig. 4 is a cross-sectional view showing the process steps of a method of fabricating a semiconductor device having a three-dimensional stacked structure according to a first embodiment of the invention.
Fig. 5 is a cross-sectional view showing the process steps of the method of fabricating the semiconductor device having a three-dimensional stacked structure according to the first embodiment of the invention, which is subsequent to Fig. 4.
Fig. 6 is a cross-sectional view showing the process steps of the method of fabricating the semiconductor device having a three-dimensional stacked structure according to the first embodiment of the invention, which is subsequent to Fig. 5.
Fig. 7 is a cross-sectional view showing the process steps of a method of fabricating a semiconductor device having a three-dimensional stacked structure according to a second embodiment of the invention.
Fig. 8 is a cross-sectional view showing the process steps of the method of fabricating the semiconductor device having a three-dimensional stacked structure according to the second embodiment of the invention, which is subsequent to Fig. 7.
Fig. 9 is a cross-sectional view showing the process steps of the method of fabricating the semiconductor device having a three-dimensional stacked structure according to the second embodiment of the invention, which is subsequent to Fig. 8.
Fig. 10 is a cross-sectional view showing the state prior to the step of fixing the semiconductor chips to the support substrate in the method of fabricating the semiconductor device according to the second embodiment of the invention.
Fig. 11 is a cross-sectional view showing a variation of the method of fabricating the semiconductor device having a three-dimensional stacked structure according to the second embodiment of the invention.
Fig. 12 is a cross-sectional view showing another variation of the method of fabricating the semiconductor device having a three-dimensional stacked structure according to the second embodiment of the invention.
Fig. 13 is a cross-sectional view showing the process steps of a method of fabricating a semiconductor device having a three-dimensional stacked structure according to a third embodiment of the invention.
Fig. 14 is a cross-sectional view showing a method of fabricating a semiconductor device having a three-dimensional stacked structure according to a fourth embodiment of the invention.
Fig. 15 is a cross-sectional view showing a method of fabricating a semiconductor device having a three-dimensional stacked structure according to a fifth embodiment of the invention.
Fig. 16 is a cross-sectional view showing a method of fabricating a semiconductor device having a three-dimensional stacked structure according to a sixth embodiment of the invention.
Fig. 17 is a cross-sectional view showing the process steps of a method of fabricating a semiconductor device having a three-dimensional stacked structure according to a seventh embodiment of the invention.
Fig. 18 is a cross-sectional view showing the process steps of a method of fabricating a semiconductor device having a three-dimensional stacked structure according to an eighth embodiment of the invention.
Fig. 19 is a cross-sectional view showing the process steps of a method of fabricating a semiconductor device having a three-dimensional stacked structure according to a ninth embodiment of the invention.
Fig. 20 is a cross-sectional view showing the process steps of a method of fabricating a semiconductor device having a three-dimensional stacked structure according to a tenth embodiment of the invention.
Fig. 21 is a cross-sectional view showing the process steps of a method of fabricating a semiconductor device having a three-dimensional stacked structure according to an eleventh embodiment of the invention.
Fig. 22 is a cross-sectional view showing the process steps of a method of fabricating a semiconductor device having a three-dimensional stacked structure according to a twelfth embodiment of the invention.
Fig. 23 is a cross-sectional view showing the process steps of the method of fabricating the semiconductor device having a three-dimensional stacked structure according to the twelfth embodiment of the invention, which is subsequent to Fig. 22.
Fig. 24 is a cross-sectional view showing the process steps of a method of fabricating a semiconductor device having a three-dimensional stacked structure according to a thirteenth embodiment of the invention.
Fig. 25 is a cross-sectional view showing the process steps of the method of fabricating the semiconductor device having a three-dimensional stacked structure according to the thirteenth embodiment of the invention, which is subsequent to Fig. 24.
Fig. 26 is a cross-sectional view showing the process steps of a method of fabricating a semiconductor device having a three-dimensional stacked structure according to a fourteenth embodiment of the invention.
Fig. 27 is a cross-sectional view showing a second example of the method of filling the adhesive to be used in the methods of fabricating the semiconductor devices according to the first to fourteenth embodiments of the invention.
Fig. 28 is a cross-sectional view showing the second example of the method of filling the adhesive to be used in the methods of fabricating the semiconductor devices according to the first to fourteenth embodiments of the invention.
Fig. 29 is a cross-sectional view showing a third example of the method of filling the adhesive to be used in the methods of fabricating the semiconductor devices according to the first to fourteenth embodiments of the invention.
Fig. 30 is a cross-sectional view showing a fourth example of the method of filling the adhesive to be used in the methods of fabricating the semiconductor devices according to the first to fourteenth embodiments of the invention.
Fig. 31 is a cross-sectional view showing a fifth example of the method of filling the adhesive to be used in the methods of fabricating the semiconductor devices according to the first to fourteenth embodiments of the invention.
Fig. 32 is a cross-sectional view showing the fifth example of the method of filling the adhesive to be used in the methods of fabricating the semiconductor devices according to the first to fourteenth embodiments of the invention.
Fig. 33 is a cross-sectional view showing the fifth example of the method of filling the adhesive to be used in the methods of fabricating the semiconductor devices according to the first to fourteenth embodiments of the invention.
Fig. 34 is a cross-sectional view showing the fifth example of the method of filling the adhesive to be used in the methods of fabricating the semiconductor devices according to the first to fourteenth embodiments of the invention.
Fig. 35 is a cross-sectional view showing the fifth example of the method of filling the adhesive to be used in the methods of fabricating the semiconductor devices according to the first to fourteenth embodiments of the invention.
Fig. 36 is a cross-sectional view showing a first example of the method of preventing the warp of the support substrate to be used in the methods of fabricating the semiconductor devices according to the first to fourteenth embodiments of the invention.
Fig. 37 is a cross-sectional view showing a second example of the method of preventing the warp of the support substrate to be used in the methods of fabricating the semiconductor devices according to the first to fourteenth embodiments of the invention.
Fig. 38 is a cross-sectional view showing a third example of the method of preventing the warp of the support substrate to be used in the methods of fabricating the semiconductor devices according to the first to fourteenth embodiments of the invention.
Fig. 39 is a conceptual illustration showing the warped state of the support substrate that may occur in the methods of fabricating the semiconductor devices according to the first to fourteenth embodiments of the invention.
Fig. 40 is a conceptual illustration showing a fourth example of the method of preventing the warp of the support substrate to be used in the methods of fabricating the semiconductor devices according to the first to fourteenth embodiments of the invention.
Fig. 41 is a conceptual illustration showing a first variation of the method of placing semiconductor chips to be used in the methods of fabricating the semiconductor devices according to the first to fourteenth embodiments of the invention.
Fig. 42 is a conceptual illustration showing a second variation of the method of placing semiconductor chips to be used in the methods of fabricating the semiconductor devices according to the first to fourteenth embodiments of the invention.
Fig. 43 is a partial cross-sectional view showing the method of bonding semiconductor chips with bonding metals in detail used in the method of fabricating the semiconductor device according to the first embodiment of the invention.
Fig. 44 is a partial cross-sectional view showing the method of bonding semiconductor chips with bonding metals in detail used in the method of fabricating the semiconductor device according to the first embodiment of the invention, which is subsequent to Fig. 43.
Fig. 45 is a partial cross-sectional view showing the method of bonding semiconductor chips with bonding metals in detail used in the method of fabricating the semiconductor device according to the first embodiment of the invention, where the bonding metals are left after the bonding, which is subsequent to Fig. 44.
Fig. 46 is a partial cross-sectional view showing the method of bonding semiconductor chips with bonding metals in detail used in the method of fabricating the semiconductor device according to the first embodiment of the invention, where the bonding metals are not left after the bonding, or no bonding metals are used, which is subsequent to Fig. 44.
Fig. 47 is an enlarged partial cross-sectional view showing the detailed structure of the microbump electrode used in the method of fabricating the semiconductor device according to the first embodiment of the invention.
Fig. 48 is a schematic plan view showing the arrangements of the solder balls for external circuit connection and the microbump electrodes of the semiconductor device according to the invention.
Fig. 49 is a schematic cross-sectional view showing the detailed structure of the semiconductor chip of the semiconductor device having a three-dimensional stacked structure according to the invention.

### DESCRIPTION OF THE REFERENCE SYMBOLS

- 10A, 10B, 10C, 10D: semiconductor device
- 11: support substrate
- 11a: mounting surface of the support substrate
- 12: connecting portion
- 13: semiconductor chip
- 14: adhesive
- 15: connecting portion
- 16: semiconductor chip
- 17: adhesive
- 18: connecting portion
- 19: semiconductor chip
- 20: adhesive
- 21: connecting portion
- 22: semiconductor chip
- 23: adhesive
- 24: insulating layer
- 25: conductive plug
- 26: microbump electrode for external circuit connection
- 27: solder ball
- 30A, 30B, 30C, 30A', 30B', 30C', 30D: semiconductor device
- 31: support substrate
- 32: insulating layer
- 33: wiring line
- 34: conductive plug
- 35, 36: microbump electrode
- 37: semiconductor chip
- 37A: semiconductor wafer
- 38, 38a: adhesive
- 38aa: filler-containing adhesive
- 38b: filler
- 38bb: filler-containing filler
- 39: insulating layer
- 40: conductive plug
- 41, 42: microbump electrode
- 43: semiconductor chip
- 44: adhesive
- 45: insulating layer
- 46: conductive plug
- 47, 48: microbump electrode
- 49: semiconductor chip
- 50: adhesive
- 51, 53, 55: insulating layer
- 52, 54, 56: conductive material (buried interconnection)
- 57, 57a, 57b, 58, 59: stopper
- 60: microbump electrode for external circuit connection
- 61: insulating layer
- 71: wiring layer
- 72: insulating layer
- 80, 81, 82: warp-preventing adhesive
- 90: warp applying apparatus
- 91,92: pressing member
- 100: structure
- 101, 102: pressing plate
- 103: support rod
- 104: substrate
- 104': piece of substrate
- 105: semiconductor wafer
- 105': piece of semiconductor wafer
- 106: stack
- 111: chamber
- 112: container for adhesive
- 113: adhesive
- 114: heater
- 120: bonding metal
- 121: clamp member
- 121a: injection hole
- 122: closed space
- 131, 132, 133: carrier substrate
- 151, 153: insulating layer
- 152: wiring layer
- 154: conductive plug
- 160: MOS transistor
- 161: source/drain region
- 162: gate insulating layer
- 163: gate electrode
- 171, 173: abstemious smoking layer
- 172: wiring layer
- 174: conductive plug
- R1, R2: connecting portion
- C: semiconductor integrated circuit (semiconductor solid-state circuits) formed on semiconductor chip
- L1: first semiconductor circuit layer
- L2: second semiconductor circuit layer
- L3: third semiconductor circuit layer
- L4: fourth semiconductor circuit layer

### BEST MODE FOR CARRYING OUT THE INVENTION

Preferred embodiments of the present invention will be described in detail below while referring to the drawings attached.

### BASIC CONCEPT OF THE INVENTION

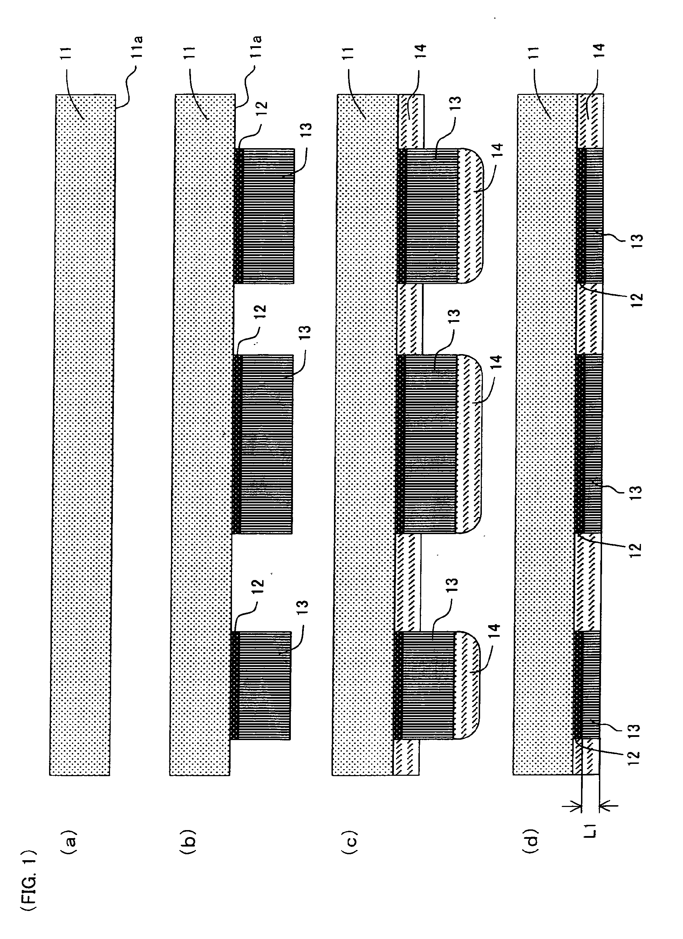

Figs. 1 to 3 are cross-sectional views showing the basic concept of a method of fabricating a semiconductor device having a three-dimensional stacked structure according to the invention.

First, a support substrate having a desired rigidity is prepared, as shown in Fig. 1(a). The substrate 11 comprises a flat mounting surface 11a for mounting semiconductor chips (i.e., chip-shaped semiconductor circuits) thereon at one side thereof. As the substrate 11, for example, a glass, a single-crystal silicon (Si) wafer (an integrated circuit is formed in its surface area, or no integrated circuit is formed), or the like may be preferably used.

Next, as shown in Fig. 1(b), semiconductor chips 13, each of which has a known structure, are fixed at predetermined positions on the mounting surface 11a of the substrate 11. Predetermined gaps are formed between the adjoining chips 13 and between the chips 13 and the edge of the substrate 11. These chips 13, which are so-called Known Good Dies (KGDs), may have any structure (which includes a desired built-in integrated circuit or circuits), and may be fabricated by any method. The chips (chip-shaped semiconductor circuits) 13 and a cured adhesive 14 located in the gaps among the chips 13 and on their peripheries constitute a first semiconductor circuit layer L1. In other words, the first semiconductor circuit layer L1 is constituted by the chips (chip-shaped semiconductor circuits) 13 and the adhesive 14 located on the peripheries thereof.

Actually, it is usual that several to several hundreds of the chips 13 are fixed. However, three chips as shown will be explained here for the sake of simplification of explanation.

The fixing of the semiconductor chips 13 onto the mounting surface 11a of the support substrate 11 is performed by using connecting portions 12 formed on the surfaces of the respective chips 13. Although the concrete structure of the connecting portion 12 is explained later, the portion 12 can be realized by using, for example, microbump electrodes. The mechanical and electrical connection between the chips 13 and the mounting surface 11a is simultaneously performed with the connecting portions 12. The state at this stage is shown in Fig. 1(b). The chips 13 may be fixed, for example, in one-to-one correspondence with a known high-speed chip bonder. Alternately, all the chips 13 may be located on a support member (not shown) in advance according to a predetermined layout and then, all the chips 13 may be fixed onto the mounting surface 11a in a lump with the support member.

Corresponding to the connecting portions 12 of the chips 13, connecting portions (not shown) similar to the connecting portions 12 may be formed at predetermined positions on the mounting surface 11a of the substrate 11. In this case, the connection portions 12 of the chips 13 and the connecting portions of the mounting surface 11a are respectively joined, thereby accomplishing the mechanical and electrical connection between the chips 13 and the surface 11a.

Next, as shown in Fig. 1(c), the liquid or fluid adhesive 14 is placed in an appropriate way in the gaps on the peripheries of the semiconductor chips 13 fixed to the mounting surface 11a by way of the connecting portions 12. Thereafter, the adhesive 14 is cured by applying heat, irradiating ultraviolet rays, or the like. It is preferred that the adhesive 14 is made of electrically insulative synthetic resin. This is because the adjoining chips 13 need to be electrically insulated from each other, and the resin 14 serves as part of the package of the said semiconductor device. At this time, it is not necessary that the thickness of the cured layer of the adhesive 14 formed on the mounting surface 11a amounts to the overall height of the chips 13. It is sufficient that the gaps (which include the connecting portions 12) are designed in such a way as to be entirely filled with the adhesive 14 when the chips 13 are thinned by polishing in the next step.

In this embodiment, the support substrate 11 is turned upside down and then, a method of spraying the liquid adhesive 14 is used in the state where the surface of the substrate 11 faces upward. Therefore, the adhesive 14 is attached to the opposite faces (i.e., the reverses) of the chips 13 to the connecting portions 12 also. Since the adhesive 14 on the reverses of the chips 13 are removed in the subsequent semiconductor-chip polishing step, no problem will occur.

Next, the opposite faces (i.e., the reverses) of all the semiconductor chips 13 to their adhered surface, which have been fixed to the mounting surface 11a of the substrate 11, are polished in a lump by the CMP (Chemical Mechanical Polishing) method. As shown in Fig. 1(d), this polishing step is carried out in such a way that the reverses of the respective chips 13 form the same plane as the cured layer of the adhesive 14 existing around the chips 13. Practically, it is preferred that this step is carried out until the cured layer of the adhesive 14 is slightly polished, thereby planarizing the exposed surface of the cured layer of the adhesive 14 simultaneously with the polishing of the reverses of the chips 13. In addition, in this polishing step using the CMP method, the known mechanical polishing method may be used together according to the necessity. This is applicable to all the semiconductor chip polishing steps to be explained below.

The polishing of the reverses of the chips 13 by the CMP method will cause no obstacle relating to the operation of the chips 13. This is because the integrated circuit incorporated in each chip 13 is formed only in the surface area of the chip 13 at its surface side at a very small depth and therefore, the remaining part of the chip 13 is unconcerned about the circuit operation.

Through the above-described steps, as shown in Fig. 1(d), a first semiconductor circuit layer L1 including the semiconductor chips 13 is formed on the mounting surface 11a of the support substrate 11. Therefore, it may be said that the first semiconductor circuit layer L1 including the chips 13 is fixed to the surface 11a with the connecting portions 12 of the respective chips 13 and the adhesive 14. Since the mechanical connection of the chips 13 to the surface 11a is performed by not only the connecting portions 12 but also the adhesive 14, sufficient connection strength is obtained.

Next, in approximately the same way as above, a plurality of semiconductor chips 16 are arranged on the first semiconductor circuit layer L1 formed through the above-described steps, thereby forming a second semiconductor circuit layer L2.

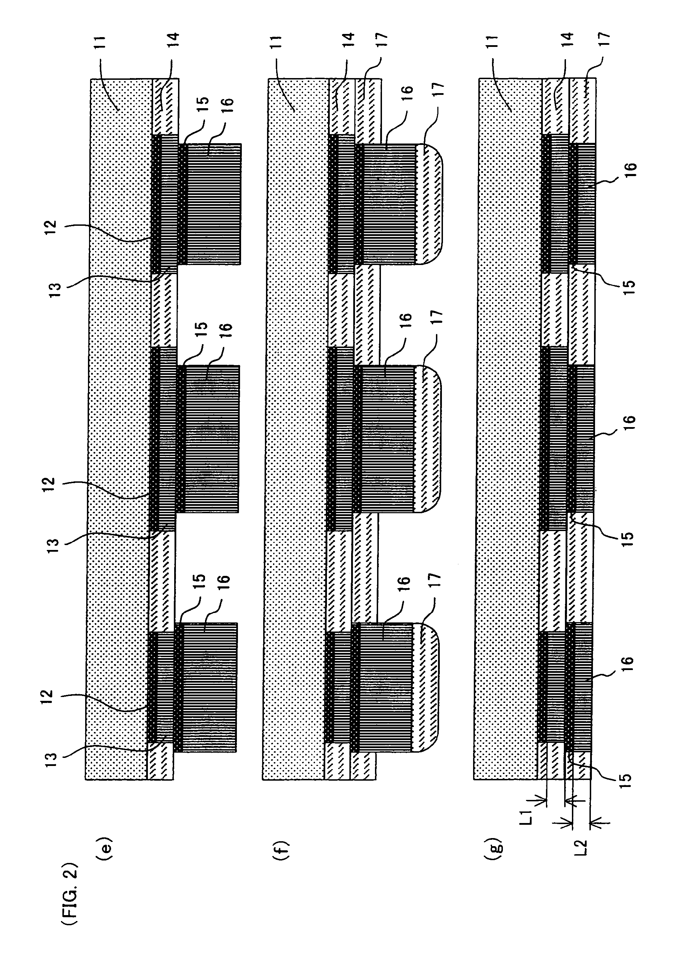

Specifically, as shown in Fig. 2(e), semiconductor chips 16 (i.e., chip-shaped semiconductor circuits), each of which has a connecting portion 15 on its surface, are respectively fixed to the reverses of the chips 13 exposed from the cured layer of the adhesive 14 in such a way as to be superposed on the corresponding chips 13. The structure of the connecting portion 15 of the chip 16 is the same as that of the connecting portion 12 of the chip 13 of the first semiconductor circuit layer L1. The mechanical and electrical connection between the chips 16 and the chips 13 is simultaneously accomplished by the connecting portions 15.

If the chip 16 is smaller than the chip 13, the whole connecting portion 15 of the chip 16 is covered with the reverse of the chip 13. However, if the chip 16 is larger than the chip 13, part of the connecting portion 15 of the chip 16 protrude from the reverse of the chip 13, where the protruding part contacts the adhesive 14.

Thereafter, as shown in Fig. 2(e), the gaps formed on the peripheries of the chips 16 fixed to the corresponding chips 13 of the first semiconductor circuit layer L1 by way of the connection portions 15 are filled with a liquid or fluid adhesive 17 in the same way as used for the chips 13. Then, the adhesive 17 is cured by applying heat, irradiating ultraviolet rays, or the like. The state at this stage is shown in Fig. 2(f).

Next, the opposite faces (i.e., the reverses) of all the fixed chips 16 to their fixed faces are polished by the CMP method, thereby making the reverses of the respective chips 16 located in the same plane as the cured layer of the adhesive 17, as shown in Fig. 2(g). In this way, the chips 16 are mechanically and electrically connected to the corresponding chips 13 with the connecting portions 15. Thus, a second semiconductor circuit layer L2 including the chips 16 and the cured layer of the adhesive 17 is formed to be superposed on the first semiconductor circuit layer L1. The mechanical and electrical connection between the second semiconductor circuit layer L2 and the first semiconductor circuit layer L1 is carried out by the connecting portions 15 of the respective chips 16.

Next, in approximately the same way as above, a plurality of semiconductor chips 19 are arranged on the second semiconductor circuit layer L2 formed through the above-described steps, thereby forming a third semiconductor circuit layer L3.

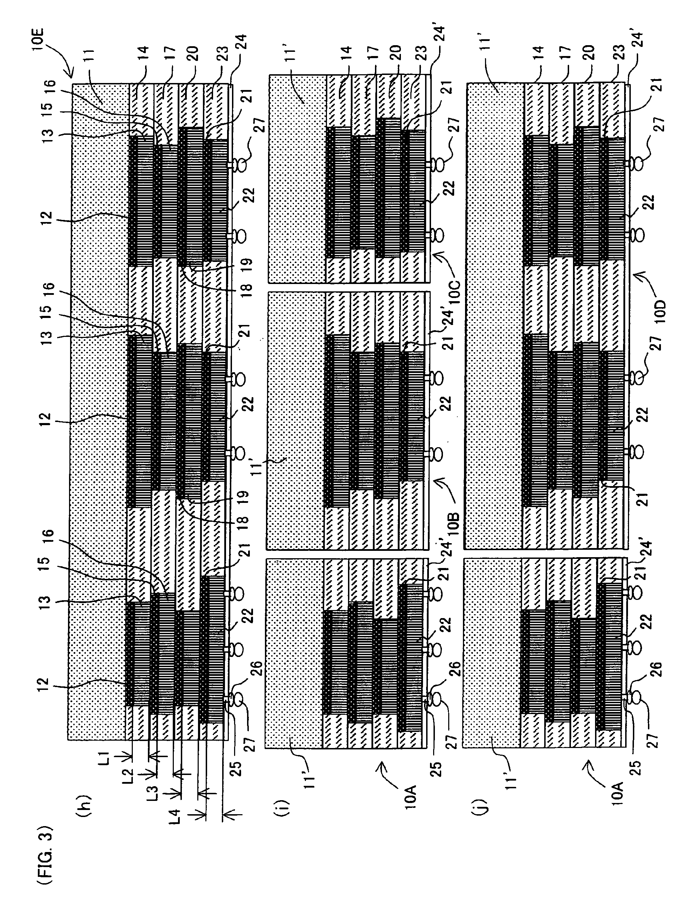

Specifically, as shown in Fig. 3(h), semiconductor chips 19 (i.e., chip-shaped semiconductor circuits), each of which has a connecting portion 18 in its surface, are respectively fixed to the reverses of the chips 16 exposed from the cured layer of the adhesive 17 of the second semiconductor circuit layer L2 in such a way as to be superposed thereon. The structure of the connecting portion 18 of the chip 19 is the same as that of the connecting portion 12 of the chip 13 of the first semiconductor circuit layer L1. The mechanical and electrical connection between the chips 19 and the chips 16 is simultaneously accomplished by the connecting portions 18.

If the chip 19 is smaller than the chip 16, the whole connecting portion 18 of the chip 19 is covered with the reverse of the chip 16. However, if the chip 19 is larger than the chip 16, part of the connecting portion 18 of the chip 19 protrude from the reverse of the chip 16, where the protruding part contacts the adhesive 17.

Thereafter, the gaps formed on the peripheries of the chips 19 fixed to the corresponding chips 16 of the second semiconductor circuit layer L2 by way of the connection portions 18 are filled with a liquid or fluid adhesive 20 in the same way as used for the chips 13. Then, the adhesive 20 is cured by applying heat, irradiating ultraviolet rays, or the like.

Next, the opposite faces (i.e., the reverses) of the fixed chips 19 to their fixed faces are polished by the CMP method, thereby making the reverses of the respective chips 19 located in the same plane as the cured layer of the adhesive 20. In this way, the chips 19 are mechanically and electrically connected to the corresponding chips 16 with the connecting portions 18. Thus, a third semiconductor circuit layer L3 including the chips 19 and the cured layer of the adhesive 20 is formed to be superposed on the second semiconductor circuit layer L2. The mechanical and electrical connection between the third semiconductor circuit layer L3 and the second semiconductor circuit layer L2 is carried out by the connecting portions 18 of the respective chips 19.

Next, in approximately the same way as above, a plurality of semiconductor chips 22 are arranged on the third semiconductor circuit layer L3 formed through the above-described steps, thereby forming a fourth semiconductor circuit layer L4.

Specifically, as shown in Fig. 3(h), semiconductor chips 22 (i.e., chip-shaped semiconductor circuits), each of which has a connecting portion 21 on its surface, are respectively fixed to the reverses of the chips 19 exposed from the cured layer of the adhesive 20 of the third semiconductor circuit layer L3 in such a way as to be superposed thereon. The structure of the connecting portion 21 of the chip 22 is the same as that of the connecting portion 12 of the chip 13 of the first semiconductor circuit layer L1. The mechanical and electrical connection between the chips 22 and the chips 19 is simultaneously accomplished by the connecting portions 21.

If the chip 22 is smaller than the chip 19, the whole connecting portion 21 of the chip 22 is covered with the reverse of the chip 19. However, if the chip 22 is larger than the chip 19, part of the connecting portion 21 of the chip 22 protrude from the reverse of the chip 19, where the protruding part contacts the adhesive 20.

Thereafter, the gaps formed on the peripheries of the chips 22 fixed to the corresponding chips 19 of the third semiconductor circuit layer L3 by way of the connection portions 21 are filled with a liquid or fluid adhesive 23 in the same way as used for the chips 13. Then, the adhesive 23 is cured by applying heat, irradiating ultraviolet rays, or the like.

Next, the opposite faces (i.e., the reverses) of the fixed chips 22 to their fixed faces are polished by the CMP method, thereby making the reverses of the respective chips 22 located in the same plane as the cured layer of the adhesive 23. In this way, the chips 22 are mechanically and electrically connected to the corresponding chips 19 with the connecting portions 21. Thus, a fourth semiconductor circuit layer L4 including the chips 22 and the cured layer of the adhesive 23 is formed to be superposed on the third semiconductor circuit layer L3. The mechanical and electrical connection between the fourth semiconductor circuit layer L4 and the third semiconductor circuit layer L3 is carried out by the connecting portions 21 of the respective chips 22.

Subsequently, an insulating layer 24 is formed on the surface formed by the chips 22 and the cured layer of the adhesive 23 of the fourth semiconductor circuit layer L4, thereby covering the entirety of the said surface. Conductive plugs 25 (buried interconnections), which are connected to the internal integrated circuits of the corresponding chips 22 through the insulating layer 24, are formed at the predetermined positions. Then, microbump electrodes (electrodes formed by microbumps) 26, each of which is fixed to one end of the corresponding plug 25, are formed. Finally, ball-shaped solders (solder balls) 27 are fixed onto the respective electrodes 26. The solder balls 27 may be cancelled.

Through the above-described steps, as shown in Fig. 3(h), a stacked structure formed by sequentially stacking the first to fourth semiconductor circuit layers L1 to L4 on the mounting surface 11a of the support substrate 11 is obtained. This stacked structure includes chip stacks each of which is formed by four stacked chips 13, 16, 19, and 22 (chip-shaped semiconductor circuits). These chip stacks are arranged apart from each other in a direction parallel to the substrate 11, and the gaps on the peripheries of the said chip stacks are filled with the cured adhesives 14, 17, 20, and 23. In each of the chip stacks, the stacked chips 13, 16, 19, and 22 are electrically interconnected.

Subsequently, the stacked structure comprising the first to fourth semiconductor circuit layers L1 to L4 is subjected to a dicing process by a known method, thereby dividing the stacked structure into desired semiconductor devices. This dicing process is performed in such a way that the dicing blade passes through between the adjoining chip stacks. In this way, semiconductor devices 10A, 10B and 10C as shown in Fig. 3(i) are obtained. Each of the devices 10A, 10B and 10C comprises a three-dimensional stacked structure, wherein a set of four semiconductor chips 13, 16, 19, and 22 having different sizes and functions are stacked on the divided substrate 11'.

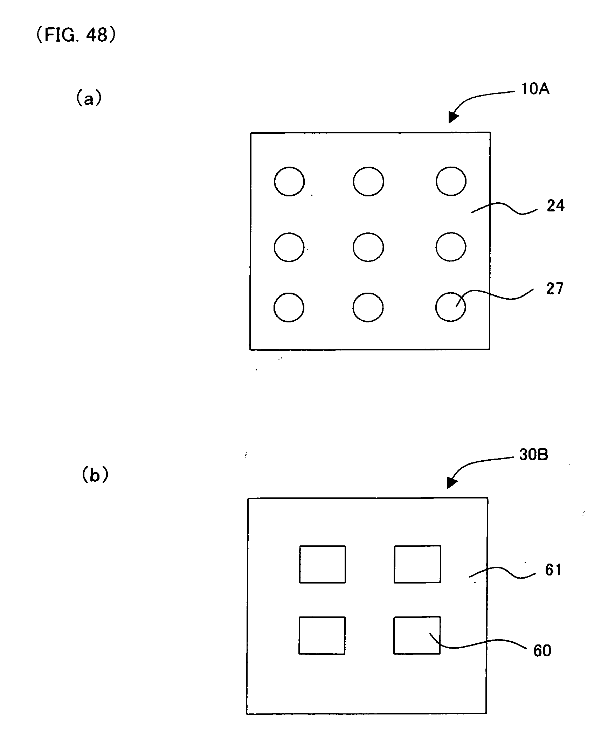

Fig. 48(a) is a schematic plan view showing the layout of the solder balls 27 of the semiconductor device 10A. The solder balls 27 (i.e., the microbump electrodes 26) for external circuit connection are regularly arranged on the flat surface opposite to the substrate 11. This is applicable to the semiconductor devices 10B and 10C. The microbump electrodes 26 themselves may be used for external circuit connection by omitting the solder balls 27.

The dicing process is not limited to the above-described method. For example, as shown in Fig. 3(j), the dicing process may be carried out in such a way as to include the two adjoining chip stacks, or to include the three or more chip stacks as necessary. Alternately, the entirety of the stacked structure shown in Fig. 3(h) may be used as a wafer-level semiconductor device 10E without the dicing process.

As explained above, with the method of fabricating the semiconductor device having a three-dimensional stacked structure according to the invention, by combining the semiconductor chips 13, 16, 19, and 22 (the chip-shaped semiconductor devices) with different functions together on the support substrate 11 as necessary, the semiconductor device 10A, 10B, 10C, 10D or 10E each having a three-dimensional stacked structure and capable of a systemized function can be realized. Accordingly, not only systemized semiconductor devices in a similar way to the conventional system LSI can be easily obtained but also diversified functions can be realized according to the necessity.

Moreover, the semiconductor chips 13, 16, 19, and 22 formed respectively in the first to fourth semiconductor circuit layers L1 to L4 are arranged to be apart from each other in a direction parallel to the substrate 11 in the semiconductor circuit layer L1, L2, L3, or L4. The chips 13, 16, 19, and 22 are respectively fixed by the insulative adhesives 14, 17, 20, and 23 and then, are polished from their reverse side to adjust their thicknesses. For this reason, even if the chips 13, 16, 19, and 22 to be combined (i.e., semiconductor circuits to be combined) are different in size, shape and/or thickness from each other, the chips 13, 16, 19, and 22 can be combined and mounted on the single substrate 11.

Furthermore, with the fabrication method of the invention, the semiconductor devices 10A, 10B and 10C, or the semiconductor devices 10A and 10D, or the semiconductor device 10E, each having a three-dimensional stacked structure, is/are obtained. Each of the devices 10A, 10B, 10C, 10D, and 10E comprises the substrate 11 or divided substrate 11', and the chips 13, 16, 19, and 22 having different functions mounted together on the substrate 11 or 11' according to the necessity. The opposite face of the three-dimensional stacked structure to the substrate 11 or 11' is covered with the insulating layer 24 or divided insulating layer 24'. The solder balls 27 for external circuit connection are arranged on the insulating layer 24 or 24'. The side face(s) of the stacked structure or structures is/are covered with the covering materials, i.e., the adhesives 14, 17, 20, and 23, made of the insulative synthetic resins.

As explained above, with the semiconductor devices 10A, 10B, 10C, 10D, and 10E, the electrical interconnection among the semiconductor circuit layers L1 to L4 is realized by the connecting portions 12, 15, 18, and 21. The substrate 11 or 11', the covering materials (the adhesives 14, 17, 20, and 23), and the insulating layer 24 or 24' has a function of the package that accommodates and protects the semiconductor circuit layers L1 to L4. Electrical connection to an external circuit or device can be performed using the microbump electrodes 26 or the solder balls 27 arranged on the opposite face of the stacked structure to the substrate 11 or 11'. Therefore, each of the semiconductor devices 10A, 10B, 10C, 10D, and 10E according to the invention has a structure that the semiconductor circuit layers L1 to L4 and the package are unified, in other words, a package-integrated three-dimensional stacked structure. As a result, similar systemization to conventional system LSIs can be easily realized while eliminating or suppressing the difficulty in the electrical interconnection (wiring) between the internal circuits and in the packaging and at the same time, diversified functions can be realized according to the necessity.

In the above explanation, semiconductor chips (chip-shaped semiconductor circuits) are used as the semiconductor circuit constituting each of the first to fourth semiconductor circuit layers L1 to L4. However, a semiconductor wafer (a wafer-shaped semiconductor circuits) may be used for this purpose. Although one semiconductor chip in one of the semiconductor circuit layers L1 to L4 is superposed on a corresponding semiconductor chip in an adjoining one of the semiconductor circuit layers L1 to L4 in the above explanation, the invention is not limited to this. One semiconductor chip in one of the semiconductor circuit layers L1 to L4 may be superposed on two or more corresponding semiconductor chips in an adjoining one of the semiconductor circuit layers L1 to L4.

Moreover, although semiconductor chips judged as KGDs are used in each of the first to fourth semiconductor circuit layers L1 to L4 in the above explanation, it is unnecessary for the invention that all the semiconductor chips in each of the semiconductor circuit layers are KGDs. With the semiconductor chip judged as a KGD, it is unnecessary that all the circuits formed in this chip are used (or operated), which means that an unused (or non-operable) circuit or circuits (e.g., a redundant section) may be included therein. Here, the "redundant section" means that redundant components are added to the chip in advance in such a way that the chip operates to conduct all the functions even if part of the components in the said chip has a malfunction. If a defect is found in some of the circuit components in the first to fourth semiconductor circuit layers L1 to L4 at the inspection stage after the stacking, adjustment is applied to the said components so that the circuit components in the redundant section are used instead of the defective components. This is easily carried out by cutting the wiring lines connected to the defective components by, for example, supplying a predetermined electric current from the outside and then, switching the wiring lines in such a way as to be connected to the redundant components. Since this is well known in the said art, explanation is omitted here. Due to preparation of the redundant section, there is an additional advantage that the fabrication yield of the said semiconductor device is increased.

If the semiconductor chip providing specific circuit functions in one of the first to fourth semiconductor circuit layers L1 to L4 is unnecessary, it is preferred that the position of the said chip is filled with a so-called dummy chip. Here, the dummy chip means a semiconductor chip having the same external form as a KGD and no inner circuit, or a semiconductor chip having the same external form as a KGD and inner circuits all of which are unused. In this case, only buried interconnections for electrical connection to another semiconductor chip or chips are formed in the dummy chip as necessary. This is because if a vacant position where no semiconductor chip exists is generated in one of the semiconductor circuit layers L1 to L4, some obstacle may occur in the execution of the step of stacking the semiconductor chips, or some problem on the mechanical strength may arise with respect to the semiconductor device fabricated. However, if such the problem can be avoided, the vacant position may be filled with any filling material other than the dummy chip.

### FIRST EMBODIMENT

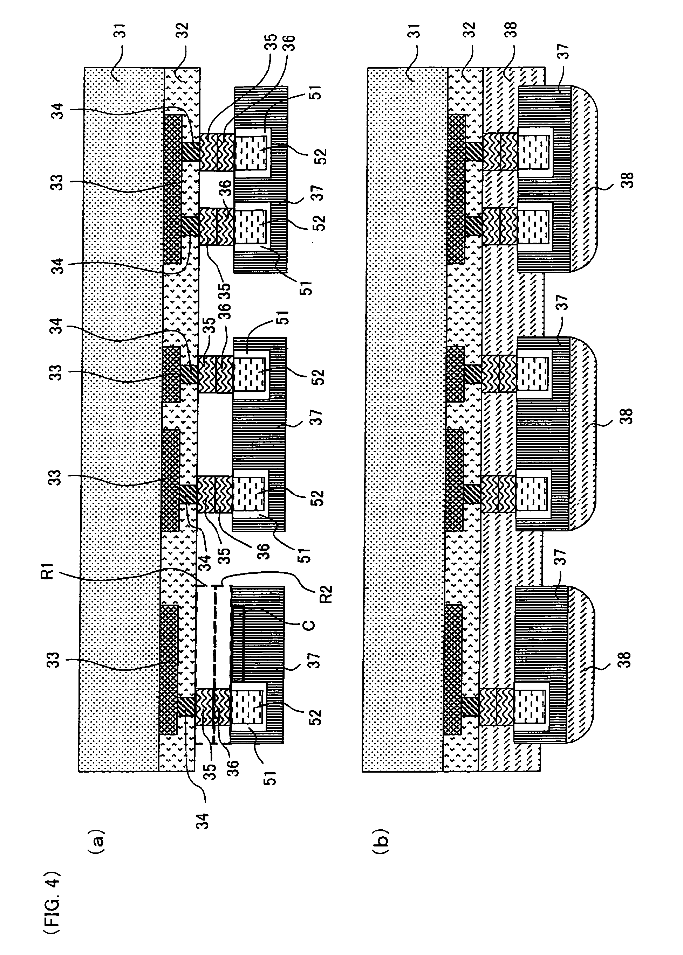

Next, a method of fabricating a semiconductor device having a three-dimensional stacked structure according to a first embodiment of the invention will be explained below with reference to Figs. 4 to 6. This method is based on the above-described basic concept of the invention, where the "connecting portion" used in Figs. 1 to 3 is realized by conductive contacts, i.e., microbump electrodes.

The conductive plugs, buried interconnections, and microbump electrodes shown in Figs. 4 to 6 are enlarged and exaggerated for easy understanding. Thus, the actual size of them is far smaller than that of the semiconductor chips.

First, as shown in Fig. 4(a), a support substrate 31 having a desired rigidity is prepared and then, a plurality of sets of wiring lines 33 are formed corresponding to respective semiconductor chips (chip-shaped semiconductor circuits) 37 to be fixed on the mounting surface (lower surface) of the substrate 31. An insulating layer 32 is formed on the mounting surface of the substrate 31 to cover all the wiring lines 33. Through holes that reach the respective sets of wiring lines 33 are formed at the predetermined positions of the insulating layer 32 by a known etching method. Thereafter, a conductive layer (not shown) is formed in such a way as to cover the insulating layer 32 and to fill the through holes and then, the conductive layer thus formed is polished by the CMP method until the insulating layer 32 is exposed. As a result, the conductive layer embedded in the through holes is selectively left to form conductive plugs 34. The conductive plugs 34 and the wiring lines 33 constitute the buried interconnections of the substrate 31. In this way, as shown in Fig. 4(a), the insulating layer 32, into which the sets of the buried interconnections comprising the wiring lines 33 and the conductive plugs 34 are embedded and the surface of which is planarized, is obtained.

As the substrate 31, for example, glass, single-crystal Si wafer (integrated circuits are formed or not formed in its surface area), or the like may be preferably used. However, a member made of any other material may be used if it has a desired rigidity. As the insulating layer 32, an insulating layer made of silicon dioxide (SiO₂) or the like may be used. As the wiring lines 33 and the conductive plugs 34, various conductive materials such as polysilicon, tungsten, copper, aluminum, or the like may be used.

Next, to realize the mechanical and electrical connection to the semiconductor chips 37 to be explained later, microbump electrodes 35 are formed on the planarized surface of the insulating layer 32. As the method of forming the electrodes 35, any known method may be used. For example, after a suitable conductive layer is formed on the surface of the insulating layer 32, the conductive layer is selectively removed by photolithography and etching, thereby leaving only the necessary parts of the conductive layer. As shown in Fig. 4(a), one end (an upper end in Fig. 4(a)) of each electrode 35 is contacted with a corresponding one of the conductive plugs 34 embedded in the insulating layer 32. Here, all the electrodes 35 have the same shape (for example, rectangular or circular) and the same size; however, it is needless to say that at least one of the shape and size of the electrodes 35 may be different from each other as necessary.

The microbump electrodes 35 formed on the surface of the insulating layer 32 are segmented into the plurality of sets, as shown in Fig. 4(a). Each set of the electrodes 35 constitutes a connecting portion R1 for a semiconductor chip 37 (which will be explained later). These chips 37 are used for forming a first semiconductor circuit layer L1.

On the other hand, the semiconductor chips 37 are prepared, each of which comprises microbump electrodes 36 formed to be exposed at predetermined positions on its surface (the upper face in Fig. 4(a)). The electrodes 36 are then contacted with the electrodes 35 on the support substrate 31 in a one-to-one correspondence. The whole stacked structure including the substrate 31 and the chips 37 is heated to a predetermined temperature while appropriately applying a pressing force toward the substrate 31 to the chips 37. After a predetermined time passes, the said structure is cooled to room temperature. Thus, the electrodes 36 on each chip 37 are bonded to the opposing electrodes 35 on the substrate 31. As s result, the mechanical and electrical connection between the chips 37 and the buried interconnections on the substrate 31 are simultaneously accomplished, where the chips 37 are fixed to the predetermined positions on the substrate 31. The state at this stage is shown in Fig. 4(a).

One set of the microbump electrodes 36 formed on each chip 37 constitutes a connecting portion R2 for the said chip 37. The connecting portion R2 corresponds to the connecting portion 12 on the chip 12 shown in Figs. 1 to 3.

The chips 37 may be fixed to the substrate 31 by canceling the electrodes 35 (i.e., the connecting portion R1) on the substrate 31 and directly contacting the electrodes 36 (i.e., the connecting portion R2) on the chips 37 with the surface of the insulating layer 32. In this case, heating and cooling is carried out in the same way as explained above, thereby bonding the electrodes 36 on the chips 37 to the corresponding plugs 34 embedded in the insulating layer 32 on the substrate 31. Thus, the mechanical and electrical connection between the chips 37 and the buried interconnections on the substrate 31 are accomplished simultaneously.

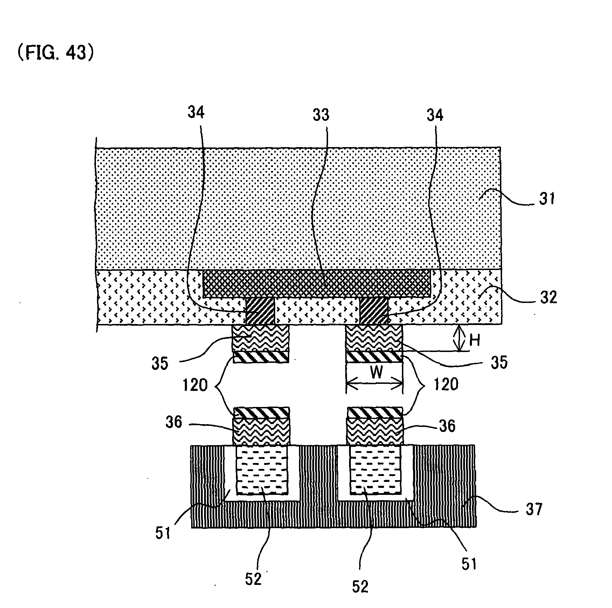

Here, the step of opposing and contacting the electrodes 36 on the chips 37 with the electrodes 35 on the substrate 31 in a one-to-one correspondence is explained in detail with reference to Figs. 43 to 46. Figs. 43 to 46 are partial cross-sectional views showing the step of bonding the electrodes 35 and 36 by way of intervening bonding metals.

First, as shown in Fig. 43, thin-film-shaped bonding metals 120 (preferably, the thickness is approximately 0.2 µm) are formed on the end face of each electrode 35 on the support substrate 31 and the end face of the opposing electrode 36 on the chip 37, respectively. The formation of the bonding metals 120 on the electrodes 36 may be carried out by any method. For example, the thin-film-shaped metals 120 may be selectively formed directly on the upper end faces of the electrodes 35 or 36 by a known plating method.

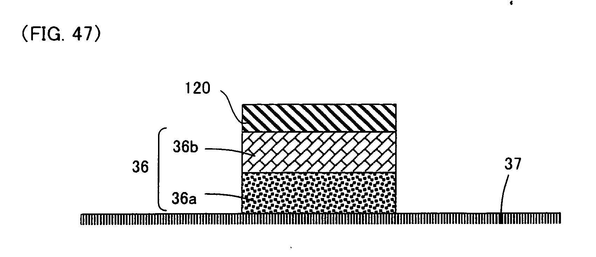

As the conductive material for the electrodes 35 and 36, for example, a two-layer structure of indium (In) and gold (Au), i.e., (In/Au), a two-layer structure of tin (Sn) and silver (Ag), i.e., (Sn/Ag), a single-layer structure of copper (Cu), or a single-layer structure of tungsten (W) may be preferably used. In the case of the two-layer structure of (In/Au), it is preferred that the In layer is placed as the lower layer 36a and the Au layer is placed as the upper layer 36b, as shown in Fig. 47. In the case of the two-layer structure of (Sn/Ag), it is preferred that the Sn layer is placed as the lower layer 36a and the Ag layer is placed as the upper layer 36b, as shown in Fig. 47. This is applicable to the electrode 35. In the case of the single-layer structure of Cu or W, it is usual that the whole electrode 35 or 36 is formed by Cu or W.

As the bonding metal 120, for example, In, Au, an indium-gold alloy (In-Au), or a gold-tin alloy (Au-Sn) is preferably used.

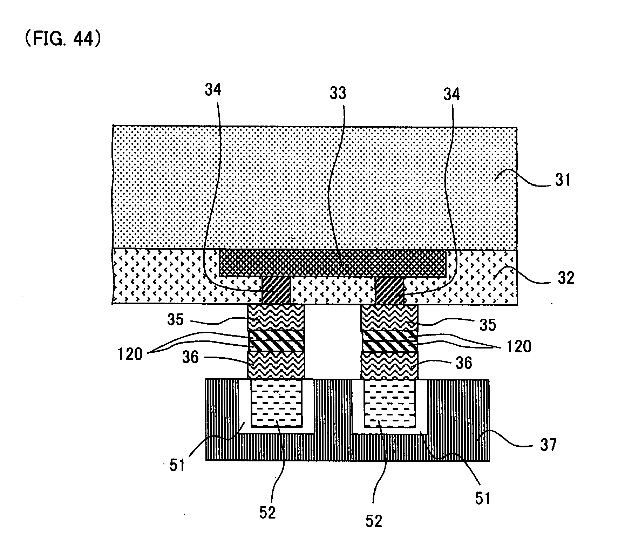

Subsequently, the chips 37 are lifted in such a way that the bonding metals 120 formed on the electrodes 36 are opposed to contact the bonding metals 120 formed on the electrodes 35 of the substrate 31. The state at this stage is shown in Fig. 44. Thereafter, while applying an upward pressing force to the chips 37, the whole stacked structure including the substrate 31 and the chips 37 is heated to a temperature (for example, 200 °C) where the metals 120 melt from room temperature. After a predetermined time passes, it is cooled to room temperature.

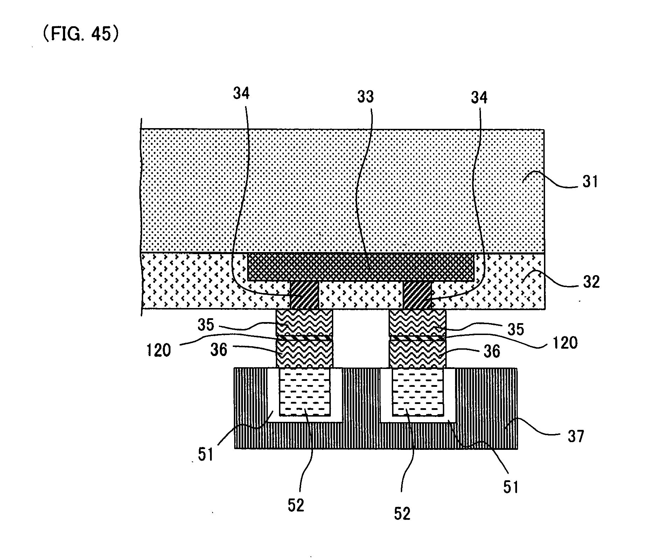

In this way, the bonding metals 120 are temporarily melted and then, re-solidified. Therefore, the electrodes 36 on each chip 37 are bonded to the opposing electrodes 35 on the substrate 31 with the metals 120. As a result, the mechanical and electrical connection between the chips 37 and the buried interconnections on the substrate 31 are accomplished simultaneously by the metals 120 thus re-solidified, as shown in Fig. 45.

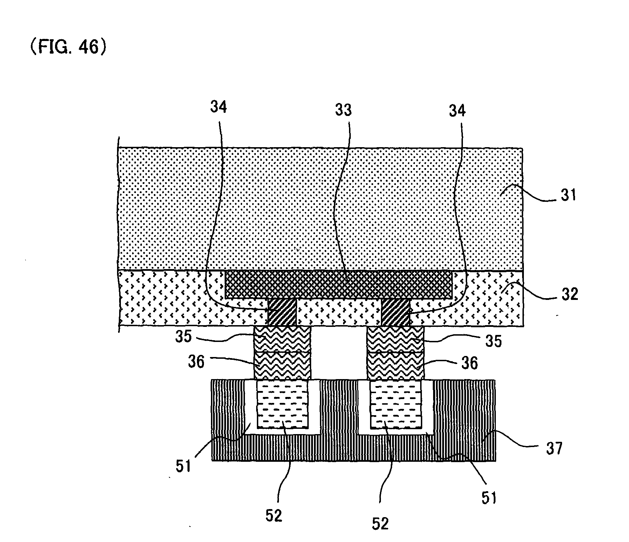

The re-solidified bonding metals 120 are expanded to the entirety of the electrodes 35 and 36 and thus, the resultant metals 120 are thinner than before melting (for example, to approximately 0.1 µm in thickness), as clearly shown in Fig. 45. Alternately, the metals 120 diffuse into the inside of the electrodes 35 and 36 to disappear and thus, the resultant electrodes 35 and 36 are directly contacted with each other, as shown in Fig. 46.

The electrodes 35 and 36 may be directly bonded to each other without placing the bonding metals 120 between the electrodes 35 and 36. In this case, the electrodes 35 and 36 are bonded to each other by strongly pressing the electrodes 36 to the corresponding electrode 35 at room temperature or under heat to thereby cause locally deformation in the electrodes 35 and 36. This means that the electrodes 35 and 36 are bonded to each other due to "pressure bonding". The bonded state is shown in Fig. 46. In addition, whether the pressure bonding is carried out at room temperature or under heat is selected in accordance with the conductive material used for the electrodes 35 and 36.

As shown in Fig. 43, the side or diameter W of the electrodes 35 and 36 are usually 50 µm or less, and a typical value is approximately 5 µm. The height H of the electrodes 35 and 36 are usually 20 µm or less, and a typical value is approximately 2 µm. Usually, the side or diameter of the conductive material 52 that forms the buried interconnections is approximately the same as that of the electrodes 35 and 36. However, the side or diameter of the conductive plugs 34 is usually less than that of the electrodes 35 and 36. On the other hand, the size of the chips 37 is usually in the range of several millimeters to twenty and several millimeters. The thickness of the chips 37 is usually in the range of 200 µm to 1000 µm. It is usual that several tens to several hundred thousand electrodes 36 are formed on the single chip 37.

Here, in order to make the fabrication easy, all the microbump electrodes 36 on the chips 37 are the same in shape (e.g., rectangular or circular) and size as the microbump electrodes 35 on the substrate 31. However, if bonding to the electrodes 35 is possible, it is needless to say that the shape and/or size of the electrodes 36 may be different from those of the electrodes 35 according to the necessity.

The semiconductor chips 37 comprising the electrodes 36 (or, the electrodes 36 and the bonding metals 120) may be sequentially fixed to the respective sets of the electrodes 35 on the substrate 31 one by one with a known high-speed chip bonder. Alternately, a necessary number of the chips 37 comprising the electrodes 36 (or, the electrodes 36 and the bonding metals 120) may be arranged on a supporting member (not shown) at a predetermined layout in advance and thereafter, all the chips 37 may be fixed to the substrate 31 in a lump using the said supporting member.

The bonding metals 120 are placed on both of the electrodes 35 and 36 here; however, they may be placed on either of the electrodes 35 and 36.

When the chips 37 are fixed to the substrate 31 with the electrodes 35 and 36 in the above-described way, the semiconductor integrated circuit (the semiconductor solid-state circuit) C formed in the surface area (the surface area at the side of the electrode 35) of each chip 37 in such a way as not to overlap with the electrodes 36 are electrically connected to the corresponding buried interconnections of the substrate 31 by way of the corresponding electrodes 35 and 36. This is because the electrodes 36 on each chip 37 are formed to function as external connection terminals for connecting the integrated circuit C in the said chip 37 to an external circuit.

In each of the chips 37 fixed in the above-described way, buried interconnections are formed in its inside in advance, where the buried interconnections are electrically connected to the electrodes 36 formed on the surface (the upper face in Fig. 4(a)) of the said chip 37. The buried interconnections (each of which is formed by a conductive material 52 surrounded by an insulating layer 51) are used to make electrical connection (i.e., inter-chip connection) between the integrated circuit C of the said chip 37 and the integrated circuit in a semiconductor chip 43 to be superposed on the said chip 37 in a later step. The buried interconnections are formed in the following way.

Specifically, first, a trench with a predetermined depth is formed on the surface of the chip 37 (on which the electrodes 36 are formed) by a known method. The depth of the trench needs to be larger than the resultant thickness (height) of the chip 37 that is to be left when the next semiconductor chip polishing step is completed. Next, the inner side faces and the inner bottom face of the trench are covered with the insulating layer (e.g., SiO₂ 51 by a known method. Thereafter, by a known method, the trench covered with the insulating layer 51 is filled with the conductive material 52 (e.g., polysilicon, tungsten, or copper) and the surface of the chip 37 is planarized. The electrode 36, which is located on the open end of the buried interconnection (i.e., the conductive material 52) thus formed, is electrically and mechanically connected to the open end face of the buried interconnection (i.e., the conductive material 52). In this way, the buried interconnection (i.e., the conductive material 52) can be exposed from the reverse (the lower surface in Fig. 4(a)) of the chip 37 when the next semiconductor chip polishing step is completed.

The methods of forming the buried interconnection (i.e., the conductive material 52) and the electrode 36 of the chip 37 are not limited to the methods explained here. Any other method may be used if the buried interconnection (i.e., the conductive material) 52 and the electrode 36 as shown in Fig. 4(a) can be obtained by it.

If the chip 37 is a so-called "dummy chip", i.e., a semiconductor chip having the same (or different) external form as a KGD and no inner circuit, or a semiconductor chip having the same (or different) external form as a KGD and inner circuits unused, the buried interconnection (the conductive material) 52 is used for electrically connecting the wiring lines 33 on the substrate 31 to the integrated circuit in a chip 43 to be superposed on the chip 37.

When the fixing operation of the chips 37 to the substrate 31 is finished, an adhesive filling step is carried out. In this step, as shown in Fig. 4(b), the gaps between the substrate 31 and the chips 37 and the gaps among the chips 37 are filled with a liquid or fluid adhesive 38 with electrical insulative property by a suitable method. Then, the adhesive 38 is cured by applying heat, irradiating ultraviolet rays, or the like. Since the height H of the electrodes 35 and 36 are usually 20 µm or less (typically, approximately 2 µm), the gaps between the substrate 31 and the chips 37 are usually 40 µm or less (typically, approximately 4 µm). The size of the gaps among the chips 37 is, for example, several micrometers to several hundred micrometers, which varies according to the layout of the wiring lines 33 on the substrate 31 and other semiconductor chips, or the like.

It is preferred that the adhesive 38 used in the adhesive filling step is an adhesive made of synthetic resin having an electrically insulative property and a curing property due to heat, ultraviolet rays, or the like. This is because the substrate 31 and the chips 37 need to be electrically insulated from each other and the adjoining chips 37 need to be electrically insulated from each other by the adhesive 38, and because the cured adhesive 38 forms part of the package of the said semiconductor device. At this stage, the thickness of the cured layer of the adhesive 38 formed on the insulating layer 32 of the substrate 31 needs not amount to the overall height of the chips 37. It is sufficient that the gaps (which include the bonding metals 120 and the microbump electrodes 35 and 36) are completely filled with the adhesive 38 when the chips 37 are thinned by polishing in the next semiconductor chip polishing step.

As the adhesive 38 applicable to the adhesive filling step, for example, epoxy resin, bismaleid resin, cyana resin, polyimide resin, BCB (benzocyclobutene), or the like may be used. In these adhesives, epoxy resin is particularly preferred for this purpose. This is because epoxy resin is inexpensive, easy to be handled, and high in chemical stability.

In this embodiment, as the adhesive filling method, a method that the substrate 31 is turned upside down in such a way that the insulating layer 32 faces upward and then, the liquid adhesive 38 is sprayed (i.e., a spraying method) is used. Thus, the adhesive 38 is placed not only in the gaps but also on the reverses of the chips 37, as shown in Fig. 4(b). Since the adhesive 38 placed on the reverses of the chips 37 are automatically removed in the subsequent semiconductor chip polishing process, no obstacle will occur.

The "spraying method" is a method that the substrate 31 is turned upside down in such a way that the insulating layer 32 faces upward and then, the liquid adhesive 38 is sprayed from the upper side with a known sprayer in the atmosphere or a suitable container. However, the invention is not limited to this method. The liquid adhesive 38 may be sprayed upward from the lower side without turning the substrate 31 upside down. The substrate 31 may be put into a sideways position and the adhesive 38 may be sprayed horizontally. The "spraying method" is one of the simplest ways and has an advantage that the adhesive filling step can be easily performed at low cost.

As a simple way to perform the adhesive filling step, a "coating method" that a liquid or fluid adhesive having an electrically insulation property is coated on desired positions may be used. This "coating method" is a method where a liquid or fluid adhesive having an electrically insulation property is placed on desired positions by coating. For example, the substrate 31 on which the chips 37 have been fixed is placed on a rotating plate structured to be rotatable in a horizontal plane and then, a liquid or fluid adhesive is placed on the said plate. Subsequently, the said plate is rotated, thereby expanding the adhesive to the whole surface of the substrate 31 due to centrifugal force. This is termed the "spin coating method". In this case, there is an advantage that the film of the adhesive coated on the whole surface of the substrate 31 has an approximately uniform thickness automatically.

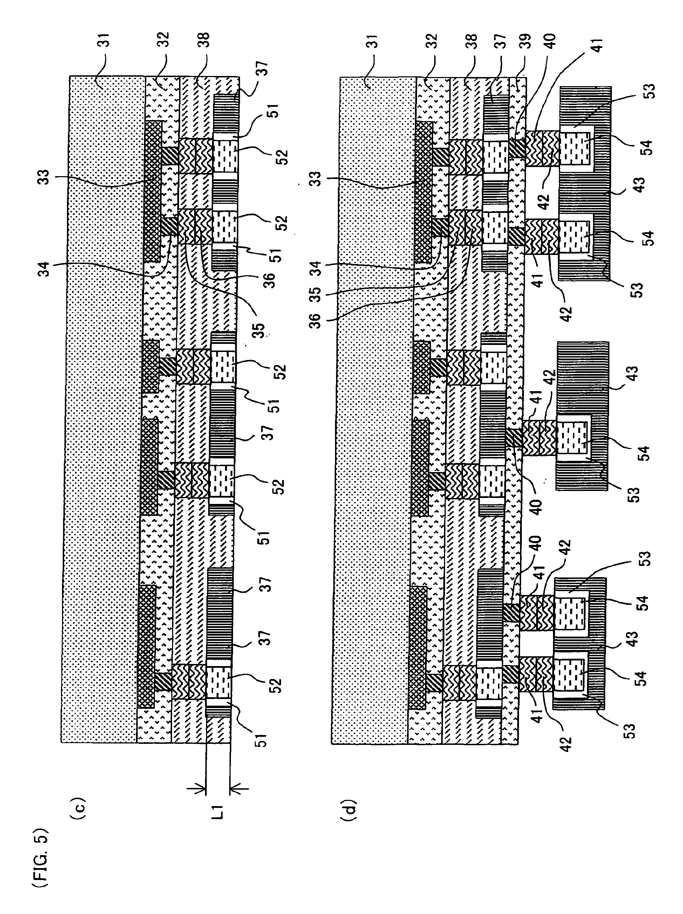

Next, the reverses (here, the lower surfaces) of all the chips 37 fixed in the above-described way are polished in a lump by the CMP method (the semiconductor chip polishing step). This step is carried out in such a way that the reverses of the respective chips 37 are located in the same plane as the cured layer of the adhesive 38 located therebetween, as shown in Fig. 5(c). In practice, preferably, the endpoint of the CMP process is set at the time when the cured layer of the adhesive 38 among the chips 38 is slightly polished, thereby planarizing the surface of the cured layer of the adhesive 38 simultaneously with the polishing of the reverses of the respective chips 37. Due to this CMP process, the conductive materials 52 are exposed from the reverses of the respective chips 37, resulting in the buried interconnections. In this state, the materials (buried interconnections) 52 penetrate through the chips 37 vertically (in a direction perpendicular to the substrate 31).

The resultant thickness of the chip 37 after the polishing by the CMP process is not limited; it may be set at any value according to the necessity. Since the initial thickness of the chip 37 is usually 200 µm to 1000 µm, the resultant thickness of the chip 37 after the CMP process is usually several micrometers to several hundred micrometers.

Even if the lower surface of each chip 37 is polished in the CMP process, no obstacle about the operation of the chip 37 will occur. This is because the integrated circuit C incorporated in the chip 37 is formed only in the surface area of the said chip 37 at an extremely small depth and therefore, the remaining part of the chip 37 is unconcerned about the circuit operation. Moreover, needless to say, the positions of the conductive materials (the buried interconnections) 52 in the chip 37 are determined in such a way as not to overlap with the integrated circuit C in the said chip 37. This is to prevent the formation of the buried interconnections 52 from affecting the operation of the circuit C.

Through the above-described steps, as shown in Fig. 5(c), a first semiconductor circuit layer L1, which is formed by the chips 37 and the cured adhesive 38 located among the chips 37 and on the peripheries thereof, is formed on the surface of the insulating layer 32 of the substrate 31. Each chip 37 is connected to the insulating layer 32 with the connecting portions R1 (which includes the electrodes 35) on the substrate 31 and the connecting portions R2 (which includes the electrodes 36) on the said chip 37 and at the same time, is adhered to the insulating layer 32 with the adhesive 38. Therefore, it may be said that the first semiconductor circuit layer L1 is fixed to the mounting surface with the connecting portions R1 and R2 and the adhesive 38. Since the mechanical connection of each chip 37 to the insulating layer 32 is performed by not only the connecting portions R1 and R2 but also the cured adhesive 38, sufficient connection strength is obtained.

Next, in approximately the same way as above, semiconductor chips 43 are superposed on the first semiconductor circuit layer L1 formed as described above, thereby forming a second semiconductor circuit layer L2.

Specifically, as shown in Fig. 5(d), an insulating layer 39 is formed to cover the surface of the cured layer of the adhesive 38 and the whole reverses of the chips 37 exposed therefrom. This insulating layer 39 is provided to electrically insulate the chips 37 of the first semiconductor circuit layer L1 from the chips 43 of the second semiconductor circuit layer L2. Next, through holes reaching the respective conductive materials (buried interconnections) 52 of the chips 37 are formed by a suitable etching method at predetermined positions of the insulating layer 39. These through holes are usually overlapped entirely or partially with the corresponding materials (buried interconnections) 52 of the chips 37. This is because the chips 37 of the layer L1 can be directly connected to the chips 43 of the layer L2 and because the process is the simplest. However, the invention is not limited to this. For example, by forming conductive materials (buried interconnections) on the lower surfaces of the chips 37 or additionally forming a wiring layer below the insulating layer 39, the said through holes may be formed in such a way as not to be overlapped with the conductive materials (buried interconnections) 52 of the chips 37. It is sufficient for the invention that the chips 37 of the layer L1 and the chips 43 of the layer L2 stacked thereon are electrically interconnected. The invention is not limited to the concrete interconnection methods disclosed in this specification.

Subsequently, a suitable conductive layer (not shown) is formed to cover the insulating layer 39, thereby filling the through holes with part of the conductive layer. Then, the conductive layer is polished by the CMP method until the surface of the insulating layer 39 is exposed, thereby selectively removing the exposed parts of the conductive layer from the insulating layer 39. In this way, the conductive layer is left in the through holes, resulting in conductive plugs 40.

Through the above-described steps, as shown in Fig. 5(d), the insulating layer 39 is obtained, where sets of the conductive plugs 40 are embedded and the surface of the layer 39 is planarized.

Next, sets of microbump electrodes 41 are formed on the planarized surface of the insulating layer 39. The method of forming the electrodes 41 is the same as that for the electrodes 35 formed on the surface of the insulating layer 32 of the substrate 31 and therefore, explanation about it is omitted. Each electrode 41 is located at a position where it contacts the corresponding conductive plug 40 embedded in the insulating layer 39, as shown in Fig. 5(d).

Next, in the same way as the chips 37, the semiconductor chips 43 are fixed to the first semiconductor circuit layer L1 with the electrodes 41, as shown in Fig. 5(d). Similar to the chips 37 that constitute the layer L1, each chip 43 has microbump electrodes 42 exposed on its surface and buried interconnections each formed by a conductive material 54 surrounded by an insulating layer 53 in its inside. Like the chips 37, the electrodes 42 of the chips 43 are respectively opposed to and contacted with the electrodes 41 using bonding metals or without bonding metals. Next, while applying a suitable pressing force toward the substrate 31 to the chips 43, the whole stacked structure including the substrate 31 and the layer L1 is heated and then, cooled to room temperature after a predetermined time has passed. Thus, the electrodes 42 on each chip 43 are bonded to the opposing electrodes 41. As a result, the mechanical and electrical connection between the chips 43 and 37 is simultaneously accomplished. The state at this stage is shown in Fig. 5(d).

Similar to the chips 37, the chips 43 also may be fixed in a one-to-one correspondence, for example, with a known high-speed chip bonder. Alternately, all the chips 43 may be located at the predetermined positions on a supporting member (not shown) in advance and then, all the chips 43 may be fixed in a lump with the supporting member.

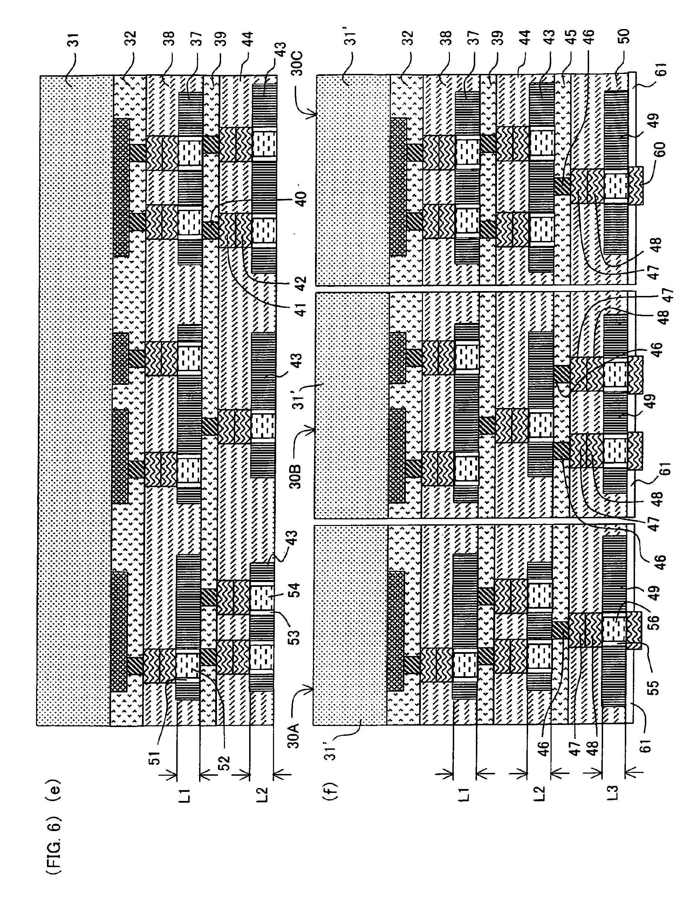

When the fixing operation of the chips 43 is completed in the above-described way, then, the adhesive filling step is carried out using the same filling method as explained above on the adhesive 38. Specifically, as shown in Fig. 6(e), the gaps among the chips 43 fixed to the insulating layer 39 (i.e., the first semiconductor circuit layer L1) with the electrodes 41 and 42 are filled with a liquid or fluid adhesive 44 with electrical insulation property by the above-described "spraying method" (or the above-described "coating method"). Thereafter, the adhesive 44 is cured by applying heat, irradiating ultraviolet rays, or the like. The adhesive 44 is the same as the adhesive 38 embedded in the gaps among the chips 37. At this stage, the thickness of the layer of the adhesive 44 formed on the insulating layer 39 needs not amount to the overall height of the chips 43. It is sufficient that the gaps are completely filled with the adhesive 44 when the chips 43 are thinned by polishing in the next semiconductor chip polishing step.

Next, the reverses (here, the lower surfaces) of all the chips 43 fixed in the above-described way are polished in a lump by the CMP method (the semiconductor-chip polishing step). This step is carried out under the same condition as the chips 37 in such a way that the reverses of the respective chips 43 are located in the same plane as the cured layer of the adhesive 44 located therebetween, as shown in Fig. 6(e). Due to this CMP process, the conductive materials 54 for the buried interconnections are exposed from the reverses of the respective chips 43, resulting in the conductive plugs. In this state, the buried interconnections (conductive materials) 54 penetrate through the chips 43 vertically.

Through the above-described steps, as shown in Fig. 6(e), the second semiconductor circuit layer L2 including the adhesive 44 and the chips 43 surrounded by the same is formed on the surface of the insulating layer 39.

Subsequently, in approximately the same way as above, semiconductor chips 49 are superposed on the second semiconductor circuit layer L2 thus formed, thereby forming a third semiconductor circuit layer L3.

Specifically, as shown in Fig. 6(f), an insulating layer 45 is formed to cover the surface of the cured layer of the adhesive 44 and the whole reverses of the chips 43 exposed therefrom. The insulating layer 45 is provided to electrically insulate the chips 43 of the second semiconductor circuit layer L2 from the chips 49 of the third semiconductor circuit layer L3. Next, conductive plugs 46 are formed on predetermined positions on the insulating layer 45 by the same method as used for the conductive plugs 40.

Thus, as shown in Fig. 6(f), the insulating layer 45 is obtained, where the conductive plugs 46 are embedded therein and the surface of the layer 45 is planarized.

Next, microbump electrodes 47 are formed on the planarized surface of the insulating layer 45 by the same method as used for the microbump electrodes 35. Each electrode 47 is located at a position where the electrode 47 contacts the corresponding conductive plug 46 embedded in the insulating layer 45, as shown in Fig. 6(f).

Next, in the same way as the chips 43, the semiconductor chips 49 are fixed to the second semiconductor circuit layer L2 with the electrodes 47, as shown in Fig. 6(f). Similar to the chips 43 forming the layer L2, each chip 49 has microbump electrodes 48 exposed on its surface and buried interconnections each formed by a conductive material 56 surrounded by an insulating layer 55 in its inside. Similar to the chips 37, the electrodes 48 of the chips 49 are respectively opposed to and contacted with the electrodes 47 using bonding metals or without bonding metals. Next, while applying a suitable pressing force toward the substrate 31 to the chips 49, the whole stacked structure including the substrate 31 and the first and second semiconductor circuit layers L1 and L2 is heated and then, cooled to room temperature after a predetermined time has passed. Thus, the electrodes 48 on the respective chip 49 are bonded to the opposing electrodes 47. As a result, the mechanical and electrical connection between the chips 49 and the chips 43 is simultaneously performed. The state at this stage is shown in Fig. 6(f).

The chips 49 may be fixed in a one-to-one correspondence, for example, with a known high-speed chip bonder, like the chips 37 and 43. Alternately, all the chips 49 may be located at the predetermined positions on a supporting member (not shown) in advance and then, all the chips 49 may be fixed in a lump with the supporting member.

When the fixing operation of the chips 49 is completed, then, the adhesive filling step is carried out using the same filling method as explained about the adhesives 38 and 44. Specifically, as shown in Fig. 6(f), the gaps among the chips 49 fixed to the insulating layer 45 (i.e., the second semiconductor circuit layer L2) with the electrodes 47 and 48 are filled with a liquid or fluid adhesive 50 with electrical insulation property by the above-described "spraying method" (or the above-described "coating method"). Thereafter, the adhesive 50 is cured by applying heat, irradiating ultraviolet rays, or the like. The adhesive 50 is the same as the adhesive 38 buried in the gaps among the chips 37. At this stage, it is not necessary that the thickness of the layer of the adhesive 50 formed on the insulating layer 45 amounts to the overall height of the chips 49. It is sufficient that the gaps are completely filled with the adhesive 50 when the chips 49 are thinned by polishing in the next semiconductor chip polishing step.

Next, the reverses (here, the lower surfaces) of all the chips 49 fixed in the above-described way are polished in a lump by the CMP method (the semiconductor-chip polishing step). This step is carried out under the same condition as the chips 37 in such a way that the reverses of the respective chips 49 are located in the same plane as the cured layer of the adhesive 50 located therebetween, as shown in Fig. 6(f). Due to this CMP process, the buried interconnections (conductive materials) 56 are exposed from the reverses of the respective chips 49. In this state, the buried interconnections (conductive materials) 56 penetrate through the chips 49 vertically.

Through the above-described steps, as shown in Fig. 6(f), the third semiconductor circuit layer L3 including the adhesive 50 and the chips 49 surrounded by the same is formed on the surface of the insulating layer 45.

Subsequently, by a known method, an insulating layer 61 is formed to cover the surface of the cured layer of the adhesive 50 and the whole reverses of the chips 49 exposed therefrom. Next, through holes are formed at the predetermined positions of the insulating layer 61 by etching and then, a conductive material is deposited on the layer 61 to fill the said through holes. The conductive material thus deposited is selectively removed by etching, thereby forming microbump electrodes 60 contacted with the respective conductive materials 56 in the chips 49 through the insulating layer 61. These microbump electrodes 60, which are protruded from the insulating layer 61, are used for electrical connection to an external circuit or device. In other words, the electrodes 60 are terminals for external circuit connection and realize the same function as that of the above-described electrodes 26 or solder balls 27.

Through the above-described steps, a stacked structure formed by sequentially stacking the first to third semiconductor circuit layers L1 to L3 on the mounting surface of the support substrate 31 and fixing them together, as shown in Fig. 6(f). This structure comprises a plurality of sets of chip stacks, each of which includes three chips (chip-shaped semiconductor circuits) 37, 43, and 49 and three insulating layers 32, 39 and 45. The bottom and top of the stacked structure are covered with the substrate 31 and the insulating layer 61, respectively. The sidewalls of the stacked structure are formed by the cured adhesives 38, 44, and 50. The chips 37, 43, and 49 in these chip stacks are apart from each other in a direction parallel to the substrate 31. The surroundings of the chip stacks are filled with the adhesives 38, 44, and 50. The chips 37, 43, and 49 are apart from each other in a direction perpendicular to the substrate 31 and the gaps between the chips 37, 43, and 49 are filled with the adhesives 38, 44, and 50. In each chip stack, the wiring lines 33 on the substrate 31 and the stacked chips 37, 43, and 49 are electrically interconnected with each other by way of the conductive plugs 34, 40, 46 embedded in the insulating layers 32, 39, and 45, the buried interconnections (conductive materials) 52, 54, and 56 penetrating through the chips 37, 43, and 49, and the microbump electrodes 35, 36, 41, 42, 47, and 48.

Following this, the stacked structure of the first to third semiconductor circuit layers L1 to L3 is subject to a known dicing process, thereby dividing it into desired semiconductor devices. This dicing process is carried out in such a way that the dicing blade passes through between the adjoining chip stacks. Thus, semiconductor devices 30A, 30B, and 30C as shown in Fig. 6(f) are obtained. Each of the devices 30A, 30B, and 30C comprises a three-dimensional stacked structure where a set of the three semiconductor chips 37, 43, and 49 having different sizes and/or different functions are stacked on the divided support substrate 31'.

Fig. 48(b) is an explanatory drawing showing the layout of the microbump electrodes 60 of the semiconductor device 30B. As seen from this figure, the electrodes 60 for external circuit connection are regularly arranged on the surface of the stacked structure of the semiconductor circuit layers L1 to L3 opposite to the substrate 31. This is applicable to the semiconductor devices 30A and 30C.

The dicing process is not limited to the above-described example. Similar to the semiconductor device 10D shown in Fig. 3(j), the dicing may be performed to include two sets of the chip stacks or to include three or more sets of the chip stacks. The entire stacked structure prior to dicing may be used as a wafer-level semiconductor device without the dicing process.

As explained above, with the method of fabricating the semiconductor device having a three-dimensional stacked structure according to the first embodiment of the invention, first, the semiconductor chips (i.e., the first semiconductor circuits) 37 are mechanically connected to one surface of the support substrate 31 at the predetermined positions by way of the microbump electrodes 35 and 36 (i.e., the first connecting portions). Next, the gaps formed between the substrate 31 and the chips (the first semiconductor circuits) 37 mechanically connected thereto are filled with the electrically insulative adhesive 38 (i.e., the first electrically insulative adhesive) and then, the adhesive 38 is cured. Thereafter, the thicknesses of the chips (the first semiconductor circuits) 37 are adjusted to have the desired values by polishing the opposite surfaces of the chips (the first semiconductor circuits) 37 to the substrate 31, thereby forming the first semiconductor circuit layer (i.e., the first circuit layer) L1.

Following this, the semiconductor chips (i.e., the second semiconductor circuits) 43 are mechanically and electrically connected to the surface of the first semiconductor circuit layer (i.e., the first circuit layer) L1 at the predetermined positions by way of the microbump electrodes 41 and 42 (i.e., the second connecting portions). Then, the gaps formed between the first semiconductor circuit layer (i.e., the first circuit layer) L1 and the chips (the second semiconductor circuits) 43 mechanically and electrically connected thereto are filled with the electrically insulative adhesive 44 (i.e., the second electrically insulative adhesive) and then, the adhesive 44 is cured. Thereafter, the thicknesses of the chips (the second semiconductor circuits) 43 are adjusted to have the desired values by polishing the opposite surfaces of the chips (the second semiconductor circuits) 43 to the substrate 31, thereby forming the second semiconductor circuit layer (i.e., the second circuit layer) L2.

Subsequently, by repeating the steps of forming the second semiconductor circuit layer (i.e., the second circuit layer) L2, the third semiconductor circuit layer (i.e., the third circuit layer) L3 is formed. In this way, the stacked structure comprising the first to third semiconductor circuit layers (the first to third circuit layers) L1 to L3 stacked in sequence from the bottom of the said structure to the top thereof in the predetermined stacking direction, and unified with the electrically insulative adhesives 38, 44, and 50 is obtained.

Therefore, by preparing the semiconductor chips (the semiconductor circuits) 37, 43, and 49 having different functions and placing them in the first to third semiconductor circuit layers (the first to third circuit layers) L1 to L3 according to the necessity, a desired systemized function can be realized through the combination of the chips (the semiconductor circuits) 37, 43, and 49. In this case, the electrical interconnection (wiring) among the internal circuits, i.e., among the first to third semiconductor circuit layers (the first to third circuit layers) L1 to L3, is preformed in the stacked structure with the microbump electrodes 35, 36, 41, 42, 47, and 48. Regarding the package, the substrate 31 and the electrically insulative adhesives 38, 44, and 50 used to form the stacked structure can constitute the package. Accordingly, the difficulty in the electrical interconnection (wiring) between the internal circuits and in the packaging can be eliminated or suppressed.

Moreover, the stacked structure is formed by stacking the first to third semiconductor circuit layers (the first to third circuit layers) L1 to L3 each including at least one semiconductor circuit. Thus, the first to third semiconductor circuit layers (the first to third circuit layers) L1 to L3 can be formed by placing the chips (the semiconductor circuits) 37, 43, and 49 to be apart from each other in a direction parallel to the substrate 31 (i.e., in a direction perpendicular to the stacking direction of the semiconductor circuit layers L1 to L3) and filling the gaps in the surroundings of the chips (the semiconductor circuits) 37, 43, and 49 with the electrically insulative adhesives 38, 44, and 50. Even if the chips (the semiconductor circuits) 37, 43, and 49 to be placed in the first to third semiconductor circuit layers (the first to third circuit layers) L1 to L3 are different in thickness, their thicknesses are adjusted by polishing the reverses (the surfaces including no integrated circuit) of the chips 37, 43, and 49 in the stacking processes and therefore, the thickness difference of the chips 37, 43, and 49 can be eliminated. As a result, even if the chips (the semiconductor circuits) 37, 43, and 49 to be combined are different in size, shape, and/or thickness, they can be combined together on the substrate 31.

Furthermore, the stacked structure is formed by stacking the first to third semiconductor circuit layers L1 to L3 in the predetermined stacking direction, where each of the layers L1 to L3 comprises the chips (the semiconductor circuits) 37, 43, and 49. Therefore, diversified functions can be realized according to the necessity by suitably combining the types (functions) of the chips 37, 43, and 49 to be placed in the layers L1 to L3.

In addition, with the fabrication method according to the invention, the semiconductor devices 30A, 30B, and 30C according to the first embodiment of the invention are obtained. Each of the devices 30A, 30B, and 30C comprises the substrate 31' obtained by dividing the substrate 31, and the chips 37, 43, and 49 having different functions combined on the substrate 31' according to the necessity. The opposite surface of the three-dimensional stacked structure to the substrate 31' is covered with the insulating layer 61, and the microbump electrodes 60 for external circuit connection are arranged on the layer 60. The side faces of the said stacked structure are covered with the covering material formed by the adhesives 38, 44, and 50 made of insulative synthetic resin.

With the semiconductor devices 30A, 30B, and 30C, the first to third semiconductor circuit layers L1 to L3 are such that the physical size of the chips (semiconductor circuits) 37, 43, or 49 included in a corresponding one of the layers L1 to L3 in a plane parallel to the substrate 31 (i.e., in a plane perpendicular to the stacking direction of the layers L1 to L3) is smaller than the physical size of the said layer L1, L2, or L3 in the said plane. The side faces of the said chips (semiconductor circuits) 37, 43, or 49 are covered with the adhesive 38, 44, or 50. Therefore, the semiconductor devices 30A, 30B, and 30C are evidently different from the known prior-art semiconductor device having a structure that a plurality of semiconductor chips are stacked and adhered on a support substrate, the said semiconductor chips are electrically connected to each other with wires, and the whole is covered with a synthetic resin package. Furthermore, the semiconductor devices 30A, 30B, and 30C are different from the above-described prior-art semiconductor devices as explained in BACKGROUND ART each of which is fabricated by stacking a plurality of semiconductor wafers having different integrated circuits therein and fixing them together to form a wafer stack and thereafter, dicing the wafer stack, also.

The electrical interconnection between the wiring lines 33 on the substrate 31 and the first to third semiconductor circuit layers L1 to L3 is realized by the conductive plugs 34, 40, and 46, the buried interconnections (conductive materials) 52, 54, and 56 in the chips 37, 43, and 49, and the microbump electrodes 35, 36, 41, 42, 47, and 48. The substrate 31', the covering material (i.e., the adhesives 38, 44, and 50), and the insulating layer 61 serve as the package accommodating and protecting the semiconductor circuit layers L1 to L3. Electrical connection to external circuit or device can be made with the electrodes 60 arranged on the opposite surface to the substrate 31'. Accordingly, each of the semiconductor devices 30A, 30B, and 30C has a structure that the first to third semiconductor circuit layers L1 to L3 are unified with the package, in other words, a package-integrated three-dimensional stacked structure. Accordingly, with the semiconductor devices 30A, 30B, and 30C according to the first embodiment of the invention, not only similar systemization to conventional system LSIs can be easily realized while eliminating or suppressing the difficulty in the electrical interconnection (wiring) between the internal circuits and in the packaging but also diversified functions can be realized according to the necessity.

Although KGDs are used for the semiconductor chips in the above explanation, it is unnecessary for the invention that all the semiconductor chips are KGDs. With the semiconductor chip judged as a KGD, it is unnecessary that all the circuits in this chip are used (or operated). An unused (or non-operable) circuit or circuits (e.g., a redundant section) may be included therein. This is applied to the other embodiments explained below.

If the semiconductor chip providing a specific circuit function in one of the first to third semiconductor circuit layers L1 to L3 is unnecessary, it is preferred that the position of the said chip is filled with a so-called dummy chip (i.e., a semiconductor chip having the same external form as a KGD and no inner circuit, or a semiconductor chip having the same external form as a KGD and inner circuits all of which are unused). In this case, only buried interconnections for electrical connection to another semiconductor chip or chips are formed in the dummy chip. This is because if the semiconductor chip is not placed only in the position where the semiconductor chip providing a specific function is unnecessary, some obstacle may occur in the execution of the step of stacking the semiconductor chips, or some problem on the mechanical strength may arise with respect to the semiconductor device fabricated. However, if such the problem can be avoided, a member other than the dummy chip may be placed therein. This is applied to the other embodiments explained below.

With the above-described first embodiment, the wiring lines 33 embedded in the insulating layer 32 are formed on the surface of the substrate 31; however, the wiring lines 33 are not always necessary. If the wiring lines or circuits on the substrate 31 are unnecessary (in other words, the substrate 31 is used as a base of the stacked structure alone), the microbump electrodes 35 may be directly formed on the mounting surface of the substrate 31, and opposed and bonded to the microbump electrodes 36 on the semiconductor chips 37. Alternately, the electrodes 36 on the chips 37 may be directly bonded to the mounting surface of the substrate 31, where the electrodes 35 are cancelled. The chips 37 may be bonded to the mounting surface of the substrate 31 with the electrodes 35 on the substrate 31, where the electrodes 36 are cancelled.

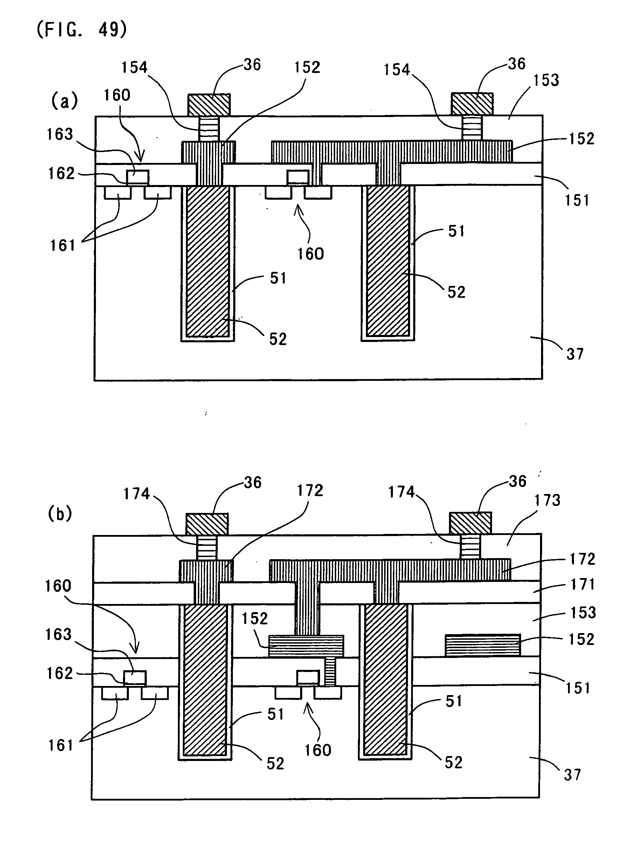

By the way, the structure of the semiconductor chips 37 is simplified in Figs. 4 to 6 for the sake of easy understanding of the stacking steps and therefore, the relationship with the actual structure of the chips 37 may be difficult to understand. So, this point is explained below with reference to Fig. 49. Fig. 49 is a schematic cross-sectional view showing the detailed structure of the chip 37 used in the above-described semiconductor device according to the first embodiment.

The chip 37 has an actual structure shown in Fig. 49, for example. Specifically, in the structure of Fig. 49(a), Metal-Oxide-Semiconductor Field-Effect Transistors (MOSFET) 160 are formed in the surface area of the chip 37. For simplification, only two transistors 160 are shown. Each transistor 160 comprises a pair of source/drain regions 161 formed in the chip 37, a gate insulating layer 162 formed on the surface of the chip 37, and a gate electrode 163 formed on the gate insulating layer 162.

An insulating layer 151 is formed on the surface of the chip 37, which covers the transistor 160 and the exposed part of the said surface. A wiring layer 152 is formed on the insulating layer 151. In Fig. 49(a), the state where the wiring layer 152 is electrically connected to a conductive material (a buried interconnection) 52 in the chip 37 and one of the source/drain regions 161 of one of the transistors 160 is shown. An insulating layer 153 is formed on the insulating layer 151 to cover the whole wiring layer 152. The microbump electrodes 36, which are formed on the flat surface of the insulating layer 153, are electrically connected to the wiring layer 152 by way of the conductive plugs 154.

In the structure of Fig. 49(a), the electrode 36 at the left side is located just over the corresponding conductive material (the buried interconnection) 52 in the chip 37. However, the electrode 36 at the right side in Fig. 49(a) is not located just over the corresponding conductive material (the buried interconnection) 52, which is slightly shifted to the right side horizontally. In Figs 4 to 6, all the electrodes 36 are located just over the corresponding conductive materials (the buried interconnections) 52; however, the invention is not limited to this. As shown in Fig. 49(a), it is sufficient that each electrode 36 is electrically connected to a corresponding one of the conductive materials (the buried interconnections) 52. It is unnecessary that each electrode 36 is located just over the corresponding conductive material (the buried interconnection) 52. The position of each electrode 36 may be shifted horizontally (i.e., in a direction parallel to the surface of the chip 37) according to the necessity.

In the structure of Fig. 49(a), the transistors 160 and the wiring layer 152 (a single-layer wiring structure) constitute the semiconductor integrated circuit (the semiconductor solid-state circuits) C.

In the structure of Fig. 49(b), similar to the structure of Fig. 49(a), MOSFETs 160 are formed in the surface area of the chip 37. An insulating layer 151 is formed on the surface of the chip 37, which covers the transistor 160 and the exposed part of the said surface. A wiring layer 152 is formed on the insulating layer 151. In Fig. 49(b), the state where the wiring layer 152 is electrically connected one of the source/drain regions 161 of one of the transistors 160 is shown. Unlike the case of Fig. 49(a), the wiring layer 152 is not directly connected to the conductive material (the buried interconnection) 52 in the chip 37. An insulating layer 153 is formed on the insulating layer 151 to cover the whole wiring layer 152.

In this structure, unlike the case of Fig. 49(a), the conductive material (the buried interconnection) 52 in the chip 37 penetrates through the insulating layers 153 and 151 located over the chip 37 and is exposed from the surface of the insulating layer 153. An insulating layer 171 is formed on the insulating layer 153. A wiring layer 172 is formed on the insulating layer 171. The wiring layer 172 is electrically connected to the wiring layer 152 and the conductive material (the buried interconnection) 52. An insulating layer 173 is formed on the insulating layer 171 to cover the whole wiring layer 172. The microbump electrodes 36, which are formed on the surface of the insulating layer 173, are electrically connected to the wiring layer 172 by way of the conductive plugs 174.

In the structure of Fig. 49(b) also, the electrode 36 at the left side is located just over the corresponding conductive material (the buried interconnection) 52 in the chip 37. However, the electrode 36 at the right side in Fig. 49(b) is not located just over the corresponding conductive material (the buried interconnection) 52, which is slightly shifted to the right side horizontally. In Figs 4 to 6, all the electrodes 36 are located just over the corresponding conductive materials (the buried interconnections) 52; however, the invention is not limited to this. As shown in Fig. 49(b), it is unnecessary that each electrode 36 is located just over the corresponding conductive material (the buried interconnection) 52. The position of each electrode 36 may be shifted horizontally (i.e., in a direction parallel to the surface of the chip 37) according to the necessity.

In the structure of Fig. 49(b), the transistors 160 and the two wiring layers 152 and 172 (a two-layer wiring structure) constitute the semiconductor integrated circuit (the semiconductor solid-state circuits) C formed in the chip 37.

Needless to say, the structures of Fig. 49(a) and Fig. 49(b) may be applied to the other embodiments and their variations explained below.

### SECOND EMBODIMENT

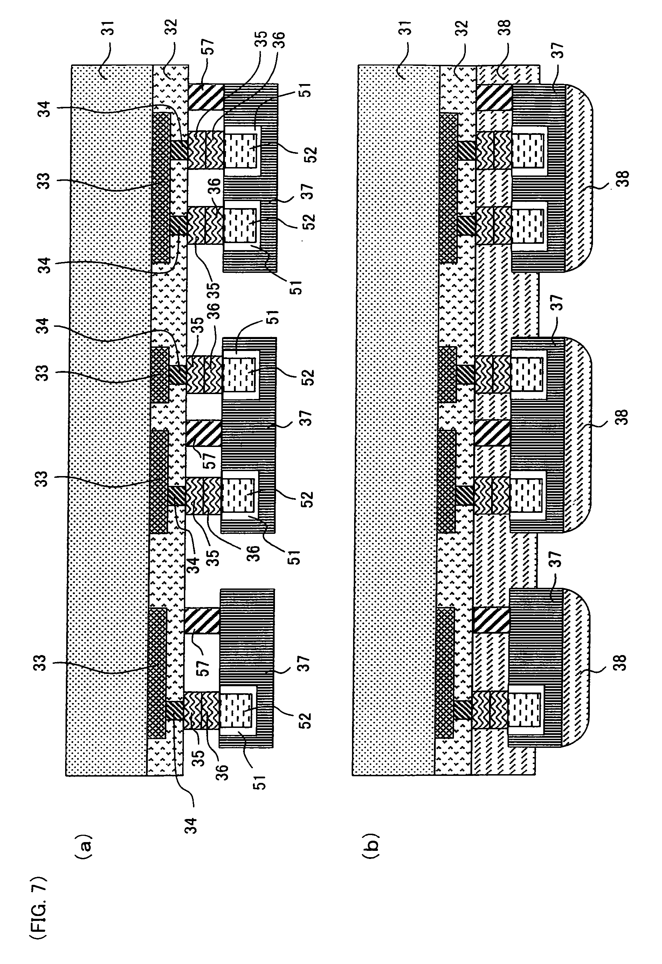

Figs. 7 to 9 are cross-sectional views showing the process steps of a method of fabricating a semiconductor device having a three-dimensional stacked structure according to a second embodiment of the invention.

Although each "connecting portion " is realized by microbump electrodes in the above-described first embodiment, "stoppers" are used in addition to the microbump electrodes in the second embodiment. This is to facilitate the positioning in a direction perpendicular to the support substrate (i.e., the stacking direction of the semiconductor circuit layers). Since the fabrication method of the second embodiment is the same as that of the first embodiment except for the use of stoppers, explanation about the same elements as those in the first embodiment is omitted here by attaching the same reference numerals to the same elements as the first embodiment in Figs. 7 to 9.

First, as shown in Fig. 7(a), in the same way as the first embodiment, an insulating layer 32 is formed on a mounting surface (a lower surface) of a support substrate 31 having a desired rigidity. A plurality of sets of buried interconnections comprising wiring lines 33 and conductive plugs 34 are embedded in the insulating layer 32. The surface of the layer 32 is planarized. On the surface of the layer 32, microbump electrodes 35 are formed.

Unlike the first embodiment, on the planarized surface of the insulating layer 32, rigid members or stoppers 57 for facilitating the positioning of semiconductor chips 37 in the direction along their height (i.e., in the direction perpendicular to the substrate 31) in the bonding step of the chips 37 are formed to protrude from the said surface.
These stoppers 57, all of which are the same in shape (e.g., rectangular or circular) and size, are positioned in such a way as to be superposed on the corresponding chips 37. However, the invention is not limited to this structure. It goes without saying that the shape and/or size of the respective stoppers 57 may be different dependent on their positions. Usually, it is sufficient that one stopper 57 is formed for one chip 37. However, two or more stoppers 57 may be formed for one chip 37.

The stoppers 57 are formed in the same way as the microbump electrodes 35. However, unlike the electrodes 35, the stoppers 57 need to be made of an insulative material such as SiO₂. This is because the stoppers 57 are directly contacted with the corresponding chips 37 when the chips 37 are fixed in this embodiment. For example, a suitable insulating layer is formed or deposited on the surface of the insulating layer 32 and then, the said insulating layer is selectively removed by photolithography and etching, leaving its required parts. Thus, the stoppers 57 can be easily formed. The formation of the stoppers 57 may be performed before or after the formation of the electrodes 35. If the stoppers 57 are not directly contacted with the corresponding chips 37 in the fixing step of the chips 37, the stoppers 57 may be made of a conductive material such as a metal.

The height of each stopper 57 from the surface of the insulating layer 32 is equal to the sum of the height of the electrode 35, the height of the electrode 36 on the chip 37, and the post melting and re-solidifying thickness of the bonding metal 120 intervening between the electrodes 35 and 36. In other words, the height of each stopper 57 is set in the following way. Namely, when the electrode 36 is pressed against the corresponding electrode 35 along with an intervening bonding metal 120, the lower end of the stopper 57 does not contact the chip 37. However, when the metal 120 is melted by heating, the lower end of the stopper 57 contacts the surface of the chip 37 and as a result, the positioning of the chip 37 along its height is automatically carried out.

When the bonding metal 120 is not used, the height of each stopper 57 from the surface of the insulating layer 32 is set to be slightly smaller than the sum of the height of the electrode 35 and the height of the electrode 36 on the chip 37. When the electrode 36 is pressed against the corresponding electrode 35, the lower end of the stopper 57 does not contact the chip 37. However, when the electrodes 35 and 36 are joined under heat by the pressure bonding, the heights of the electrodes 35 and 36 decrease slightly and the lower end of the stopper 57 contacts the surface of the chip 37. As a result, the positioning of the chip 37 along its height is automatically carried out.

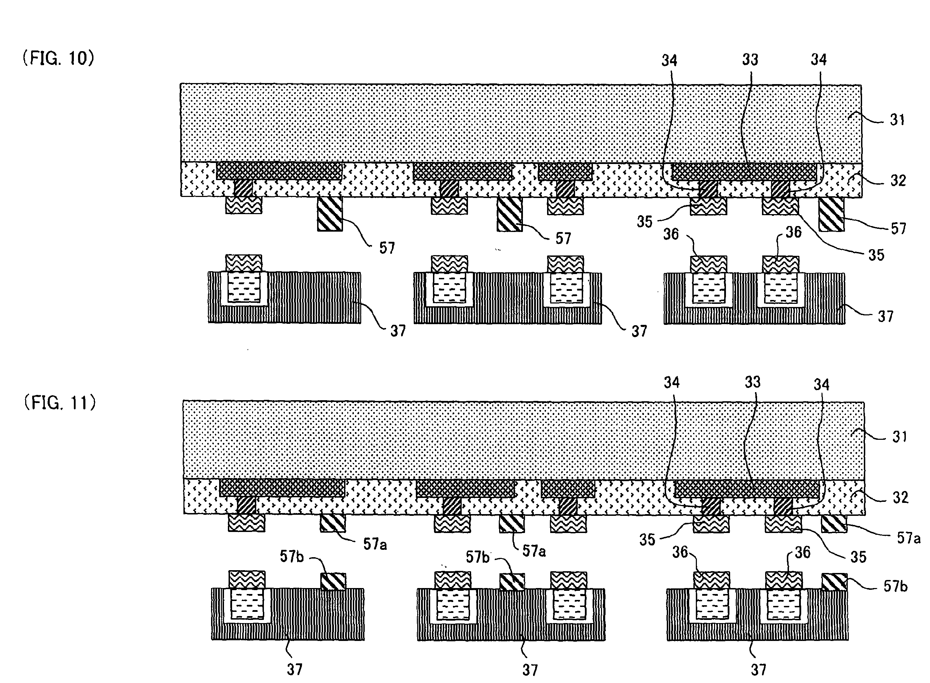

The state where the stoppers 57 are formed on the surface of the insulating layer 32 on the substrate 31 is shown in Fig. 10.

On the other hand, the semiconductor chips 37 are prepared. Each of the chips 37 comprises microbump electrodes 36 formed to be exposed on its surface and the buried interconnections in its inside. Next, as shown in Fig. 7(a), the electrodes 36 are opposed to and contacted with the corresponding electrodes 35 on the substrate 31 along with the thin bonding metals 120 or without the metals 120. Then, in the same way as the first embodiment, the whole stacked structure including the substrate 31 and the chips 37 is heated to a predetermined temperature while appropriately applying a pressing force toward the substrate 31 to the chips 37. After a predetermined time has passed, the said structure is cooled to room temperature. Thus, the electrodes 36 on each chip 37 are bonded to the opposing electrodes 35 on the substrate 31. As s result, the mechanical and electrical connection between the chips 37 and the substrate 31 is simultaneously accomplished. The state at this stage is shown in Fig. 7(a).

In the fixing step of the chips 37, when the electrodes 36 are opposed to the corresponding electrodes 35 with or without the use of the bonding metals 120, minute gaps are generated between the lower ends of the stoppers 57 and the surfaces of the chips 37 and therefore, no contact occurs therebetween. When the chips 37 are heated and pressed to thereby melt the bonding metals 120, or when the electrodes 35 and 36 are bonded to each other by the pressure bonding without the bonding metals 120, the lower ends of the stoppers 57 contact the surfaces of the chips 37. Thus, the positioning of the chips 37 along their height is automatically performed.

The chips 37 may be fixed in a one-to-one correspondence with, for example, a known high-speed chip bonder. Alternately, all the chips 37 may be located on a supporting member (not shown) in advance at the predetermined positions and then, all the chips 13 may be fixed in a lump with the supporting member.

When the fixing step of the chips 37 is finished in the above-described way, then, the adhesive filling step is carried out. Specifically, as shown in Fig. 7(b), the gaps among the chips 37 fixed to the substrate 31 with the microbump electrodes 35 and 36 are filled with a liquid or fluid adhesive 38 with electrical insulative property by a suitable method. Then, the adhesive 38 is cured by applying heat, irradiating ultraviolet rays, or the like. At this time, the thickness of the cured layer of the adhesive 38 formed on the insulating layer 32 of the substrate 31 needs not amount to the overall height of the chips 37. It is sufficient that the gaps (which include the bonding metals 120, the microbump electrodes 35 and 36, and the stoppers 57) are designed in such a way as to be completely filled with the adhesive 38 when the chips 37 are thinned by polishing in the next semiconductor chip polishing step. Here, the spraying method (or the coating method) used in the first embodiment is applied as the adhesive filling method.

Next, in the same way as the first embodiment, the opposite surfaces to the adhered ones (here, the lower surfaces) of all the chips 37 fixed as explained above are polished in a lump by the CMP method (the semiconductor chip polishing step). Due to this CMP process, the buried interconnections (the conductive materials) 52 are exposed. In this state, the buried interconnections 52 penetrate through the chips 37 vertically.

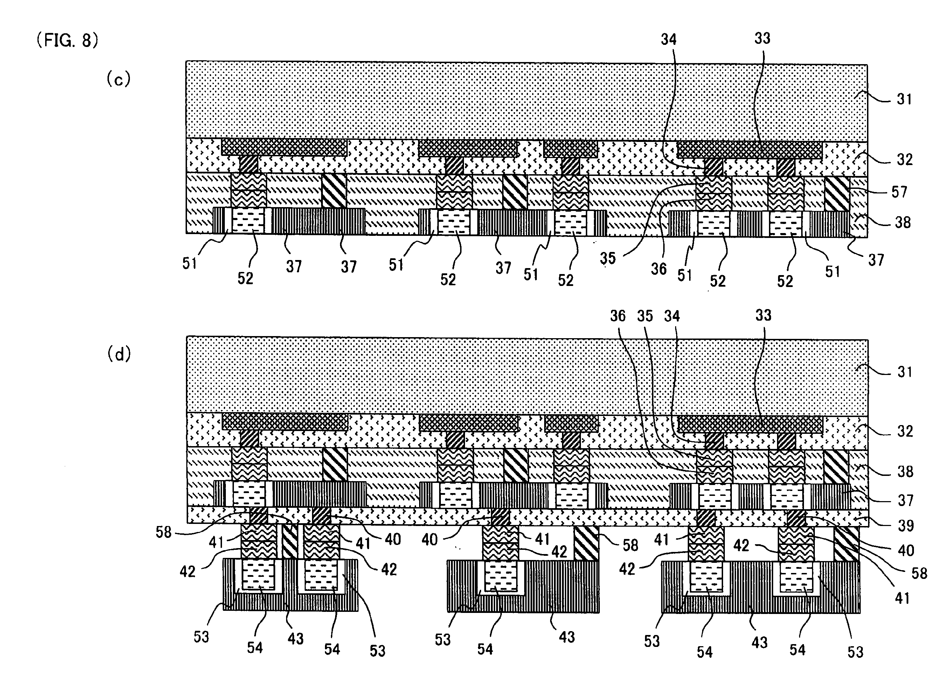

Through the above-described steps, as shown in Fig. 8(c), a first semiconductor circuit layer L1, which includes the chips 37 and the cured adhesive 38, is formed on the insulating layer 32 of the substrate 31.

Next, in approximately the same way as above, semiconductor chips 43 are superposed on the first semiconductor circuit layer L1 formed as described above, thereby forming a second semiconductor circuit layer L2.

Specifically, as shown in Fig. 8(d), an insulating layer 39 where conductive plugs 40 are embedded is formed and then, microbump electrodes 41 are formed on the surface of the insulating layer 39.

Unlike the first embodiment, stoppers 58 for facilitating the positioning of the chips 43 in the direction along their height (i.e., in the direction perpendicular to the substrate 31) are formed to protrude on the surface of the insulating layer 39. These stoppers 58, all of which are the same in shape (e.g., rectangular or circular) and size, are located in such a way as to be superposed on the corresponding chips 43. However, the invention is not limited to this. Needless to say, the shape and/or size of the stoppers 58 may be different dependent on their positions.

The stoppers 58 can be formed in the same way as that of the microbump electrodes 41. However, unlike the electrodes 41, the stoppers 58 need to be made of an insulative material such as SiO₂. The height of each stopper 58 from the surface of the insulating layer 39 is determined in the same way as the height of the above-described stopper 57 from the surface of the insulating layer 32.

The semiconductor chips 43 are prepared. Each of the chips 43 comprises microbump electrodes 42 formed to be exposed on its surface and the buried interconnections in its inside. Then, the electrodes 42 are opposed to and contacted with the corresponding electrodes 41 along with the thin bonding metals 120 or without the metals 120. The electrodes 42 on each chip 43 are bonded to the opposing electrodes 41 in the same way as the chips 37. As s result, the mechanical and electrical connection between the chips 43 and the chips 37 is simultaneously accomplished. The state at this stage is shown in Fig. 8(d). In this step, the positioning of the chip 43 along their height by the stopper 58 is performed in the same way as the positioning of the chip 37 by the stopper 57.

The chips 43 may be fixed in a one-to-one correspondence with, for example, a known high-speed chip bonder. Alternately, all the chips 43 may be located on a supporting member (not shown) in advance at the predetermined positions and thereafter, all the chips 43 may be fixed in a lump with the supporting member.

When the fixing of the chips 43 is finished in the above-described way, then, the adhesive filling step is carried out in the same way as the first embodiment.

Next, in the same way as the first embodiment, the opposite surfaces of all the chips 43, which have been fixed as explained above, to their adhered surfaces (here, their lower surfaces) are polished in a lump by the CMP method (the semiconductor chip polishing step). Due to this CMP process, the buried interconnections (the conductive materials) 54 formed in each chip 43 are exposed. In this state, the buried interconnections (the conductive materials) 54 penetrate through the chip 43 vertically.

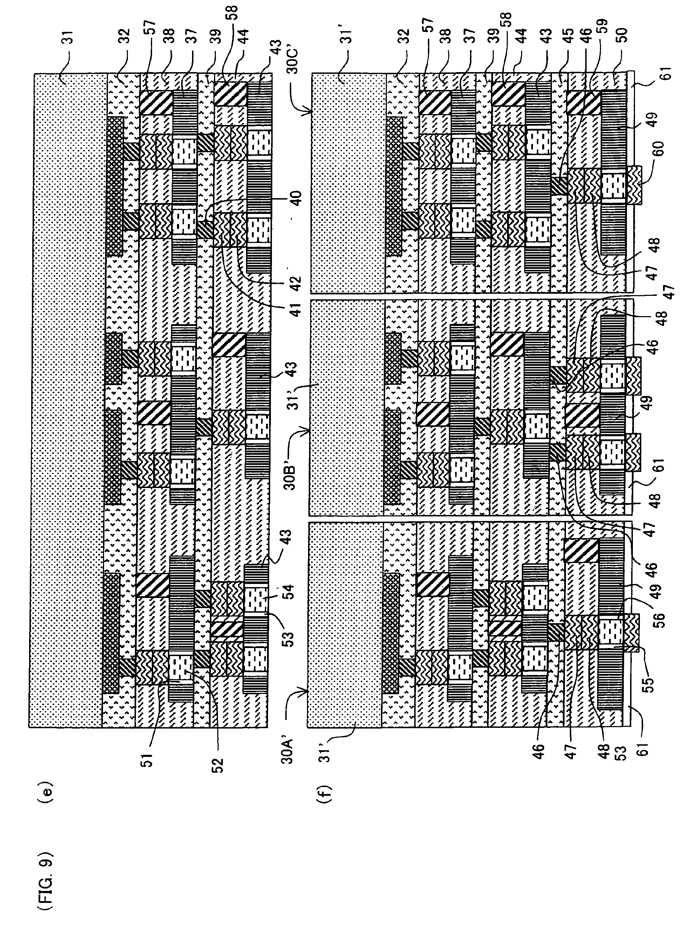

Through the above-described steps, as shown in Fig. 9(e), a second semiconductor circuit layer L2, which includes the chips 43 and the cured adhesive 44, is formed on the first semiconductor circuit layer L1.

Next, in approximately the same way as above, semiconductor chips 49 are superposed on the second semiconductor circuit layer L2 formed as described above, thereby forming a third semiconductor circuit layer L2. Similar to the chips 43 constituting the second semiconductor circuit layer L2, each of the chips 49 comprises microbump electrodes 48 exposed from its surface and buried interconnections (conductive plugs) 56 in its inside.

Specifically, as shown in Fig. 9(f), an insulating layer 39 where conductive plugs 46 are embedded is formed and then, microbump electrodes 47 are formed on the surface of the insulating layer 39.

Unlike the first embodiment, stoppers 59 for facilitating the positioning of the chips 49 in the direction along their height (i.e., in the direction perpendicular to the substrate 31) are formed to protrude on the surface of the insulating layer 45. These stoppers 59, all of which are the same in shape (e.g., rectangular or circular) and size, are located in such a way as to be superposed on the surface areas of the corresponding chips 49. However, the invention is not limited to this. Needless to say, the shape and/or size of the stoppers 59 may be different from each other dependent on their positions. The height of each stopper 59 from the surface of the insulating layer 45 is determined in the same way as the height of the stopper 57 from the surface of the insulating layer 32.

The chips 49 may be fixed in a one-to-one correspondence with, for example, a known high-speed chip bonder. Alternately, all the chips 49 may be located on a supporting member (not shown) in advance at predetermined positions and then, all the chips 49 may be fixed in a lump with the supporting member.

When the fixing of the chips 49 is finished in the above-described way, then, the adhesive filling step is carried out in the same way as the first embodiment.

Next, in the same way as in the first embodiment, the opposite surfaces of all the chips 49, which have been fixed as explained above, to their adhered surfaces (here, the lower surfaces) are polished in a lump by the CMP method (the semiconductor chip polishing step). Due to this CMP process, the buried interconnections (the conductive materials) 56 formed in each chip 49 are exposed from its lower surface. In this state, the buried interconnections (the conductive materials) 56 penetrate through the chip 49 vertically.

Through the above-described steps, as shown in Fig. 9(f), a third semiconductor circuit layer L3, which includes the chips 49 and the cured adhesive 50, is formed on the second semiconductor circuit layer L2.

Thereafter, an insulating layer 61 is formed on the reverses of the chips 49 and the cured layer of the adhesive 50 of the third semiconductor circuit layer L3, thereby covering them entirely. Then, by a known method, microbump electrodes 60 contacted with the conductive materials 56 in the chips 49 through the insulating layer 61 are formed. These electrodes 60, which protrude from the insulating layer 61, are used for electrical connection to an external circuit or device.

Through the above-described steps, as shown in Fig. 9(f), a stacked structure formed by sequentially stacking the first to third semiconductor circuit layers L1 to L3 on the lower surface of the support substrate 31 is obtained. Then, the said stacked structure is subject to a known dicing process, thereby dividing it into desired semiconductor devices. Thus, semiconductor devices 30A', 30B', and 30C' each having the three-layered stacked structure are obtained, as shown in Fig. 9(f). Each of the devices 30A', 30B', and 30C' comprises the stacked structure where the set of the three semiconductor chips 37, 43, and 49 having different sizes and/or functions are stacked on the divided support substrate 31'.

As clearly seen from the above explanation, with the method of fabricating a semiconductor device having a three-dimensional stacked structure according to the second embodiment of the invention, the stoppers 57, 58, and 59 are used. Thus, in addition to the advantages obtained in the first embodiment, there is an advantage that the positioning of the semiconductor chips 37, 43, and 49 in the direction perpendicular to the substrate 31 is facilitated when mounting the chips 37, 43, and 49.

Moreover, the semiconductor devices 30A', 30B', and 30C' according to the second embodiment of the invention fabricated in the above-described way are the same as the semiconductor devices 30A, 30B, and 30C according to the first embodiment of the invention except that the stoppers 57, 58, and 59 are added. Thus, it is needless to say that the same advantages as those of the devices 30A, 30B, and 30C are obtained.

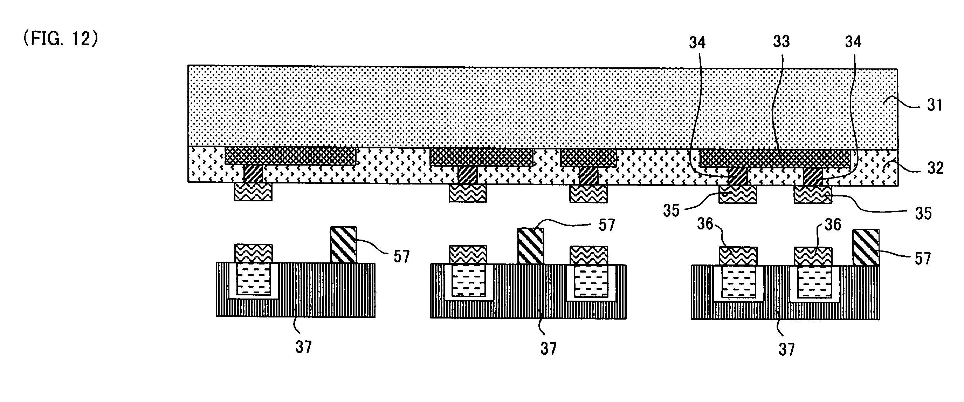

In the above-described second embodiment, the stoppers 57 are formed on the surface of the insulating layer 32 of the support substrate 31 (see Fig. 10); however, the invention is not limited to this. The layout method of the stoppers may be changed optionally. For example, as shown in Fig. 12, the stopper 57 may be formed on the surface of the chip 37. Alternately, as shown in Fig. 11, the stopper 57a may be formed on the surface of the insulating layer 32 and at the same time, the stopper 57b may be formed on the surface of the chip 37 at the position superposed on the stopper 57a. In this case, the positioning of the chip 37 along its height is performed by contacting the stoppers 57a and 57b with each other. These are applicable to the stoppers 58 and 59.

### THIRD EMBODIMENT

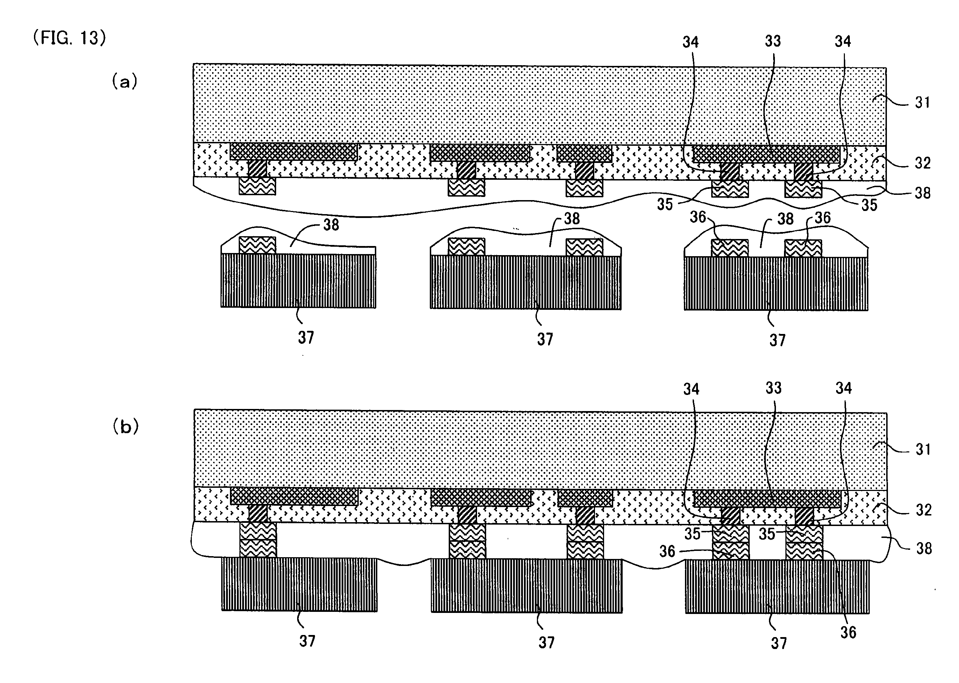

Fig. 13 is a cross-sectional view showing the process steps of a method of fabricating a semiconductor device having a three-dimensional stacked structure according to a third embodiment of the invention. The method of the third embodiment, which corresponds to a variation of the method of the above-described first embodiment (see Figs. 4 to 6), is the same as the method of the first embodiment except that the adhesive filling method is different. Therefore, explanation about the same structural elements as those in the first embodiment is omitted here by attaching the same reference numerals to the same structural elements.

With the method of the third embodiment, in the same way as the first embodiment, a plurality of sets of wiring lines 33 are formed on the mounting surface (the lower surface) of a support substrate 31. An insulating layer 32 is formed on the mounting surface of the substrate 31 to cover the whole wiring lines 33. Conductive plugs 34 reaching the respective wiring lines 33 are embedded in the insulating layer 32. Thus, a plurality of sets of buried interconnections, each of which comprises the wiring lines 33 and the plugs 34, are formed in the insulating layer 32. When forming the plugs 34, the surface of the insulating layer 32 is planarized. Thereafter, microbump electrodes 35 are formed on the surface of the insulating layer 32.

Subsequently, on the whole surface of the insulating layer 32 on which the electrodes 35 are formed, an electrically insulative adhesive 38 used in the first embodiment is coated by a proper method, thereby covering the whole exposed surfaces of the electrodes 35 and the insulating layer 32. The state at this stage is shown in Fig. 13(a). The thickness of the adhesive 38 coated on the substrate 31 and the thickness of the adhesive 38 to be coated on the chips 37 are determined in the following way: Namely, when combining the adhesive 38 coated on the substrate 31 with the adhesive 38 coated on the chips 37, they are unified together like a single layer, as shown in Fig. 13(b). Moreover, the adhesive 38 thus unified will fill the gaps between the substrate 31 and the chips 37.

On the other hand, the same adhesive 38 as coated on the insulating layer 32 on the substrate 31 is coated on the surface of each semiconductor chip 37 having protruding microbump electrodes 36 on its surface. Thus, all the electrodes 36 of the chip 37 are covered with the said adhesive 38, as shown in Fig. 13(a).

Thereafter, in the same way as the first embodiment, the electrodes 36 on each chip 37 are respectively opposed to and contacted with the corresponding electrodes 35 using thin bonding metals or without bonding metals. Since the layer-shaped adhesive 38 is formed on the substrate 31 and the layer-shaped adhesive 38 is formed on the chips 37, both of the adhesives 38 are unified to be like a single layer, as shown in Fig. 13(b), when they are contacted with each other. As a result, the gaps between the insulating layer 32 and the chips 37 are filled with the adhesive 38 and all the electrodes 35 and 36 are embedded in the adhesive 38.

While keeping this state and applying a suitable pressing force toward the substrate 31 to the chips 37, the whole stacked structure including the substrate 31 and the chips 37 is heated and then, cooled to room temperature after a predetermined time has passed. The bonding metal 120 may be used or not. Thus, the electrodes 36 on each chip 37 are bonded to the opposing electrodes 35 on the substrate 31. As a result, the mechanical and electrical connection between the chips 37 and the substrate 31 is simultaneously accomplished. In addition, this step is carried out in such a way that the layer-shaped unified adhesive 38 does not cure.

Subsequently, an additional adhesive 38 is coated on the single-layer-shaped adhesive 38, thereby generating a state where the chips 37 are partially embedded in the adhesive 38. This is because the gaps between the adjoining chips 37 are not filled with the single-layer-shaped adhesive 38 (see Fig. 13(b)) alone. By coating the additional adhesive 38, the gaps will be completely filled with the adhesive 38 when the chips 37 are thinned by polishing in the semiconductor chip polishing step. Thereafter, the whole adhesive 38 is cured by heat, ultraviolet rays, or the like, resulting in the state where the gaps between the adjoining chips 37 also are filled with the adhesive 38 (see Fig. 4(b)).

If the gaps between the adjoining chips 37 are filled with the adhesive 38 without coating the additional adhesive 38 by contriving the viscosity and/or coating method of the adhesive 38, the additional adhesive 38 is unnecessary.

With the method of the third embodiment, there is a possibility that when the electrodes 36 on each chip 37 are opposed to and contacted with the corresponding electrodes 35, the insulative adhesive 38 is sandwiched by the electrodes 35 and 36 and as a result, some defect about the electrical interconnection between the electrodes 35 and 36 will occur. However, the pressing force is applied to the respective chips 37 and thus, the adhesive 38 is automatically pushed out of the minute space between the electrodes 35 and 36. As a result, such the defect as above can be avoided. This means that no measure is required to avoid the defective electrical interconnection of this type.

The subsequent steps are the same as the first embodiment except that the adhesive 38 is coated as described above instead of the "spraying method".

Accordingly, with the method of fabricating a semiconductor device having a three-dimensional stacked structure according to the third embodiment of the invention, it is apparent that the same advantages as those in the method of the first embodiment are obtained. Moreover, it is also apparent that the semiconductor device according to the third embodiment fabricated by this method has the same advantages as the semiconductor device of the first embodiment.

### FOURTH TO SIXTH EMBODIMENTS

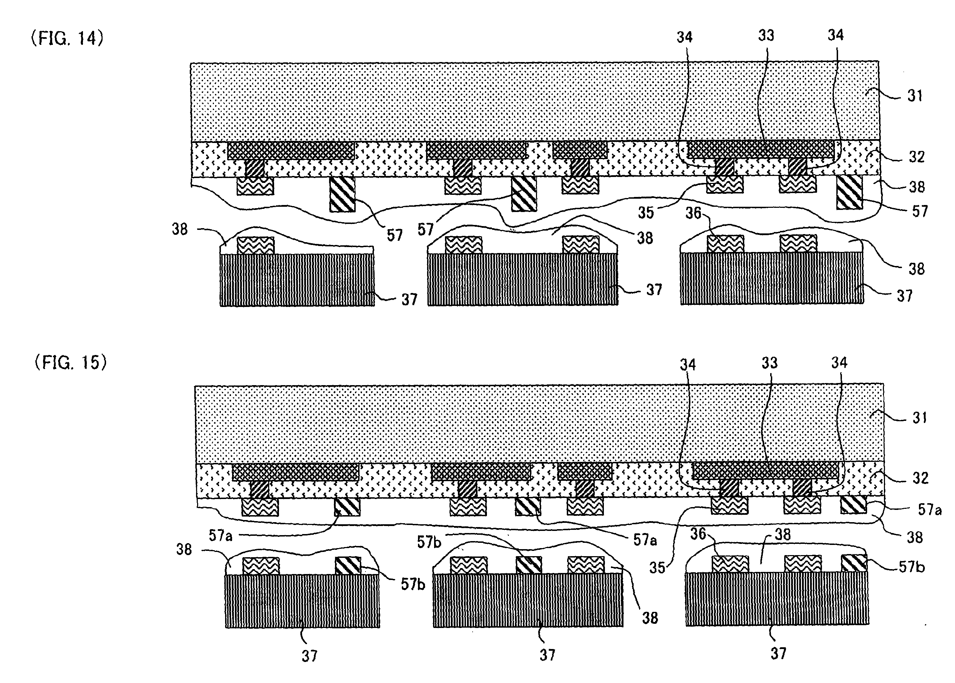

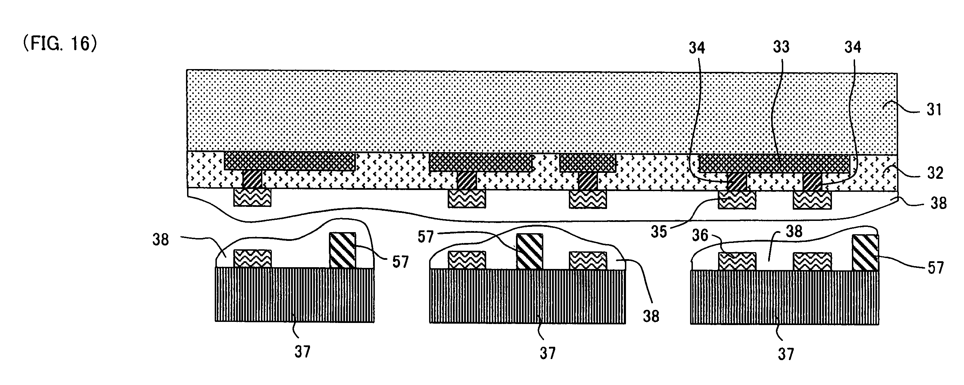

Figs. 14 to 16 show methods of fabricating a semiconductor device having a three-dimensional stacked structure according to fourth to sixth embodiments of the invention.

The methods of the fourth to sixth embodiments correspond to variations of the method of the above-described third embodiment (see Fig. 13), respectively. They are the same as the method of the third embodiment except that stoppers 57 or the combination of stoppers 57a and 57b are added and that the stoppers 57 or the stoppers 57a and 57b also are covered with the adhesive 38 when coating the adhesive 38. Therefore, explanation about the same structural elements as the third embodiment is omitted here by attaching the same reference numerals to the same elements.

The fourth to sixth embodiments correspond to the cases of Figs. 10 to 12, respectively. It is seen from the fourth to sixth embodiments that the method of the third embodiment is applicable to the cases where the stoppers are used.

### SEVENTH EMBODIMENT

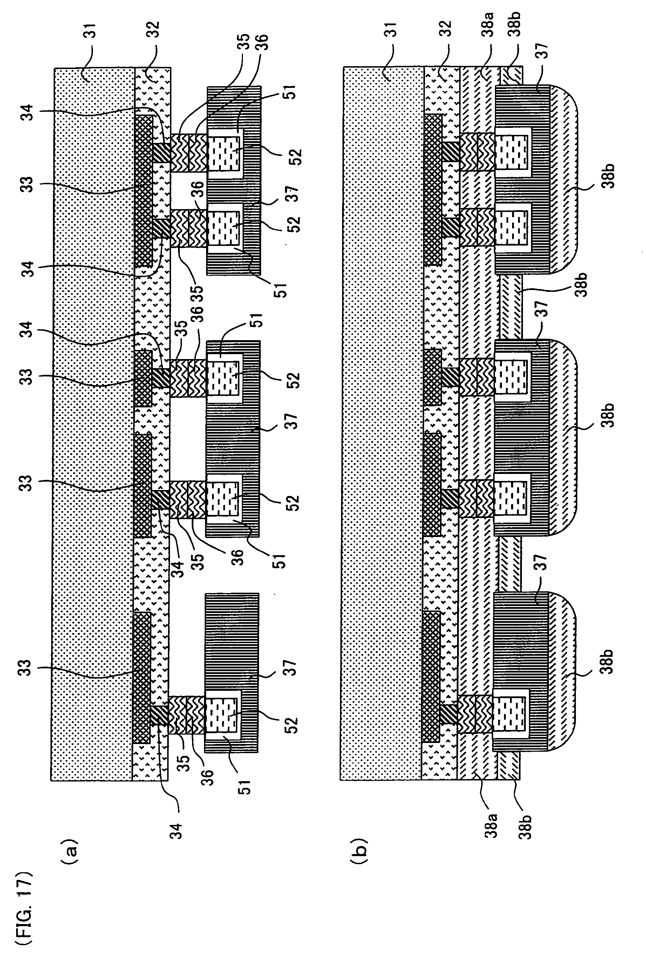

Fig. 17 is a conceptual drawing showing the process steps of a method of fabricating a semiconductor device having a three-dimensional stacked structure according to a seventh embodiment of the invention, which corresponds to Fig. 4. This embodiment is the same as the first embodiment except that the layer of a filling material 38b is formed on the cured layer of an electrically insulative adhesive 38a. The adhesive 38a is made of the same material as the adhesive 38 shown in Fig. 4.

When the fixing of the chips 37 to the substrate 31 is completed in the same way as the first embodiment, the state as shown in Fig. 17(a) is obtained. Thereafter, the adhesive filling step is carried out in the same way as the first embodiment. In this adhesive filling step, as shown in Fig. 17(b), the gaps among the chips 37 fixed to the substrate 31 by way of the electrodes 35 and 36 are filled with a liquid or fluid electrically insulative adhesive 38a by an appropriate method and then, the adhesive 38a is cured by applying heat, irradiating ultraviolet rays, or the like.

Subsequently, a layer of a filling material 38b having electrical insulative property is formed on the cured layer of the adhesive 38a in the gaps among the chips 37, thereby ensuring the electrical insulation among the chips 37. If an organic insulative material is used for the filling material 38b, it is preferred to use a known coating method. If an inorganic insulative material is used for the filling material 38b, it is preferred to use a known CVD method.

The thickness of the cured layer of the adhesive 38a is smaller than that of the cured layer of the adhesive 38 in the first embodiment. The sum of the thickness of the cured layer of the adhesive 38a and the thickness of the layer of the filling material 38b is equal to the thickness of the cured layer of the adhesive 38 in the first embodiment.

It is apparent that the same advantages as those in the first embodiment are obtained in the seventh embodiment also. Moreover, since the thickness of the cured layer of the adhesive 38a is smaller than that of the cured layer of the adhesive 38 in the first embodiment, there is an additional advantage that the necessary amount of the adhesive 38a can be reduced.

In addition, in Fig. 17, only the filling material 38b is placed on the reverses of the chips 37. This is because the adhesive 38a on the reverses of the chips 37 is removed before the formation of the layer of the filling material 38b. However, it is unnecessary to remove the adhesive 38a on the chips 37. In this case, both of the adhesive 38a and the filling material 38b are placed on the reverses of the chips 37. Since the adhesive 38a or 38a and the filling material 38b on the reverses of the chips 37 are removed in the next CMP process, no problem will occur. The filling material 38b may have a layered structure of multiple layers.

### EIGHTH EMBODIMENT

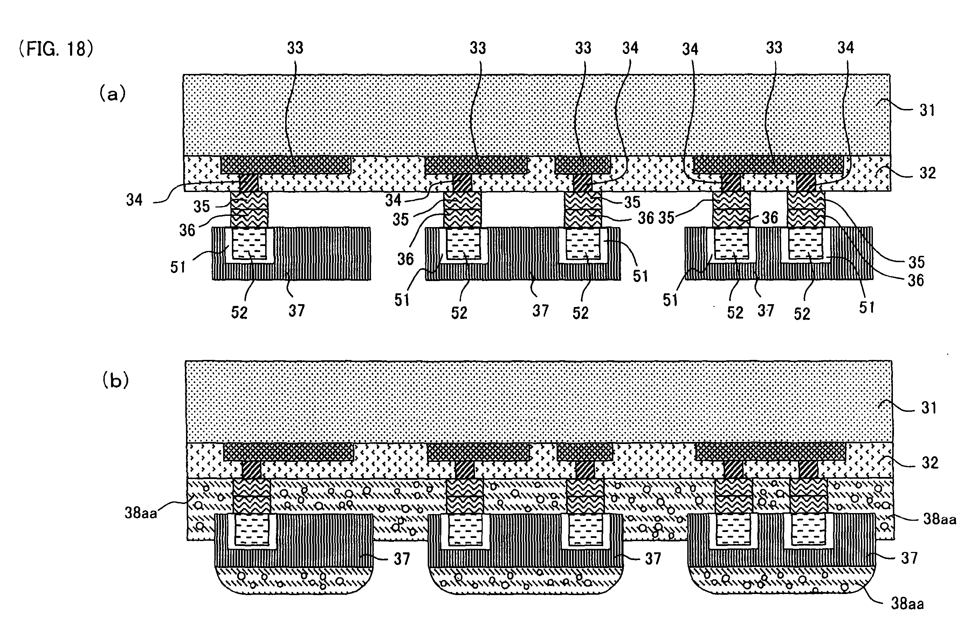

Fig. 18 is a conceptual drawing showing the process steps of a method of fabricating a semiconductor device having a three-dimensional stacked structure according to an eighth embodiment of the invention, which corresponds to Fig. 4. This embodiment is the same as the first embodiment except that the cured layer of a filler-containing adhesive 38aa is formed instead of the cured layer of the electrically insulative adhesive 38.

As the filler contained in the adhesive 38aa, any filler may be used. However, for example, minute particles (e.g., spherical) made of Si or metal covered with a film of an electrically insulative material such as SiO₂ are preferably used for this purpose.

It is apparent that the same advantages as those in the first embodiment are obtained in the eighth embodiment also. Since the adhesive 38aa contains a filler, there is an additional advantage that the warp or bend of the substrate 31 and/or the first to third circuit layers L1 to L3 can be reduced by suitably setting the thermal expansion coefficient of the said adhesive.

### NINTH EMBODIMENT

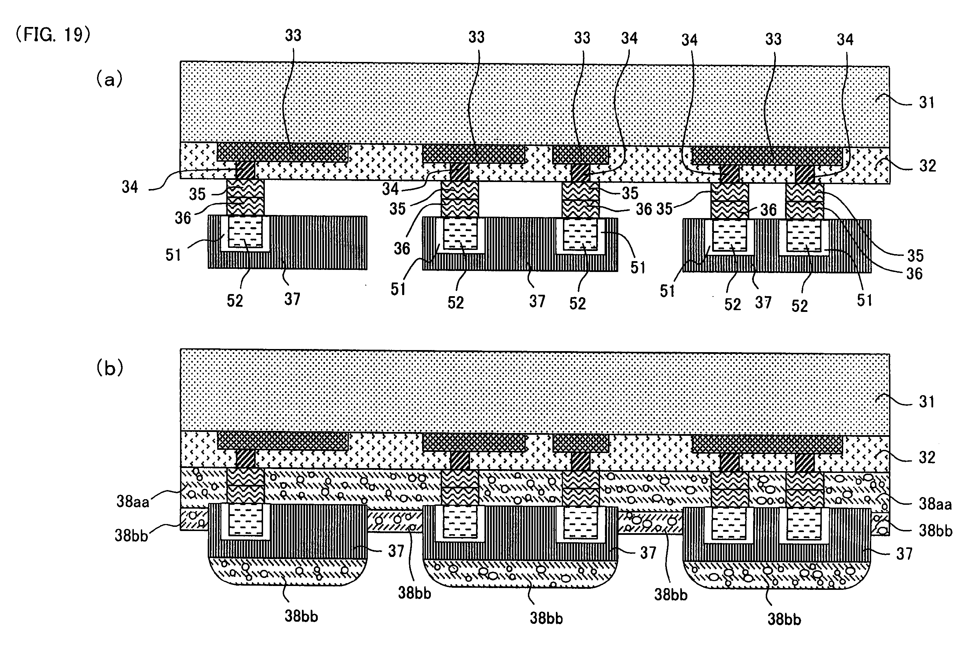

Fig. 19 is a conceptual drawing showing the process steps of a method of fabricating a semiconductor device having a three-dimensional stacked structure according to a ninth embodiment of the invention, which corresponds to Fig. 4. This embodiment is the same as the eighth embodiment of Fig. 18 except that a filler-containing filling material 38bb is formed on the cured layer of a filler-containing adhesive 38aa.

As the fillers contained in the adhesive 38aa and the filling material 38bb, any filler may be used. However, for example, minute particles (e.g., spherical) made of Si or metal covered with a film of an electrically insulative material such as SiO₂ are preferably used for this purpose.

It is apparent that the same advantages as those in the first embodiment are obtained in the ninth embodiment also. Moreover, there is an additional advantage that the warp or bend of the substrate 31 and/or the first to third circuit layers L1 to L3 can be reduced by suitably setting the thermal expansion coefficients of the adhesive 38aa and the filler material 38bb.

### TENTH EMBODIMENT

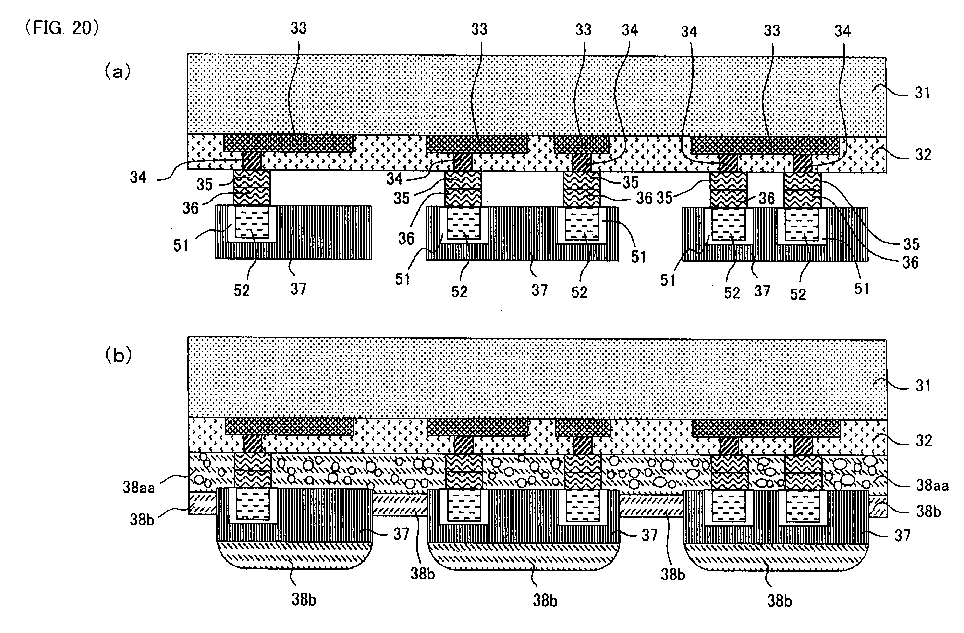

Fig. 20 is a conceptual drawing showing the process steps of a method of fabricating a semiconductor device having a three-dimensional stacked structure according to a tenth embodiment of the invention, which corresponds to Fig. 4. This embodiment is the same as the eighth embodiment of Fig. 18 except that a filling material 38b containing no filler is formed on the cured layer of a filler-containing adhesive 38aa.

It is apparent that the same advantages as those in the first embodiment are obtained in the tenth embodiment also. Moreover, there is an additional advantage that the warp or bend of the substrate 31 and/or the first to third circuit layers L1 to L3 can be reduced by suitably setting the thermal expansion coefficient of the adhesive 38aa.

### ELEVENTH EMBODIMENT

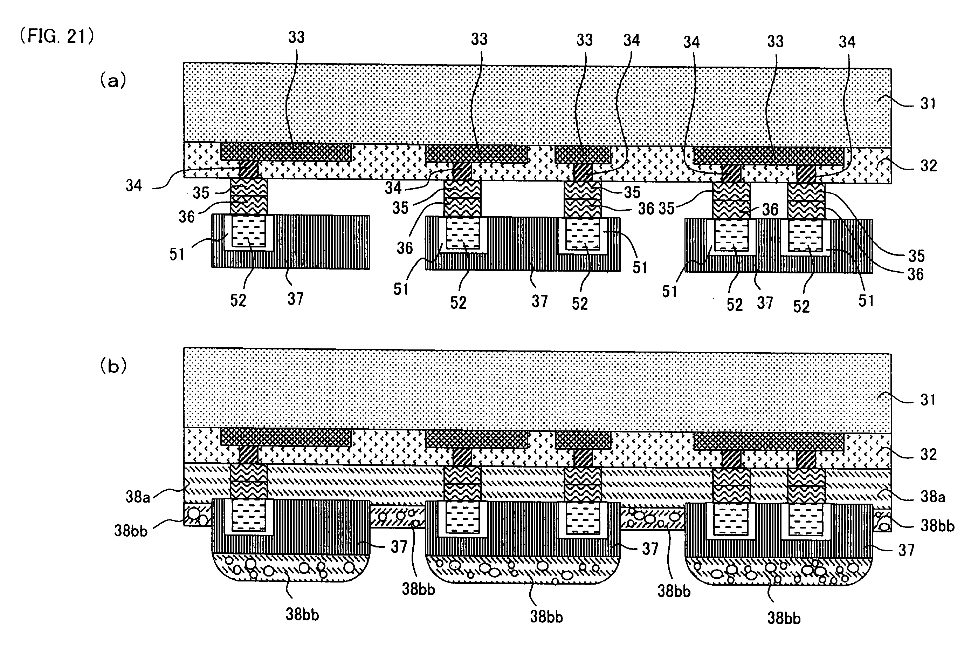

Fig. 21 is a conceptual drawing showing the process steps of a method of fabricating a semiconductor device having a three-dimensional stacked structure according to an eleventh embodiment of the invention, which corresponds to Fig. 4. This embodiment is the same as the seventh embodiment of Fig. 17 except that a filler-containing filling material 38bb is formed on the cured layer of an adhesive 38a containing no filler.

It is apparent that the same advantages as those in the first embodiment are obtained in the eleventh embodiment also. Moreover, there is an additional advantage that the warp or bend of the substrate 31 and/or the first to third circuit layers L1 to L3 can be reduced by suitably setting the thermal expansion coefficient of the filling material 38bb.

### TWELFTH EMBODIMENT

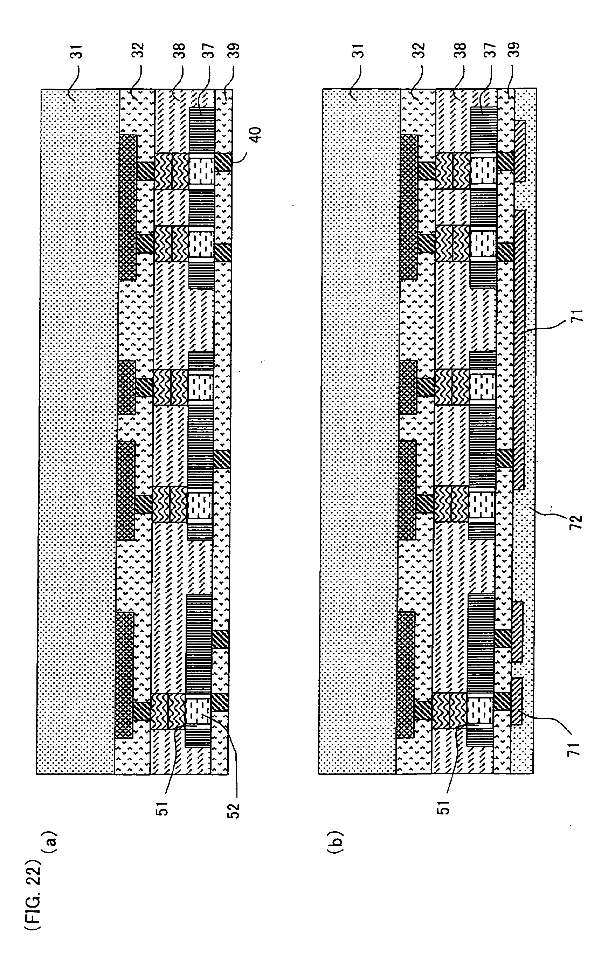

Figs. 22 to 23 are conceptual drawings showing the process steps of a method of fabricating a semiconductor device having a three-dimensional stacked structure according to a twelfth embodiment of the invention. This embodiment is the same as the first embodiment of Figs. 4 to 6 except that a wiring layer 71 and an insulating layer 72 are additionally formed between the first semiconductor circuit layer L1 and the second semiconductor circuit layer L2.

After forming the first semiconductor circuit layer L1 in the same way as the first embodiment, an insulating layer 39 containing conductive plugs 40 embedded therein is formed on the layer L1. The state at this stage is shown in Fig. 22(a). Next, a wiring layer 71 is formed on the surface of the insulating layer 39 by a known method. The wiring layer 71 is provided mainly to interconnect the adjoining chips 37. As seen from this, a wiring layer can be formed between the adjoining chips (the semiconductor circuits) 37 in the invention. Thereafter, an insulating layer 72 is formed to cover the whole wiring layer 71, thereby embedding the wiring layer 71. The state at this stage is shown in Fig. 22(b).

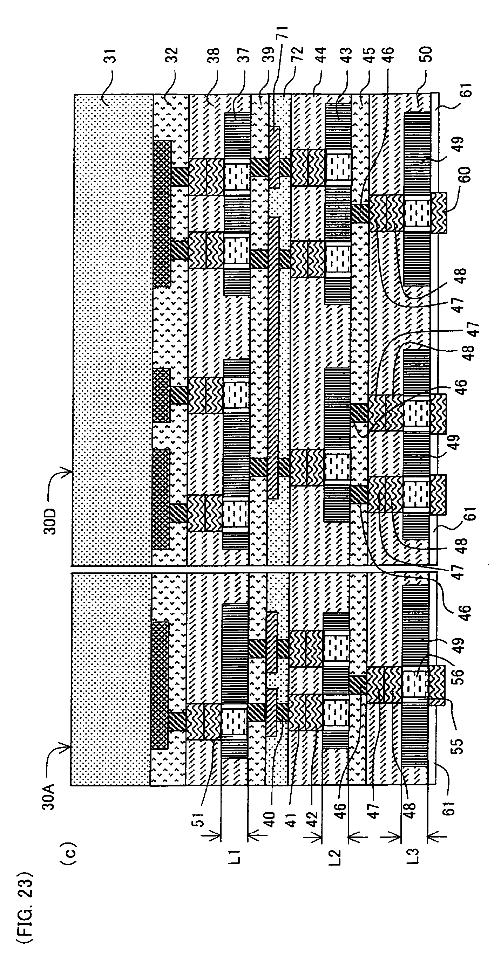

The subsequent steps are the same as those in the first embodiment. As a result, as shown in Fig. 23(c), semiconductor devices 30A and 30D are obtained. As clearly seen from Fig. 23(c), the semiconductor device 30D comprises two adjoining stacked chips, which are electrically connected to each other.

With the twelfth embodiment, there are the same advantages as those of the first embodiment and an advantage that the adjoining chips 37 can be electrically interconnected with the wiring layer 71 (i.e., the inter-chip connection is possible).

### THIRTEENTH EMBODIMENT

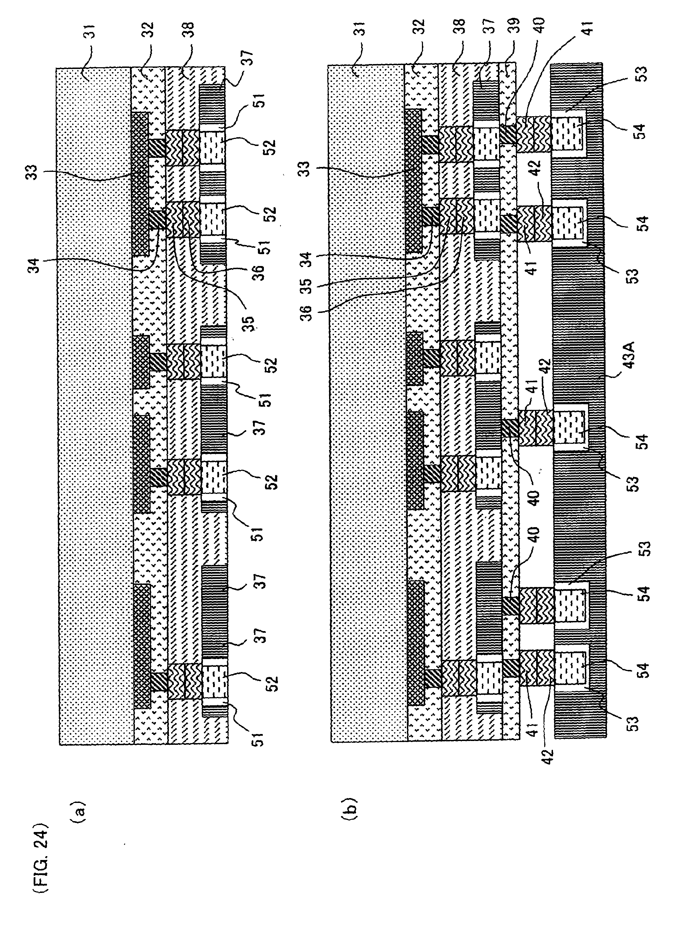

Figs. 24 to 25 are conceptual drawings showing the process steps of a method of fabricating a semiconductor device having a three-dimensional stacked structure according to a thirteenth embodiment of the invention, which correspond to Figs. 5 and 6. This embodiment is the same as the method of the first embodiment except that the second semiconductor circuit layer L2 is formed by a single semiconductor wafer 43A, not the semiconductor chips 43.

In this way, not only a plurality of semiconductor chips but also a semiconductor wafer can be used for each of the first to third semiconductor circuit layers L1 to L3.

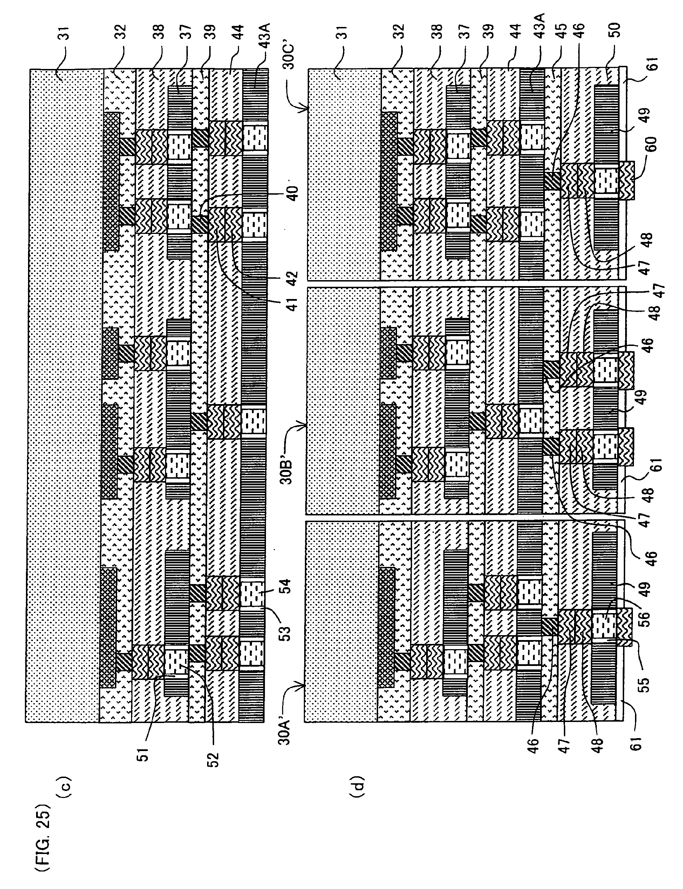

In this case, with the semiconductor devices 30A', 30B' and 30C' shown in Fig. 25(c), the ends of the divided pieces of the semiconductor wafer 43A are respectively exposed from the cured layers of the adhesive 44 that cover the sidewalls of the stacked structure comprising the divided pieces of the semiconductor wafer 43A and the semiconductor chips 37 and 49. This is because the shape and size of the wafer 43A is the same as those of the support substrate 31. However, it is needless to say that the size of the wafer 43A may be set to be smaller than that of the substrate 31.

With the semiconductor devices 30A', 30B' and 30C' shown in Fig. 25(c), a contrivance is applied to the structure of the semiconductor circuits in the wafer 43A and therefore, the operation of the devices 30A', 30B' and 30C' are not affected even if external conductors contact the ends of the divided pieces of the wafer 43A exposed from the cured layer of the adhesive 44. Thus, the exposure of the pieces of the wafer 43A will not cause any obstacle.

It is obvious that the same advantages as those in the first embodiment are obtained in the thirteenth embodiment.

### FOURTEENTH EMBODIMENT

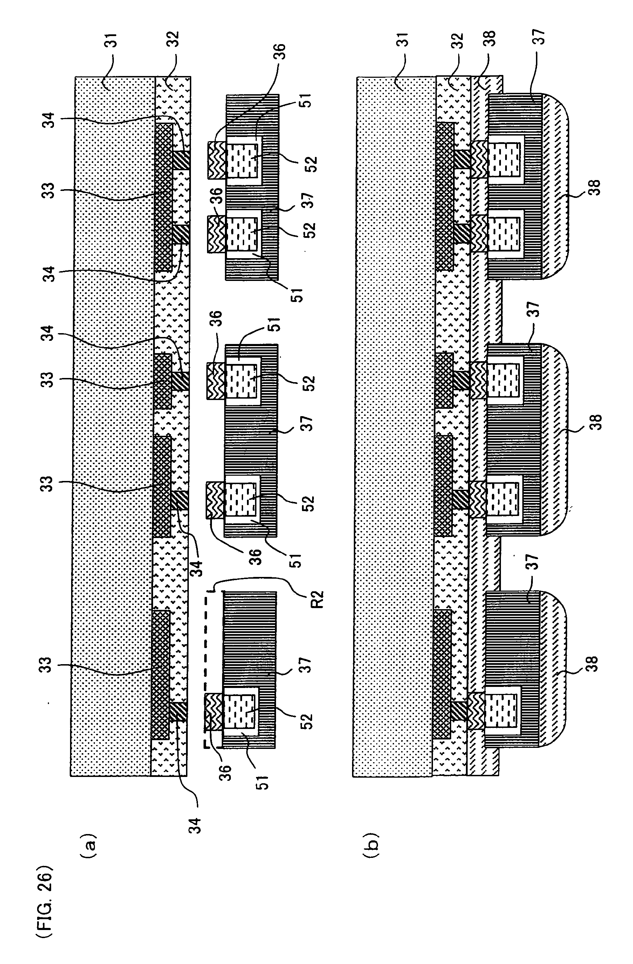

Fig. 26 is a conceptual drawing showing the process steps of a method of fabricating a semiconductor device having a three-dimensional stacked structure according to a fourteenth embodiment of the invention, which correspond to Fig. 4. This embodiment corresponds to one obtained by canceling the connecting portions R1 on the support substrate 31. In this way, the bonding of the chips 37 may be performed with the connecting portions R2 on the chips 37 alone.

In addition, opposite to this, the bonding of the chips 37 may be performed with the connecting portions R1 on the substrate 31 alone by canceling the connecting portions R2 on the chips 37.

### SECOND EXAMPLE OF ADHESIVE FILLING METHOD

In the above-described first to fourteenth embodiments, the filling operation of the adhesive is carried out by the "spraying method" (or the "coating method") at room temperature, which is termed the first example. However, the invention is not limited to the spraying and coating methods. Any other method may be usable for the invention, which will be shown below.

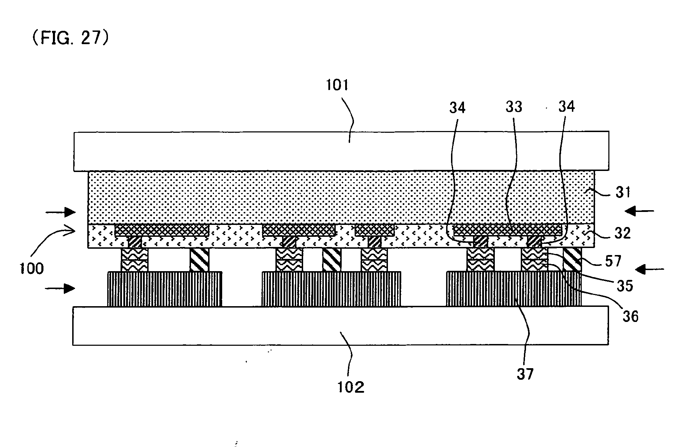

Figs. 27 to 28 are explanatory drawings showing the second example of the adhesive filling method applicable to the first to fourteenth embodiments described above.

In Fig. 27, reference numerals 101 and 102 denote rigid pressing plates, respectively. What is sandwiched by the pressing plates 101 and 102 from the upper and lower sides is the structure shown in Fig. 7(a). Reference numeral 100 is attached to this structure. The structure 100 is held by applying external forces from the upper and lower sides by way of the plates 101 and 102.

With the structure 100, since the semiconductor chips 37 are fixed to the support substrate 331 by way of the microbump electrodes 35 and 36, the plates 101 and 102 are not essential. However, here, to eliminate the risk that the bonded portions of the electrodes 35 and 36 are separated from each other due to shock in the adhesive filling step, the structure 100 is sandwiched by the plates 101 and 102. Therefore, if such the risk does not occur, or it is extremely small, the plates 101 and 102 may be omitted.

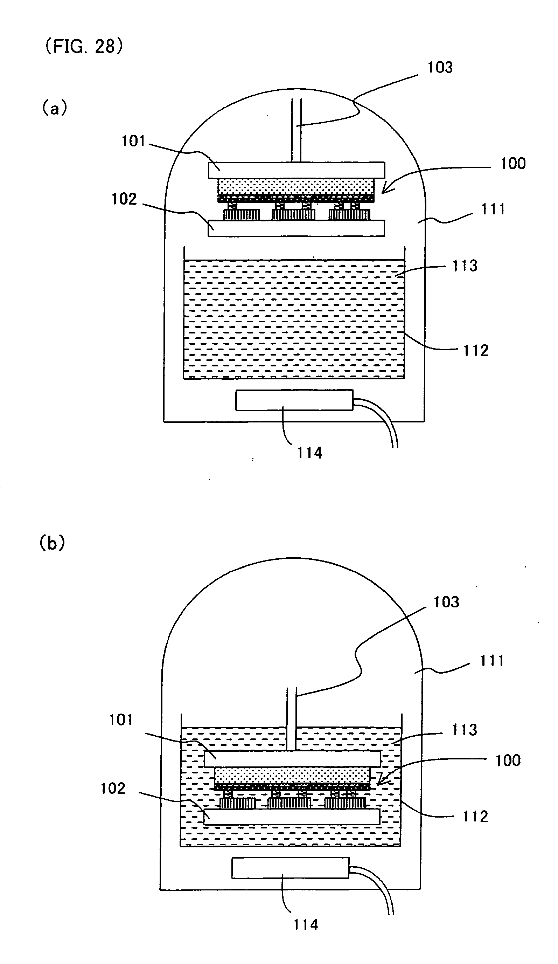

The adhesive is injected horizontally toward the center of the structure 100 sandwiched by the plates 101 and 102 from the side faces of the structure 100, thereby filling all the gaps in the structure 100 with the adhesive. After the injection and filling are completed, the said adhesive is cured by applying heat, irradiating ultraviolet rays, or the like. The injection and filling of the adhesive may be performed from the entirety or part of the side faces of the structure 100. A concrete example of the filling method of the adhesive is shown in Fig. 28.

With this filling method, as shown Fig. 28(a), a chamber 111 is used, in which a desired vacuum atmosphere can be generated. In the chamber 111, a container 112 for receiving the liquid adhesive 113 and a heater for heating the adhesive 113 in the container 112 to lower the viscosity of the adhesive 113 are provided. The heater 114 is located in the lower part of the chamber 111.

With this filling method, after a predetermined vacuum atmosphere is generated in the chamber 111, the structure 100 sandwiched by the pressing plates 101 and 102 is engaged at the lower end of a support rod 103. Thereafter, the structure 100 is immersed in the liquid adhesive 113 stored in the container 112, as shown in Fig. 28(b). At this time, the adhesive 113 in the container 112 is heated with the heater to lower its viscosity, thereby facilitating the flow and injection of the adhesive 113 into the gaps existing in the periphery of the stacked structure 100. Since the inside of the chamber 111 is in vacuum, the air remaining in the gaps between the microbump electrodes 35 and 36 is reliably evacuated from the chamber 111 to the outside, and the adhesive 113 in the container 112 is injected into the gaps instead of the air.

Subsequently, while keeping the structure 100 immersed in the adhesive 113, the atmospheric air is introduced into the chamber 111, thereby breaking the vacuum atmosphere. Due to the atmospheric pressure thus generated in the chamber 111, the adhesive 113 in the container 112 is pressurized. As a result, the adhesive 113 is injected into the gaps in the periphery of the structure 100 and the gaps between the electrodes 35 and 36 more easily.

When the injection and filling of the adhesive 113 is completed in this way, the structure 100 is lifted from the container 112 and taken out of the chamber 111. Then, the adhesive 113 is cured by applying heat, irradiating ultraviolet rays, or the like. After the curing is completed, the extra adhesive 113 is removed.

In addition, instead of the processes that a vacuum atmosphere is generated in the chamber 111 and thereafter, it is broken to the atmospheric pressure, pressurization may be carried out by introducing an inert gas such as a rare gas or nitrogen gas into the chamber 111 after breaking the vacuum atmosphere. In this case, the adhesive 113 in the container 112 is pressurized by the introduced gas and therefore, there is an advantage that the injection and filling of the adhesive 113 is more reliable.

### THIRD EXAMPLE OF ADHESIVE FILLING METHOD

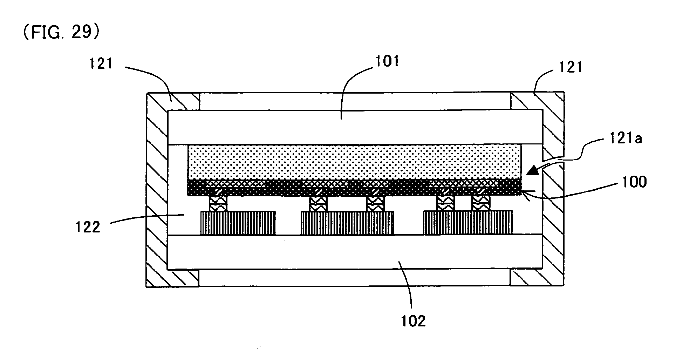

Fig. 29 shows a third example of the adhesive filling method applicable to the first to fourteenth embodiments described above.

With this filling method, a clamp member 121 is used. This member 121 is designed in such a way as to surround the periphery of the approximately cylindrical structure 100 sandwiched by the circular pressing plates 101 and 102. The clamp member 121 is divided into, for example, two parts, i.e., left- and right-side parts. The member 121 sandwiches the structure 100 and the plates 101 and 102 from their right and left sides, thereby surrounding the whole periphery of the structure 100, as shown in Fig. 29. Thus, a closed space 122 is formed by the clamp member 121 and the pressing plates 101 and 102 in the periphery of the structure 100. The adhesive is injected into the space 122 under pressure by a known method by way of injection holes 121a of the member 121. After the injection of the adhesive is completed, the injected adhesive is cured by applying heat, irradiating ultraviolet rays, or the like. Then, the clamp member 121 is removed.

In this second method, the closed space 122 is formed in the periphery of the structure 100 by the clamp member 121 having a function like a forming mold, and the adhesive is pressurized and injected into the space 122. Thus, the injection of the adhesive into the whole space 122 is ensured similar to the above-described second example. Thereafter, the structure 100 is taken out of the clamp member 121 and the extra adhesive existing on the side faces of the structure 100 is removed.

In the third example, there is an advantage that the chamber 111, the vacuum condition generating apparatus, and so on used in the second example are unnecessary, which means that the third method can be realized with a simple configuration. In addition, it is preferred that an appropriate mold release agent is coated on the surfaces of the clamp member 121 to be contacted with the adhesive. This is to facilitate the release of the member 121 from the cured adhesive.

### FOURTH EXAMPLE OF ADHESIVE FILLING METHOD

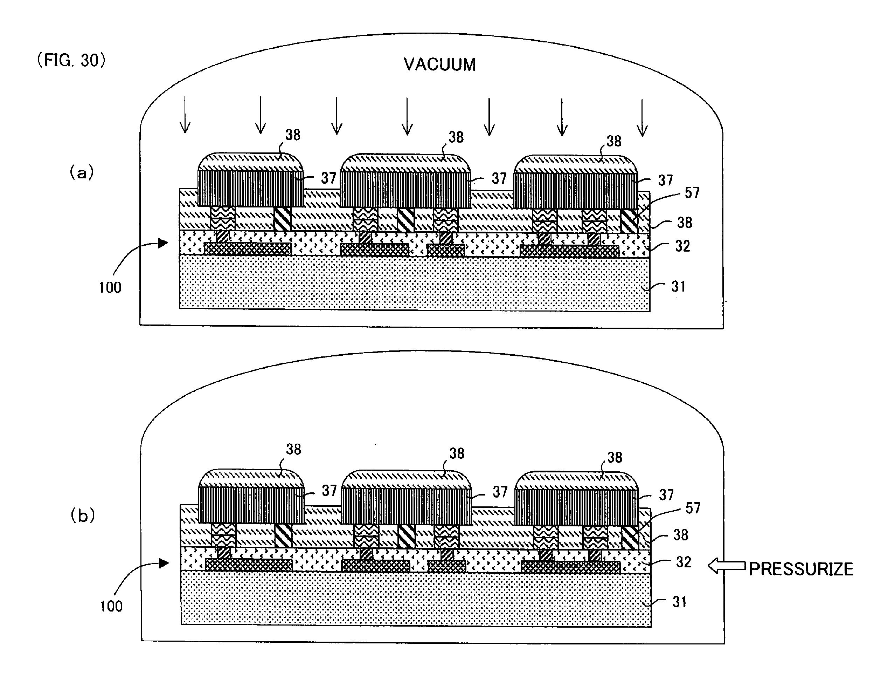

Fig. 30 shows a fourth example of the adhesive filling method applicable to the first to fourteenth embodiments described above.

In this method, after the structure 100 shown in Fig. 7(a) is turned upside down and carried into the chamber, a predetermined vacuum atmosphere is generated in the chamber. Then, the adhesive 38 is sprayed from the upper side with a known spraying apparatus (not shown). Thus, the adhesive 38 falls naturally, resulting in the state shown in Fig. 30(a). Since the surroundings of the structure 100 is in a vacuum condition, the air remaining in the gaps between the electrodes 35 and 36 is reliably evacuated to the outside, and the adhesive 38 is injected into the gaps instead.

After the spraying of the adhesive 38 is completed, the vacuum atmosphere is broken and then, pressurization is performed, as shown in Fig. 30(a). As a result, due to the pressure difference, the adhesive 38 on the structure 100 penetrates into the all gaps existing in the structure 100. Subsequently, the sprayed adhesive 38 is cured by applying heat, irradiating ultraviolet rays, or the like. The subsequent process steps are the same as those in the second example.

### FIFTH EXAMPLE OF ADHESIVE FILLING METHOD

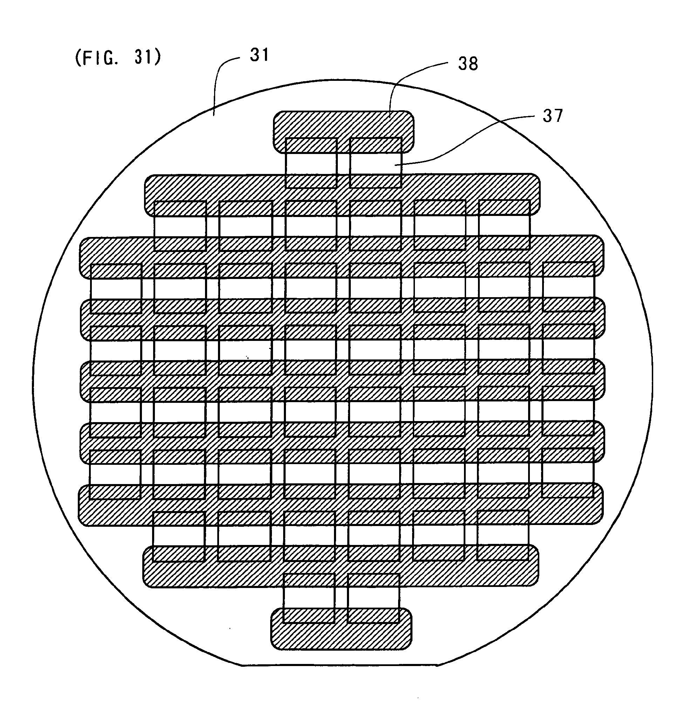

Figs. 31 to 33 show a fifth example of the adhesive filling method applicable to the first to fourteenth embodiments described above.

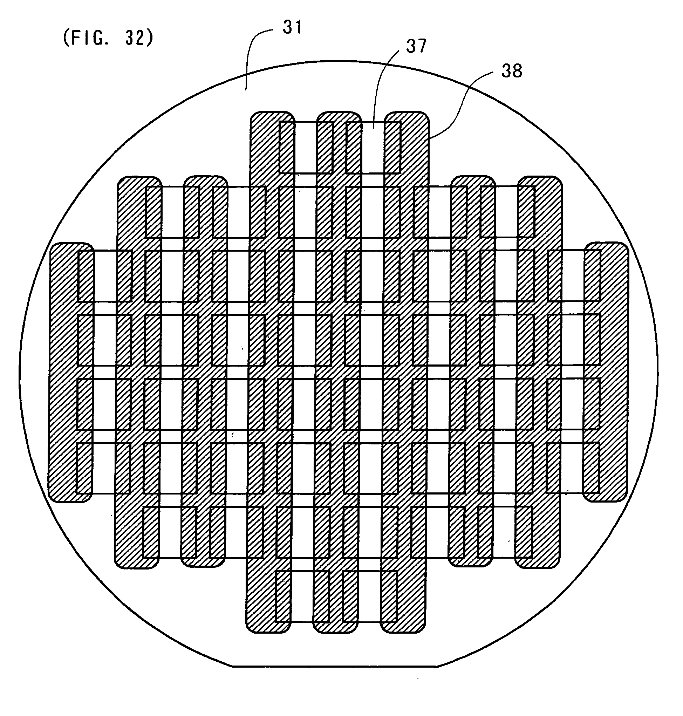

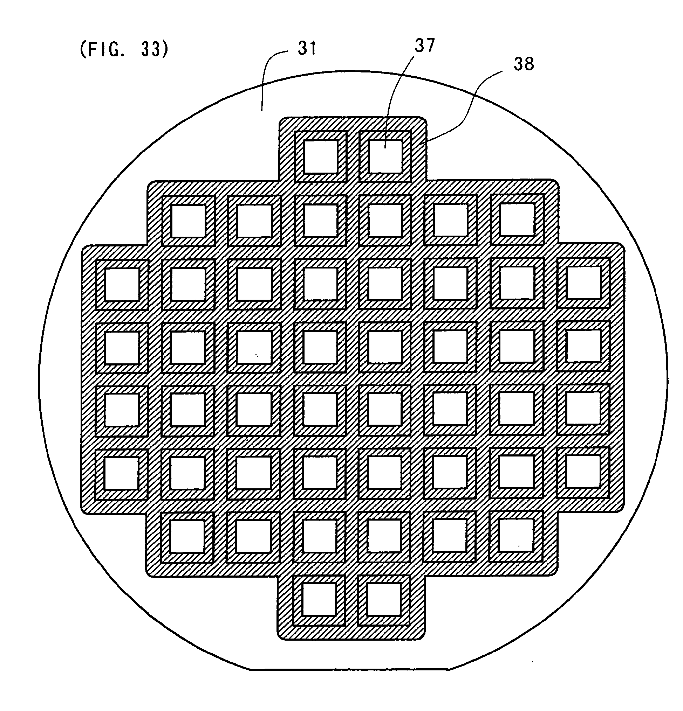

In this method, in the state where the structure 100 shown in Fig. 7 (a) is turned upside down (the chips 37 face upward on the substrate 31), the liquid adhesive 38 is linearly injected into the gaps among the regularly arranged semiconductor chips 37 and their ends with a known dispenser. Fig. 31 shows the case where the adhesive 38 is injected into the gaps horizontally arranged in the plane of the paper among the chips 37 and their top and bottom ends. Fig. 32 shows the case where the adhesive 38 is injected into the gaps vertically arranged in the plane of the paper among the chips 37 and their left and right ends. Fig. 33 shows the case where the adhesive 38 is injected into the gaps arranged horizontally and vertically in the plane of the paper among the chips 37 and their top, bottom, left, and right ends.

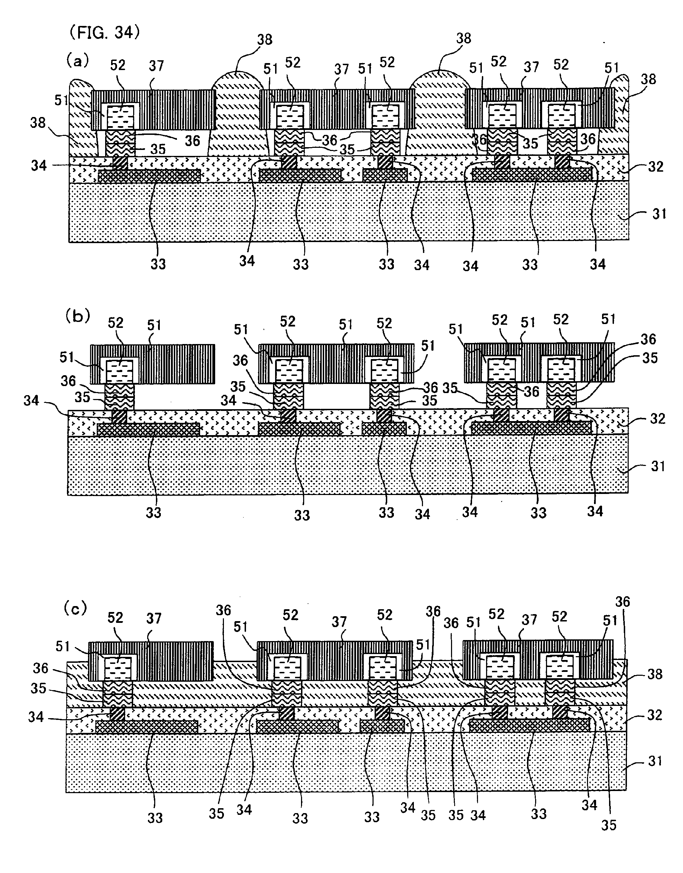

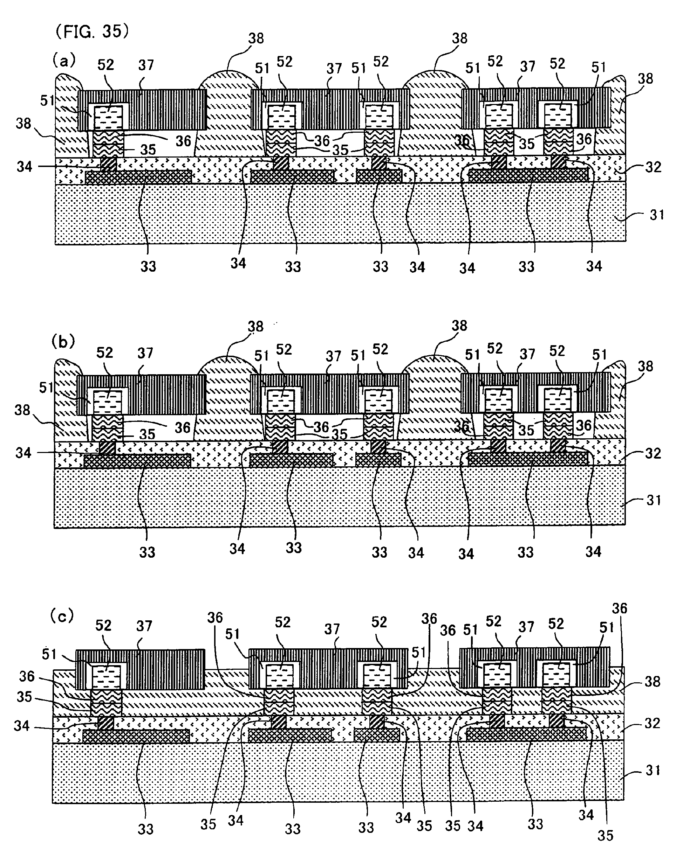

Fig. 34(a) and Fig. 34(b) show the vertical and horizontal cross sections, respectively, when the adhesive 38 is injected into the gaps horizontally arranged among the chips 37 and the top and bottom ends thereof, as shown in Fig. 31. Fig. 34(c) shows the state after the gaps among the chips 37 and the gaps between the chips 37 and the substrate 31 are filled with the injected adhesive 38. Figs. 35(a) and (b) show the vertical and horizontal cross sections, respectively, when the adhesive 38 is injected into the gaps arranged horizontally and vertically among the chips 37 and the top, bottom, right, and left ends thereof, as shown in Fig. 33. Fig. 35(c) shows the state after the gaps among the chips 37 and the gaps between the chips 37 and the substrate 31 are filled with the injected adhesive 38.

In the fifth example, the adhesive 38 is injected into the gaps among the chips 37 with a dispenser in the atmospheric air or vacuum according to one of the modes shown in Figs. 31 to 33. At this time, the liquid adhesive 38 is injected not only to fill the gaps among the chips 37 but also to cover small parts of the reverses of the chips 37, as clearly shown in Figs. 31 to 35. Thereafter, by returning the atmosphere that surrounds the substrate 31 to the atmospheric pressure from a vacuum state or by pressurizing it to a pressure higher than the atmospheric pressure, the adhesive 38 is naturally introduced into the gaps among the chips 37 due to capillary phenomenon.

In the fifth example, there is an advantage that the injection and filling operations of the adhesive 38 can be performed efficiently even if many chips 37 are mounted on the substrate 31.

### FIRST EXAMPLE OF SUBSTRATE WARP PREVENTING METHOD

Next, a method of preventing the warp of the support substrate 31 that may occur in the adhesive curing process is explained.

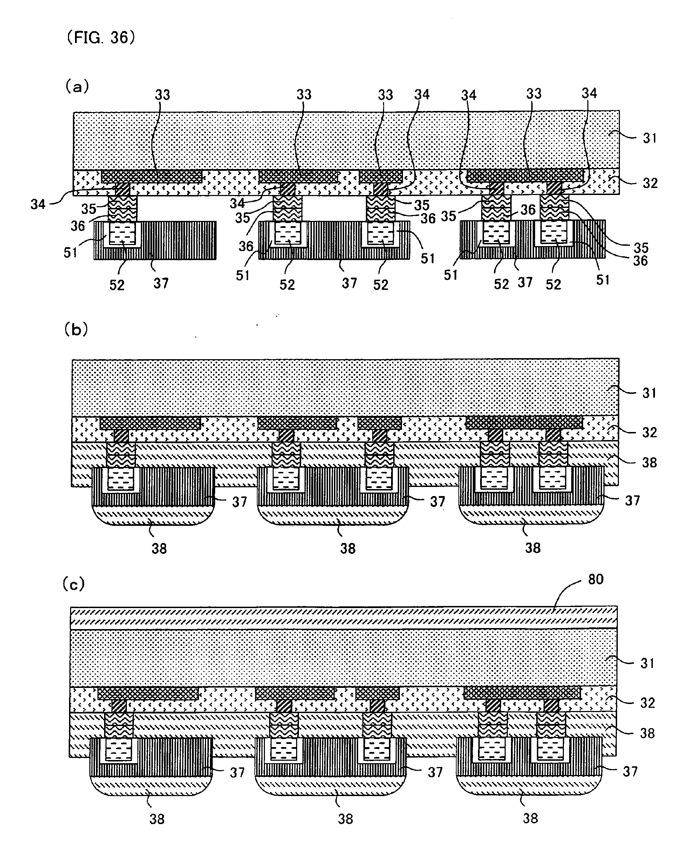

Fig. 36 shows a first example of the method of preventing the warp of the support substrate 31 applicable to the first to fourteenth embodiments described above.

When the chips 37 are fixed to the support substrate 31 with the adhesive 38 (e.g., an epoxy resin), there is a tendency that the substrate 31 is warped or bent due to the volume change of the adhesive 38 occurring in its curing process. This can be easily prevented by the method shown in Fig. 36.

In the above-described first embodiment, the state of Fig. 36(a) where the chips 37 are fixed (which is the same as the state of Fig. 4(a)) is transferred by filling of the adhesive 38 to the state of Fig. 36(b) (which is the same as the state of Fig. 4(b)). Thereafter, the CMP process is performed, thereby forming the first semiconductor circuit layer L1, as shown in Fig. 5(a). If no measure is taken in these steps, there is a danger that the substrate 31 is warped to generate a concave state due to the volume change of the adhesive 38 after its curing process, which is dependent on the kind of the adhesive 38. To prevent this danger, the state of Fig. 36(b) (Fig. 4(b)) is generated by filling the adhesive 38 and then, a warp-preventing adhesive 80 is coated on the opposite surface of the substrate to its mounting surface to thereby form a layer of the adhesive 80 with a predetermined thickness. The warp preventing adhesive 80 may be made of the same material as (or, a different material from) the adhesive 38. Subsequently, the filled adhesive 38 and the warp preventing adhesive 80 are cured simultaneously. By doing so, the warp of the substrate 31 can be effectively prevented by a simple method. The adhesive 80 may be removed after the curing of the adhesive 38 is competed.

In addition, as the warp-preventing material to be placed on the opposite surface of the substrate 31 to its mounting surface, any other material than adhesives may be used if it can prevent the warp of the substrate. For example, polyimide resin as one of organic materials may be preferably used. As one of inorganic materials, SiOₓ or SiNₓ generated by sputtering may be preferably used.

### SECOND EXAMPLE OF SUBSTRATE WARP PREVENTING METHOD

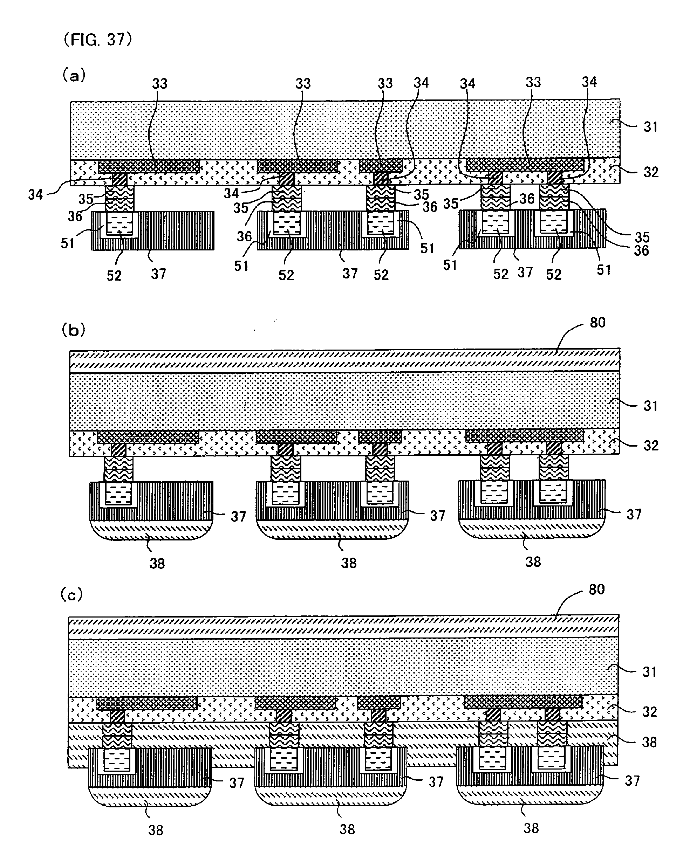

Fig. 37 shows a second example of the method of preventing the warp of the support substrate 31 applicable to the first to fourteenth embodiments described above.

In the first example shown in Fig. 36, after the state of Fig. 36(b) is formed by filling the adhesive 38, the warp-preventing adhesive 80 is coated on the opposite surface of the substrate 31 to its mounting surface to thereby form a layer with a predetermined thickness. Unlike this, in the second example, before the state of Fig. 36(b) is formed by filling the adhesive 38, the warp-preventing adhesive 80 is coated on the opposite surface of the substrate 31 to its mounting surface to thereby form a layer with a predetermined thickness (see Fig. 37(b)). Thereafter, the adhesive 38 is filled.

In this way, the warp preventing adhesive 80 may be coated before the filling operation of the adhesive 38 or simultaneously with the same. The warp preventing adhesive 80 may be removed after the curing of the adhesive 38 is completed.

In this way, the warp preventing adhesive 80 may be coated before or simultaneously with the filling operation of the adhesive 38. The warp preventing adhesive 80 may be removed after the curing operation of the adhesive 38 is completed.

### THIRD EXAMPLE OF SUBSTRATE WARP PREVENTING METHOD

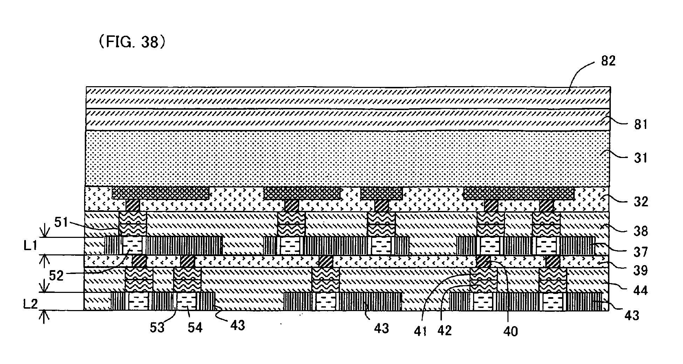

Fig. 38 shows a third example of the method of preventing the warp of the support substrate 31 applicable to the first to fourteenth embodiments described above.

In the third example, when forming the first semiconductor circuit layer L1, a warp preventing adhesive 81 is coated on the opposite surface of the substrate 31 to its mounting surface by using the first or second example of the warp preventing method shown in Fig. 36 or 37. Thereafter, when forming the second semiconductor circuit layer L2, another warp preventing adhesive 82 is superposed on the warp preventing adhesive 81 in the same way as above.

In this way, the warp preventing adhesive may be coated whenever the first to third semiconductor circuit layers L1 to L3 are formed. These warp preventing adhesives may be removed after the curing operation of all the adhesives is completed.

### FOURTH EXAMPLE OF SUBSTRATE WARP PREVENTING METHOD

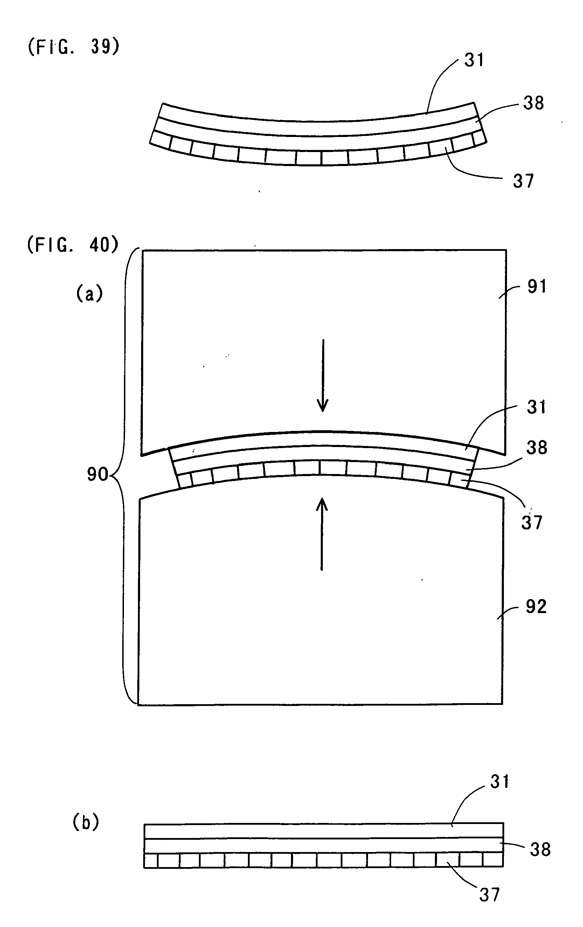

Fig. 40 shows a fourth example of the method of preventing the warp of the support substrate 31 applicable to the first to fourteenth embodiments described above.

The fourth example is a method that the amount of a warp (see Fig. 39) of the substrate 31 to be generated by curing the adhesive 38 is anticipated and then, an opposite warp with the same amount as anticipated to the said warp is applied to the substrate 31 in advance (preliminarily) with a warp applying apparatus 90.

Specifically, a structure that the chips 37 (where the electrodes 36 have been formed) are fixed to the substrate 31 (where the electrodes 35 have been formed), and the adhesive 38 is filled but the adhesive 38 is not yet cured, is sandwiched by upper and lower pressing members 91 and 92 of the warp applying apparatus 90 and pressed. At this time, it is preferred that heat is applied to the said structure to accelerate the warp of the substrate 31. In this way, an anticipated amount of warp is applied in advance. By doing so, such a flat state as shown in Fig. 40(b) is maintained even if the adhesive 38 changes its volume on curing.

The warp applying apparatus 90 can be easily realized by an application of a known pressurizing machine. For example, each of the upper and lower pressing members 91 and 92 is formed to have a desired curved surface by a rigid member made of metal, plastic or the like. Both of the members 91 and 92 are movably held to have the positional relationship shown in Fig. 40(a). By using the operation of a handle by an operator or the rotating force of a motor, the upper pressing member 91 is lowered manually or automatically and at the same time, the lower pressing member 92 is raised in synchronization with the upper member 91. Thereafter, a predetermined pressure is applied to the structure to which a preliminary warp is formed for a predetermined time, thereby generating a warped state shown in Fig. 40(a).

In addition, to prevent an excessive pressure from being applied to the structure to which a preliminary warp is to be given, it is preferred that a pressure sensor for sensing the pressure applied to the structure is provided.

### FIRST VARIATION OF SEMICONDUCTOR CHIP MOUNTING METHOD

Next, variations of a method of mounting the semiconductor chips are explained described above.

With any of the above-described first to fourteenth embodiments, the semiconductor chips are fixed in a one-to-one correspondence by using a high-speed chip bonder or the like. Alternately, all the semiconductor chips are located on a supporting member (not shown) in advance according to a predetermined layout and then, all the chips are fixed on the support substrate or the adjoining semiconductor circuit layer in a lump using the supporting member. However, the invention is not limited to these methods, and other methods than them may be applicable. They will be shown below.

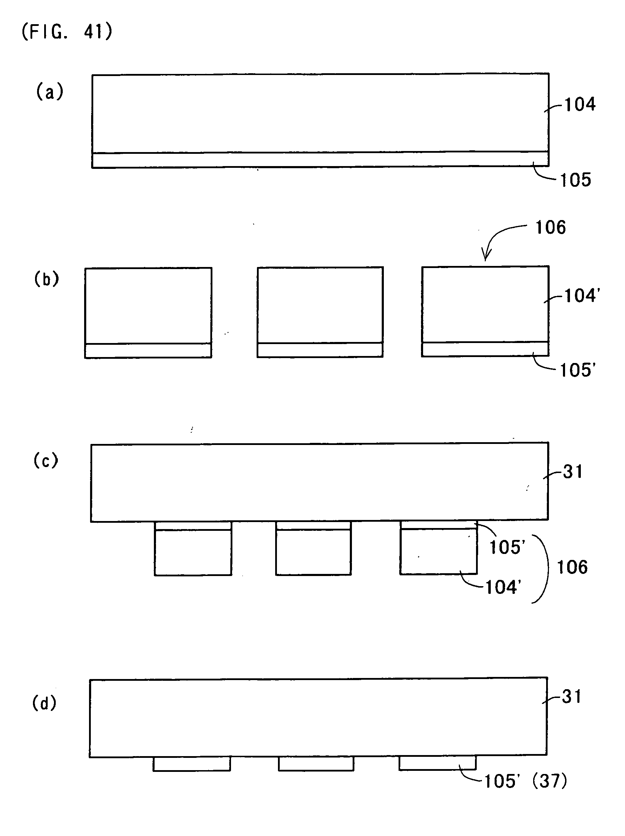

Fig. 41 shows a first variation of the method of mounting the semiconductor chips on the support substrate 31 applicable to the first to fourteenth embodiments described above.

In this method, first, as shown in Fig. 41(a), a semiconductor wafer 105 having many integrated circuits therein is adhered to one surface of a substrate 104 using a known adhesive. Next, the substrate 104 and the wafer 105 are scribed together, thereby dividing them into stacks 106, as shown in Fig. 41(b). Each of the stacks 106 is formed by a substrate piece 104' and a semiconductor wafer piece 105'. Thereafter, as shown in Fig. 41(c), the stacks 106 are turned upside down and then, they are respectively fixed to the predetermined positions (i.e., the positions to which the chips 37 are fixed) on the mounting surface of the substrate 31. In this state, the wafer pieces 105' are fixed to the mounting surface of the substrate 31. Finally, the substrate pieces 104' are removed from the corresponding stacks 106 fixed to the substrate 31 by removing the adhesive used to adhere the wafer 105, or eliminating its adhering force, or the like, thereby leaving the wafer pieces 105' alone. In this way, the wafer pieces 105' (i.e., the chips 37) are fixed on the mounting surface of the substrate 31 at the predetermined positions. The state of Fig. 41(d) is substantially the same as the state of Fig. 4(a).

With the above-described first to fourteenth embodiments, the wafer pieces 105' (i.e., the chips 37) can be fixed to the substrate 31 using such the method as shown in Fig. 41. In this method, when fixing the wafer pieces 105' (i.e., the chips 37), the wafer pieces 105' can be grasped by using the substrate pieces 104'. Accordingly, there is an advantage that the wafer pieces 105' can be handled more easily than the method used in the first to fourteenth embodiments.

### SECOND VARIATION OF SEMICONDUCTOR CHIP MOUNTING METHOD

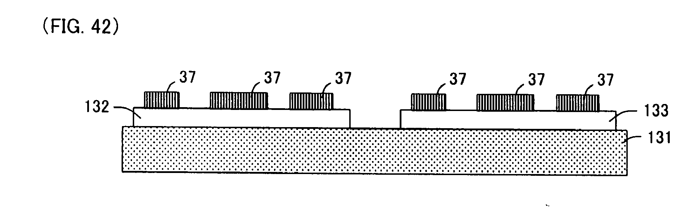

Fig. 42 shows a second variation of the method of mounting the semiconductor chips on the support substrate 31 applicable to the first to fourteenth embodiments described above.

As shown in Fig. 42, first, a predetermined number of the chips 37 are respectively arranged on a carrier substrate 132 at predetermined positions. Similarly, a predetermined number of the chips 37 are respectively arranged on another carrier substrate 133 at predetermined positions. Thereafter, the substrates 132 and 133 thus prepared are respectively placed at predetermined positions on a carrier substrate 131 larger than the substrates 132 and 133. Finally, using the carrier substrate 131 on which the substrates 132 and 133 are placed, the many chips 37 placed thereon are fixed to the mounting surface of the support substrate 31 in a lump.

With the above-described first to fourteenth embodiments, the many chips 37 can be fixed to the substrate 31 in a lump using such the method as shown in Fig. 42. In this method, the fixing operation of the many chips 37 to the substrate 31 can be carried out by a single alignment operation and a single bonding operation. Accordingly, there is an advantage that the fixing operation of the chips 37 can be performed efficiently.

### OTHER VARIATIONS

The above-described first to fourteenth embodiments and their variations are disclosed to show concrete examples of the invention. Therefore, the invention is not limited to these embodiment and variations, and modifications are possible without departing from the spirit of the invention.

For example, in the above-described embodiments, semiconductor chips as KGDs are used for each semiconductor circuit layer. However, it is unnecessary that all the chips included in each semiconductor circuit layer are KGDs. Regarding the part which is unable to be omitted in the fabrication processes due to the structures of the other parts and which is unnecessary as the circuit functions, it is needless to say that a so-called dummy chip (i.e., a semiconductor chip having the same external form as a KGD and no inner circuit) may be used.

Moreover, in the above-described embodiments, the stacked structure formed by the semiconductor circuit layers (the semiconductor chip layers or semiconductor wafers) stacked on the support substrate is divided by dicing into the semiconductor devices. However, the invention is not limited to this. The stacked structure may be used as a single semiconductor device without dicing. In this case, this is a wafer-level semiconductor device.

### INDUSTRIAL APPLICABILITY

Semiconductor devices having similar functions to the system LSI can be realized by suitably combining, mounting, and integrating semiconductor circuits with various functions on a single support substrate to constitute a three-dimensional stacked structure. Therefore, the invention is applicable to systemized semiconductor devices similar to the system LSI by combining semiconductor circuits with different functions and/or sizes according to the necessity.

## Claims

1. A semiconductor device having a three-dimensional stacked structure, comprising:
a support substrate; and
a stacked structure comprising first to n-th circuit layers (n is an integer equal to 2 or greater) stacked in sequence from a bottom of the structure to a top thereof in a predetermined stacking direction and unified with an electrically insulative adhesive, the structure being fixed to the substrate at the bottom;
wherein adjoining ones of the circuit layers in the stacked structure are mechanically and electrically interconnected with each other by way of connecting portions formed between the adjoining circuit layers, and are electrically insulated from each other by the adhesive in a region other than the connecting portions;
each of the first to n-th circuit layers is formed to include at least one semiconductor circuit; and
at least one of the first to n-th circuit layers is such that a physical size of the semiconductor circuit included in the said circuit layer in a plane perpendicular to the stacking direction is smaller than a physical size of the said circuit layer in the plane, and a side face of the said semiconductor circuit is covered with the adhesive.

2. The device according to claim 1, wherein a plurality of electrodes for external circuit connection are provided, the electrodes being located at the top of the stacked structure and electrically connected to at least one of the first to n-th circuit layers.

3. The device according to claim 1 or 2, wherein in each of the connecting portions for mechanical and electrical interconnection between the adjoining ones of the circuit layers in the stacked structure, a conductive contact formed to protrude on the semiconductor circuit of one of the two adjoining circuit layers and a conductive contact formed to protrude on the semiconductor circuit of the other of the two adjoining circuit layers are mechanically connected; and
a gap between the adjoining ones of the circuit layers in the stacked structure is filled with the adhesive.

4. The device according to claim 1 or 2, wherein in each of the connecting portions for mechanical and electrical interconnection between the adjoining ones of the circuit layers in the stacked structure, a conductive contact is formed between the said circuit layers, and both ends of the conductive contact are mechanically connected to the adjoining circuit layers, respectively; and
a gap between the adjoining ones of the circuit layers in the stacked structure is filled with the adhesive.

5. The device according to one of claims 1 to 4, wherein at least one of the first to n-th circuit layers comprises a rigid member extending between a face of the said circuit layer and an opposing face of an adjoining one of the circuit layers or the substrate.

6. The device according to one of claims 1 to 5, wherein at least one of the first to n-th circuit layers comprises a buried interconnection penetrating through the said circuit layer in the stacking direction; and
electrical connection in the said circuit layer or to an adjoining one of the circuit layers is performed by using the buried interconnection.

7. The device according to one of claims 1 to 6, wherein a whole sidewall of the stacked structure is covered with the adhesive.

8. The device according to one of claims 1 to 6, wherein the circuit layer included in at least one of the first to n-th circuit layers is exposed from the adhesive covering a sidewall of the stacked structure.

9. The device according to one of claims 1 to 8, wherein at least one of the first to n-th circuit layers comprises semiconductor circuits arranged at predetermined positions in a plane perpendicular to the stacking direction.

10. The device according to claim 9, wherein the semiconductor circuits in the said circuit layer are electrically interconnected by way of a wiring layer.

11. The device according to claim 10, wherein the wiring layer is located between the said circuit layer and the other circuit layer adjoining thereto.

12. The device according to one of claims 1 to 11, wherein the semiconductor circuit included in at least one of the first to n-th circuit layers comprises at least one dummy semiconductor circuit.

13. The device according to one of claims 1 to 12, wherein the substrate comprises an inner circuit or a wiring line, the inner circuit or the wiring line being electrically connected to at least one of the first to n-th circuit layers.

14. The device according to one of claims 1 to 13, wherein the adhesive comprises a filler.

15. The device according to one of claims 1 to 14, wherein the semiconductor circuit included in at least one of the first to n-th circuit layers comprises a redundant structure.

16. A method of fabricating a semiconductor device having a three-dimensional stacked structure, said device comprising,
a support substrate; and
a stacked structure comprising first to n-th circuit layers (n is an integer equal to 2 or greater) stacked in sequence from a bottom of the structure to a top thereof in a predetermined stacking direction and unified with an electrically insulative adhesive, the structure being fixed to the substrate at the bottom;
wherein at least one of the first to n-th circuit layers is such that a physical size of the semiconductor circuit included in the said circuit layer in a plane perpendicular to the stacking direction is smaller than a physical size of the said circuit layer in the said plane, and a side face of the said semiconductor circuit is covered with the adhesive;
said method comprising the steps of:
mechanically connecting at least one first semiconductor circuit to a surface of the support substrate at a predetermined position by way of first connecting portions;
filling a gap formed between the first semiconductor circuit and the substrate with a first electrically insulative adhesive, and curing the first adhesive;
polishing an opposite surface of the first semiconductor circuit to the substrate, where the gap is filled with the cured first adhesive, to adjust a thickness of the first semiconductor circuit to a predetermined value, thereby forming a first circuit layer constituting the stacked structure;
mechanically and electrically connecting at least one second semiconductor circuit to a surface of the first circuit layer at a predetermined position by way of second connecting portions;
filling a gap formed between the second semiconductor circuit and the first circuit layer with a second electrically insulative adhesive, and curing the second adhesive; and
polishing an opposite surface of the second semiconductor circuit to the substrate, where the gap is filled with the cured second adhesive, to adjust a thickness of the second semiconductor circuit to a predetermined value, thereby forming a second circuit layer constituting the stacked structure.

17. The method according to claim 16, wherein by repeating the three steps for forming the second circuit layer (n - 2) times, the first circuit layer comprising the at least one first semiconductor circuit, the second circuit layer comprising the at least one second semiconductor circuit, ....., and an n-th circuit layer comprising at least one n-th semiconductor circuit are stacked on the substrate in this order, thereby forming the stacked structure.

18. The method according to claim 16 or 17, further comprising a step of forming a plurality of electrodes for external circuit connection at predetermined positions on the n-th circuit layer;
wherein the electrodes for external circuit connection are electrically connected to at least one of the first to n-th circuit layers.

19. The method according to one of claims 16 to 18, wherein each of the second connecting portions used in the step of mechanically and electrically connecting the at least one second semiconductor circuit to the surface of the first circuit layer at the predetermined position comprises a conductive contact formed to protrude on the second semiconductor circuit and a conductive contact formed to protrude on the first circuit layer; and
the first circuit layer and the at least one second semiconductor circuit are mechanically and electrically connected by mechanically connecting the contacts to each other directly or by way of a bonding metal.

20. The method according to one of claims 16 to 18, wherein each of the second connecting portions used in the step of mechanically and electrically connecting the at least one second semiconductor circuit to the surface of the first circuit layer at the predetermined position comprises a conductive contact formed to protrude on the second semiconductor circuit or the first circuit layer;
wherein the first circuit layer and the at least one second semiconductor circuit are mechanically and electrically connected by mechanically connecting each end of the contact to the first circuit layer and the at least one second semiconductor circuit, respectively.

21. The method according to one of claims 16 to 20, wherein at least one of the first semiconductor circuit and the second semiconductor circuit comprises a rigid member protruding toward an opposing face of the substrate or the first circuit layer adjoining thereto; and
the rigid member is used as a stopper for positioning the first semiconductor circuit and/or the second semiconductor circuit in the stacking direction.

22. The method according to one of claims 16 to 21, wherein at least one of the first semiconductor circuit and the second semiconductor circuit comprises a buried interconnection that does not penetrate through the said semiconductor circuit; and
when the opposite surface of the said semiconductor circuit to the substrate is polished, the interconnection is turned to a penetrating state where the interconnection penetrates through the said semiconductor circuit.

23. The method according to one of claims 16 to 22, wherein the first circuit layer includes a plurality of the first semiconductor circuits and the second circuit layer includes a plurality of the second semiconductor circuits.

24. The method according to one of claims 16 to 23, wherein the first circuit layer has a physical size in a plane perpendicular to the stacking direction larger than a physical size of the at least one first semiconductor circuit in the plane;
a side face of the first semiconductor circuit is covered with the first adhesive;
the second circuit layer has a physical size in a plane perpendicular to the stacking direction larger than a physical size of the at least one second semiconductor circuit in the plane; and
a side face of the second semiconductor circuit is covered with the second adhesive.

25. The method according to one of claims 16 to 24, wherein filling the gap with the first or second adhesive is performed by spraying the first or second adhesive.

26. The method according to one of claims 16 to 24, wherein filling the gap with the first or second adhesive is performed by immersing in a liquid adhesive the first semiconductor circuit fixed to the substrate or the second semiconductor circuit fixed to the first semiconductor circuit.

27. The method according to one of claims 16 to 24, wherein filling the gap with the first or second adhesive is performed by immersing in said liquid adhesive the substrate and the first semiconductor circuit sandwiched by a pair of pressing members or the first and second semiconductor circuits sandwiched by a pair of pressing members.

28. The method according to one of claims 16 to 24, wherein filling the gap with the first or second adhesive is performed by placing the substrate and the first semiconductor circuit or the first and second semiconductor circuits in a member having a closed space, and injecting the liquid adhesive into the space under pressure.

29. The method according to one of claims 16 to 24, wherein the first semiconductor circuits or the second semiconductor circuits are regularly placed on the substrate or the first circuit layer and thereafter, gaps between the first semiconductor circuits or the second semiconductor circuits and their peripheries are coated with at least one of the first and second adhesives using a dispenser.

30. The method according to one of claims 16 to 29, wherein when the first adhesive filled in the gaps are cured, a layer for preventing a warp of the substrate is placed on an opposite surface of the substrate to the first circuit layer.

31. The method according to one of claims 16 to 29, wherein when the gaps are filled with the first adhesive and the first adhesive is cured, a warp preventing layer for preventing a warp of the substrate is placed on an opposite surface of the substrate to the first circuit layer.

32. The method according to one of claims 16 to 29, wherein when the gaps are filled with the first adhesive or the first adhesive is cured, a first warp preventing layer for preventing a warp of the substrate is placed on an opposite surface of the substrate to the first circuit layer; and
when the gaps are filled with the second adhesive or the second adhesive is cured, a second warp preventing layer for preventing a warp of the substrate is placed on the first warp preventing layer.

33. The method according to one of claims 16 to 29, further comprising a step of warping the substrate toward an opposite side to a warp of the substrate to be generated by curing of the first adhesive, which is performed after mechanically connecting the first semiconductor circuit to the substrate by way of the first connecting portions.

34. The method according to one of claims 16 to 33, wherein at least one of the first and second adhesives contains a filler.

35. The method according to one of claims 16 to 34, further comprising a step of dicing the substrate and the stacked structure along a cutting plane or planes parallel to the stacking direction to thereby form semiconductor devices.

36. The method according to one of claims 16 to 35, wherein the semiconductor circuit included in at least one of the first to n-th circuit layers comprises a redundant structure.
